# EUROPEAN PATENT APPLICATION

(11) **EP 4 365 263 A1**
(43) Date of publication of application: **08.05.2024**
(21) Application number: 23206068.1
(22) Date of filing: 26.10.2023
(51) Int. Cl.: C09K 11/00, H10K 85/00, C07F 15/00

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHTEMITTING DEVICE**

(30) Priority: 28.10.2022 KR 20220141755
(71) Applicant: Samsung Electronics Co., Ltd., Suwon-si, Gyeonggi-do 16677 (KR)
(72) Inventor: MIN, Minsik, 16678 Suwon-si (KR); KIM, Hwang Suk, 16678 Suwon-si (KR); BAE, Hyejin, 16678 Suwon-si (KR); CHOI, Hyesung, 16678 Suwon-si (KR); KANG, Hosuk, 16678 Suwon-si (KR); KIM, Jong Soo, 16678 Suwon-si (KR); KIM, Joonghyuk, 16678 Suwon-si (KR); SON, Youngmok, 16678 Suwon-si (KR); WON, Joonghee, 16678 Suwon-si (KR); JEONG, Daun, 16678 Suwon-si (KR); JUNG, Yongsik, 16678 Suwon-si (KR); CHWAE, Jun, 16678 Suwon-si (KR)
(74) Representative: Elkington and Fife LLP

(57) **Abstract**

An organometallic compound represented by Formula 1-1 or 1-2: 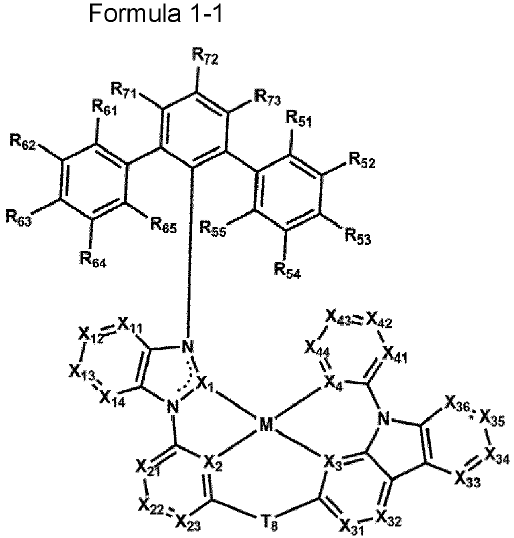 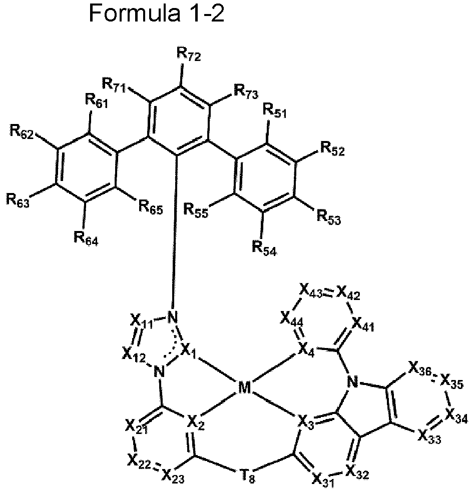 wherein, in Formulae 1-1 and 1-2, M is Pt or Pd; each of X₁, X₂, and X₃ is carbon; X₄ is nitrogen; T₈ is O, S, N(R₈₁), C(R₈₁)(R₈₂), or Si(R₈₁)(R₈₂); and the remaining substituent groups are as defined herein.

## Description

### FIELD OF THE INVENTION

One or more embodiments relate to an organometallic compound, an organic light-emitting device including the same, and an electronic apparatus including the organic light-emitting device.

### BACKGROUND OF THE INVENTION

Organic light-emitting devices (OLEDs) are self-emissive devices that have wide viewing angles, short response times, and excellent characteristics in terms of luminance, driving voltage, and response speed. In addition, OLEDs can produce full-color images.

According to an example, an organic light-emitting device may include an anode, a cathode, and an organic layer arranged between the anode and the cathode and including an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. These excitons may transition from an excited state to a ground state, thereby generating light.

### SUMMARY OF THE INVENTION

Aspects are directed to an organometallic compound, an organic light-emitting device including the same, and an electronic apparatus including the organic light-emitting device.

Additional aspects will be set forth in part in the detailed description that follows and, in part, will be apparent from the detailed description, or may be learned by practice of the presented exemplary embodiments herein.

According to an aspect, provided is an organometallic compound represented by Formula 1-1 or 1-2. 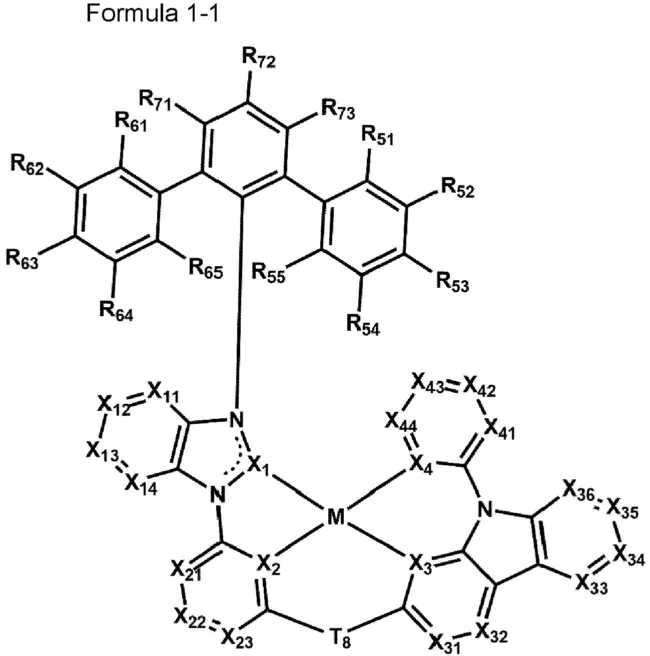 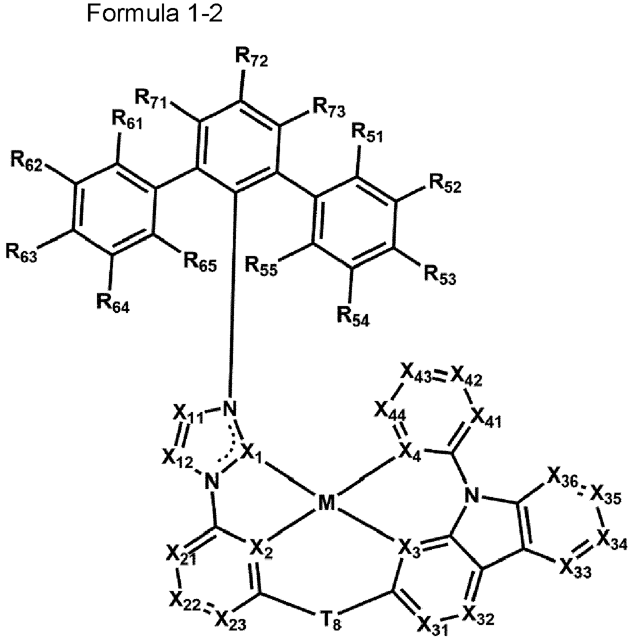 wherein, in Formulae 1-1 and 1-2,
M is Pt or Pd,
each of X₁, X₂, and X₃ is carbon,
X4 is nitrogen,
X₁₁ is N, C(R₁₁), or C(R₀), X₁₂ is N, C(R₁₂), or C(R₀), X₁₃ is N, C(R₁₃), or C(R₀), X₁₄ is N, C(R₁₄), or C(R₀),
X₂₁ is N, C(R₂₁), or C(R₀); X₂₂ is N, C(R₂₂), or C(R₀); and X₂₃ is N, C(R₂₃), or C(R₀),
X₃₁ is N, C(R₃₁), or C(R₀); X₃₂ is N, C(R₃₂), or C(R₀); X₃₃ is N, C(R₃₃), or C(R₀); X₃₄ is N, C(R₃₄), or C(R₀); X₃₅ is N, C(R₃₅), or C(R₀); and X₃₆ is N, C(R₃₆), or C(R₀),
X₄₁ is N, C(R₄₁), or C(R₀); X₄₂ is N, C(R₄₂), or C(R₀); X₄₃ is N, C(R₄₃), or C(R₀); and X₄₄ is N, C(R₄₄), or C(R₀),
T₈ is O, S, N(R₈₁), C(R₃₁)(R₃₂), or Si(R₈₁)(R₈₂),
each R₀ is independently a group represented by Formula 2,
R₁₁ to R₁₄, R₂₁ to R₂₃, R₃₁ to R₃₆, R₄₁ to R₄₄, R₅₁ to R₅₅, R₆₁ to R₆₅, R₇₁ to R₇₃, R₈₁, and R₈₂ are each independently:
   a group represented by Formula 2,
   hydrogen or deuterium, or
   a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
   wherein Condition A or Condition B is satisfied:
      Condition A
         each of X₂₁ to X₂₃ in Formulae 1-1 and 1-2 is not N, and A-i), A-ii) or A-iii) is true :
         A-i) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀),
         A-ii) at least one of R₅₁ to R₅₅ in Formulae 1-1 and 1-2, at least one of R₆₁ to Res in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
         A-iii) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to Res in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2,
      Condition B
         at least one of X₂₁ to X₂₃ in Formulae 1-1 and 1-2 is N, and B-i), B-ii) or B-iii) is true:
         B-i) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀),
         B-ii) at least one of R₅₁ to R₅₅ in Formulae 1-1 and 1-2, at least one of R₆₁ to Res in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
         B-iii) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to Res in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, and
when the organometallic compound represented by Formulae 1-1 or 1-2 comprises at least two groups represented by Formula 2, the at least two groups represented by Formula 2 are identical to or different from each other, 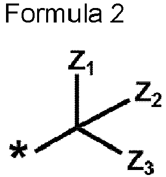 wherein, in Formula 2,
Z₁ is:
   hydrogen or deuterium, or
   a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
   Z₂ is hydrogen or deuterium,
   Z₃ is a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
   at least two of Z₁ to Z₃ are not linked to each other to form a ring, and
   * indicates a binding site to a neighboring atom.

According to another aspect, also provided is an organic light-emitting device including a first electrode, a second electrode, and an organic layer arranged between the first electrode and the second electrode, wherein the organic layer includes an emission layer, and wherein the organic layer further includes at least one of the organometallic compounds.

According to still another aspect, provided is an electronic apparatus including the organic light-emitting device.

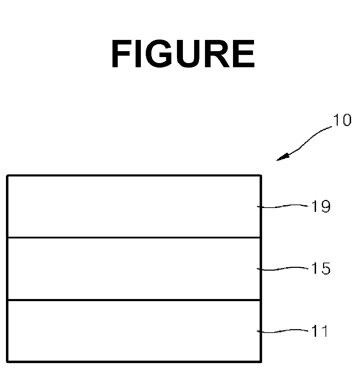

### BRIEF DESCRIPTION OF THE DRAWING

The above and other aspects, features, and advantages of certain exemplary embodiments will be more apparent from the following detailed description taken in conjunction with the accompanying drawing, in which:
The FIGURE is a schematic view of an organic light-emitting device according to one or more embodiments.

### DETAILED DESCRIPTION OF THE EMBODIMENTS

Reference will now be made in further detail to exemplary embodiments, examples of which are illustrated in the accompanying drawing, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figure, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volts (eV)" of the vacuum level, while when the work function or the HOMO energy level is referred to be "shallow," "low," or "small," the work function or HOMO energy level has a small absolute value based on "0 eV" of the vacuum level.

An organometallic compound according to an aspect is represented by Formula 1-1 or 1-2: 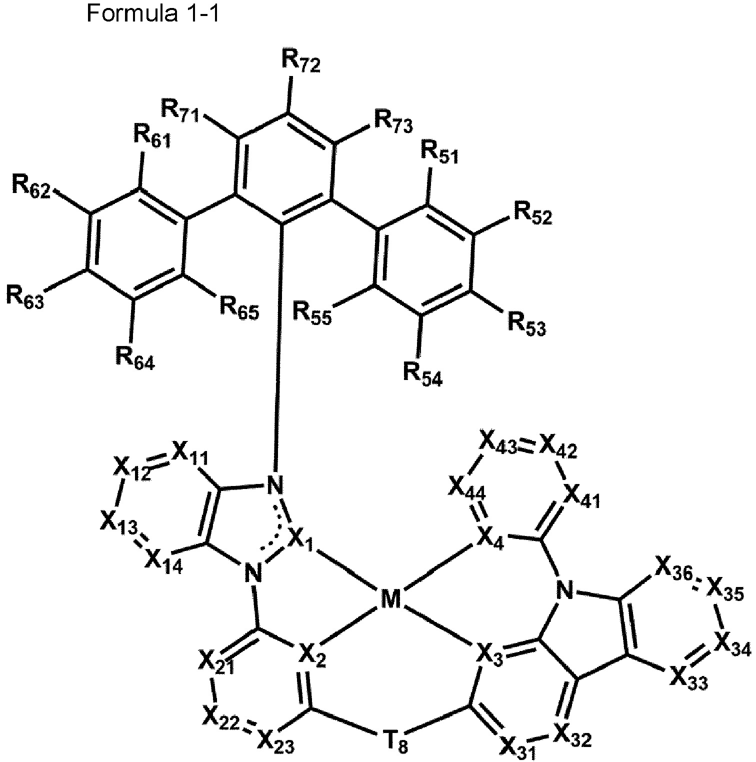 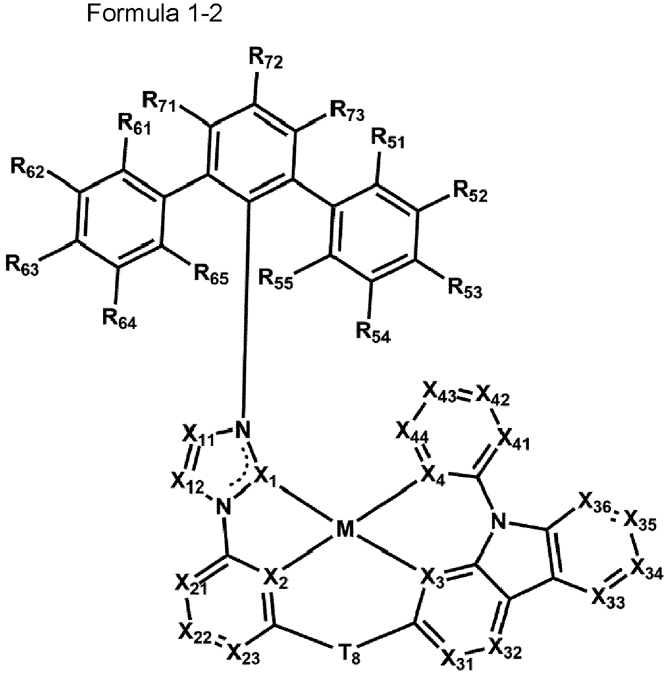 wherein, in Formulae 1-1 and 1-2, M is Pt or Pd.

For example, M may be Pt.

In Formulae 1-1 and 1-2, each of X₁, X₂, and X₃ is carbon, and X₄ is nitrogen.

For example, a bond between X₁ and M and a bond between X₄ and M may each be a coordinate bond, and a bond between X₂ and M and a bond between X₃ and M may each be covalent bond. In other words, the organometallic compound represented by Formulae 1-1 and 1-2 is neutral.

In Formulae 1-1 and 1-2,
X₁₁ is N, C(R₁₁), or C(R₀); X₁₂ is N, C(R₁₂), or C(R₀); X₁₃ is N, C(R₁₃), or C(R₀); and X₁₄ is N, C(R₁₄), or C(R₀),
   X₂₁ is N, C(R₂₁), or C(R₀); X₂₂ is N, C(R₂₂), or C(R₀); and X₂₃ is N, C(R₂₃), or C(R₀),
   X₃₁ is N, C(R₃₁), or C(R₀); X₃₂ is N, C(R₃₂), or C(R₀); X₃₃ is N, C(R₃₃), or C(R₀); X₃₄ is N, C(R₃₄), or C(R₀); X₃₅ is N, C(R₃₅), or C(R₀); and X₃₆ is N, C(R₃₆), or C(R₀),
X₄₁ is N, C(R₄₁), or C(R₀); X₄₂ is N, C(R₄₂), or C(R₀); X₄₃ is N, C(R₄₃), or C(R₀); and X₄₄ is N, C(R₄₄), or C(R₀), and
T₈ is O, S, N(R₈₁), C(R₃₁)(R₃₂), or Si(R₈₁)(R₈₂),
wherein R₀, R₁₁ to R₁₄, R₂₁ to R₂₃, R₃₁ to R₃₆, R₄₁ to R₄₄, R₅₁ to R₅₅, R₆₁ to R₆₅, R₇₁ to R₇₃, R₈₁, and R₈₂ are each as defined herein.

It is easily understood that Formula 1-1 and Formula 1-2, in which X₁ is indicated to be a carbene, may be represented by Formula 1-1' and Formula 1-2', in which charges of X₄ and N neighboring to X₁ is indicated, respectively (that is, Formula 1-1 is same as Formula 1-1' and Formula 1-2 is same as Formula 1-2') and descriptions for Formula 1-1 and Formula 1-2 may be applied to Formula 1-1' and Formula 1-2', respectively. 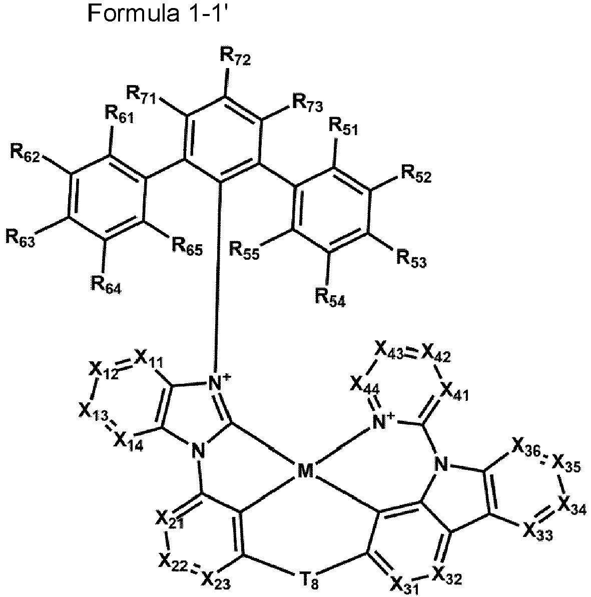 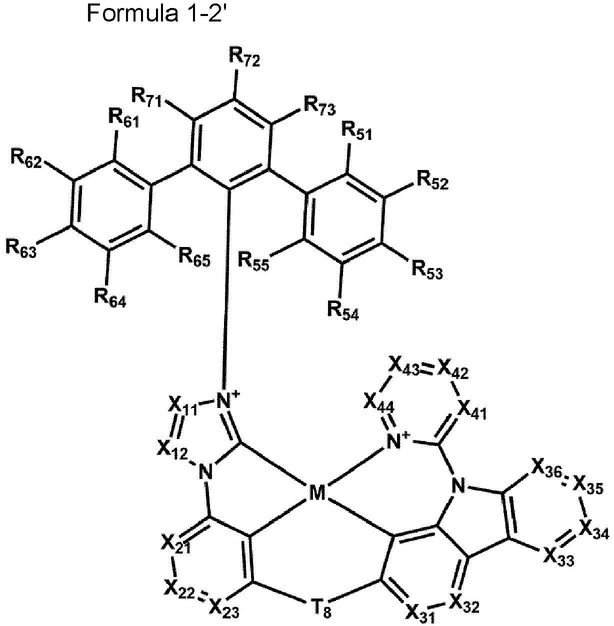 wherein, in Formulae 1-1' and 1-2',
X₁₁ may be N, C(R₁₁), or C(R₀); X₁₂ may be N, C(R₁₂), or C(R₀); X₁₃ may be N, C(R₁₃), or C(R₀); and X₁₄ may be N, C(R₁₄), or C(R₀),
X₂₁ may be N, C(R₂₁), or C(R₀); X₂₂ may be N, C(R₂₂), or C(R₀); and X₂₃ may be N, C(R₂₃), or C(R₀),
X₃₁ may be N, C(R₃₁), or C(R₀); X₃₂ may be N, C(R₃₂), or C(R₀); X₃₃ may be N, C(R₃₃), or C(R₀); X₃₄ may be N, C(R₃₄), or C(R₀); X₃₅ may be N, C(R₃₅), or C(R₀); and X₃₆ may be N, C(R₃₆), or C(R₀),
X₄₁ may be N, C(R₄₁), or C(R₀); X₄₂ may be N, C(R₄₂), or C(R₀); X₄₃ may be N, C(R₄₃), or C(R₀); and X₄₄ may be N, C(R₄₄), or C(R₀), and
T₃ may be O, S, N(R₈₁), C(R₃₁)(R₃₂), or Si(R₃₁)(R₃₂).

In one or more embodiments, all of X₁₁ to X₁₄, X₂₁ to X₂₃, X₃₁ to X₃₆, and X₄₁ to X₄₄ may not be N.

In one or more embodiments, at least one of X₁₁ to X₁₄, at least one of X₂₁ to X₂₃, at least one of X₃₁ to X₃₆, at least one of X₄₁ to X₄₄, or a combination thereof, may be N.

In one or more embodiments, T₈ in Formulae 1-1 and 1-2 may be O or S.

R₀ in Formulae 1-1 and 1-2 is a group represented by Formula 2. 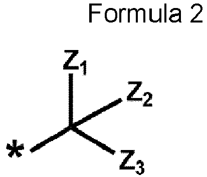 wherein, in Formula 2,
Z₁ is:
hydrogen or deuterium; or
a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
Z₂ is hydrogen or deuterium,
Z₃ is a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
at least two of Z₁ to Z₃ are not linked to each other to form a ring, and
   * indicates a binding site to a neighboring atom.
R₁₁ to R₁₄, R₂₁ to R₂₃, R₃₁ to R₃₆, R₄₁ to R₄₄, R₅₁ to R₅₅, R₆₁ to R₆₅, R₇₁ to R₇₃, R₈₁, and R₈₂ in Formulae 1-1 and 1-2 are each independently:
   a group represented by Formula 2;
   hydrogen or deuterium; or
   a C₁-C₂₀ alkyl group, a phenyl group, or a carbazolyl group (for example, an N-carbazolyl group or the like), each unsubstituted or substituted with at least one of deuterium, a C₁-C₂₀ alkyl group, a phenyl group, a carbazolyl group (for example, an N-carbazolyl group or the like), or a combination thereof.

As used herein, "a C₁-C₂₀ alkyl group, a phenyl group, or a carbazolyl group, each substituted with at least one of deuterium, a C₁-C₂₀ alkyl group, a phenyl group, a carbazolyl group, or a combination thereof" may include, for example:
a C₁-C₂₀ alkyl group that is substituted with at least one deuterium,
a C₁-C₂₀ alkyl group that is substituted with at least one phenyl group,
a C₁-C₂₀ alkyl group that is substituted with at least one deuterium and at least one phenyl group,
a C₁-C₂₀ alkyl group that is substituted with at least one deuterium and at least one deuterated phenyl group (for example, a phenyl group that is substituted with five deuteriums, or the like),
a C₁-C₂₀ alkyl group that is substituted with at least one phenyl group, the phenyl groups are each independently unsubstituted or substituted with at least one of deuterium, a C₁-C₂₀ alkyl group, or a combination thereof,
a phenyl group that is substituted with at least one deuterium,
a phenyl group that is substituted with at least one C₁-C₂₀ alkyl group,
a phenyl group that is substituted with at least one deuterium and at least one C₁-C₂₀ alkyl group,
a phenyl group that is substituted with at least one deuterium and at least one deuterated C₁-C₂₀ alkyl group (for example, -CD₃, CD₂H, -CDH2, -CD₂CD₃, - CH₂CD₃, or the like),
a phenyl group that is substituted with at least one C₁-C₂₀ alkyl group and at least one deuterated C₁-C₂₀ alkyl group, or
a carbazolyl group that is substituted with at least one deuterium.

In one or more embodiments, R₁₁ to R₁₄, R₂₁ to R₂₃, R₃₁ to R₃₆, and R₄₁ to R₄₄ may each independently be:
hydrogen or deuterium; or
a C₁-C₁₀ alkyl group, a phenyl group, or a carbazolyl group, each unsubstituted or substituted with at least one of deuterium, a C₁-C₁₀ alkyl group, a phenyl group, a carbazolyl group, or a combination thereof.

In one or more embodiments, R₅₁ to R₅₅, R₆₁ to Res, R₇₁ to R₇₃, R₈₁, and R₈₂ may each independently be:
a group represented by Formula 2;
hydrogen or deuterium; or
a C₁-C₁₀ alkyl group, a phenyl group, or a carbazolyl group, each unsubstituted or substituted with at least one of deuterium, a C₁-C₁₀ alkyl group, a phenyl group, a carbazolyl group, or a combination thereof.

In one or more embodiments, R₁₁ to R₁₄, R₂₁ to R₂₃, R₃₁ to R₃₆, and R₄₁ to R₄₄ may each independently be:
hydrogen or deuterium;
a C₁-C₂₀ alkyl group that is unsubstituted or substituted with at least one of deuterium, a phenyl group, or a combination thereof; or
a phenyl group or a carbazolyl group, each unsubstituted or substituted with at least one of deuterium, a C₁-C₂₀ alkyl group, or a combination thereof.

In one or more embodiments, R₅₁ to R₅₅, R₆₁ to R₆₅, R₇₁ to R₇₃, R₈₁, and R₈₂ may each independently be:
a group represented by Formula 2;
hydrogen or deuterium;
a C₁-C₂₀ alkyl group that is unsubstituted or substituted with at least one of deuterium, a phenyl group, or a combination thereof; or
a phenyl group or a carbazolyl group, each unsubstituted or substituted with at least one of deuterium, a C₁-C₂₀ alkyl group, or a combination thereof.

In one or more embodiments, R₁₁ to R₁₄, R₂₁ to R₂₃, R₃₁ to R₃₆, and R₄₁ to R₄₄ may each independently be:
hydrogen or deuterium;
a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one of deuterium, a phenyl group, or a combination thereof; or
a phenyl group or a carbazolyl group, each unsubstituted or substituted with at least one of deuterium, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof.

In one or more embodiments, R₅₁ to R₅₅, R₆₁ to R₆₅, R₇₁ to R₇₃, R₈₁, and R₈₂ may each independently be:
a group represented by Formula 2;
hydrogen or deuterium;
a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with deuterium, a phenyl group, or a combination thereof; or
a phenyl group or a carbazolyl group, each unsubstituted or substituted with at least one of deuterium, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof.

Each of the organometallic compounds represented by Formulae 1-1 and 1-2 satisfies Condition A or Condition B:
Condition A
   each of X₂₁ to X₂₃ in Formulae 1-1 and 1-2 is not N, and A-i), A-ii) or A-iii) is true :
   A-i) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀),
   A-ii) at least one of R₅₁ to R₅₅ in Formulae 1-1 and 1-2, at least one of R₆₁ to Res in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
   A-iii) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2;
Condition B
   at least one of X₂₁ to X₂₃ in Formulae 1-1 and 1-2 is N, and B-i), B-ii) or B-iii) is true:
   B-i) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀),
   B-ii) at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
   B-iii) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2.

In other words, each of the organometallic compounds represented by Formulae 1-1 and 1-2 includes at least one group represented by Formula 2.

When each of the organometallic compounds represented by Formulae 1-1 and 1-2 includes at least two groups represented by Formula 2, the at least two groups represented by Formula 2 may be identical to or different from each other.

For example, the organometallic compound may satisfy at least one of Conditions 1 to 8, but embodiments are not limited thereto:
Condition 1
   at least one of X₁₁ to X₁₄ in Formula 1-1 is C(R₀), or
   at least one of X₁₁ and X₁₂ in Formula 1-2 is C(R₀);
Condition 2
   at least one of X₃₁ and X₃₂ in Formulae 1-1 and 1-2 is C(R₀);
Condition 3
   at least one of X₃₃ to X₃₆ in Formulae 1-1 and 1-2 is C(R₀);
Condition 4
   at least one of X₄₁ to X₄₄ in Formulae 1-1 and 1-2 is C(R₀);
Condition 5
   at least one of R₅₁ to R₅₅ in Formulae 1-1 and 1-2 is a group represented by Formula 2;
Condition 6
   at least one of R₆₁ to R₆₅ in Formulae 1-1 and 1-2 is a group represented by Formula 2;
Condition 7
   at least one of R₇₁ to R₇₃ in Formulae 1-1 and 1-2 is a group represented by Formula 2;
Condition 8
   at least one of X₂₁ to X₂₃ in Formulae 1-1 and 1-2 is N, and
   at least one among the others of X₂₁ to X₂₃ is C(R₀).

In one or more embodiments, the organometallic compound may satisfy at least one of Conditions 1 to 4.

In one or more embodiments, the organometallic compound may satisfy at least one of Conditions 5 to 7.

In one or more embodiments, the organometallic compound may satisfy Condition 4, may satisfy Conditions 5 and 6, may satisfy Condition 6, may satisfy Conditions 4 and 6, may satisfy Condition 3, or may satisfy Condition 2.

In one or more embodiments, the organometallic compound may satisfy one of Conditions 1-1, 1-2, 2-1, 3-1, 3-2, 4-1, 5-1, and 5-2, one of Conditions 6-1 and 6-2, or a combination thereof, but embodiments are not limited thereto:
Condition 1-1
   X₁₂ in Formula 1-1 is C(R₀);
Condition 1-2
   X₁₃ in Formula 1-1 is C(R₀);
Condition 2-1
   X₃₂ is C(R₀);
Condition 3-1
   X₃₄ is C(R₀);
Condition 3-2
   X₃₅ is C(R₀);
Condition 4-1
   X₄₂ is C(R₀);
Condition 5-1
   R₅₂ is a group represented by Formula 2;
Condition 5-2
   each of R₅₂ and R₅₄ is a group represented by Formula 2, and
   R₅₂ and R₅₄ are identical to or different from each other;
Condition 6-1
   R₆₂ is a group represented by Formula 2;
Condition 6-2
   each of R₆₂ and R₆₄ is a group represented by Formula 2, and
   R₆₂ and R₆₄ are identical to or different from each other.

In one or more embodiments, the organometallic compound may satisfy Condition 4-1, may satisfy Conditions 5-1 and 6-1, may satisfy Condition 6-1, may satisfy Condition 6-2, may satisfy Conditions 6-2 and 4-1, or may satisfy Conditions 4-1, 5-1, and 6-1.

In one or more embodiments, in Formulae 1-1 and 1-2, X₄₂ may be C(R₄₂) or C(R₀), and R₄₂ may not be hydrogen.

In one or more embodiments, Z₁ in Formula 2 may be hydrogen or deuterium.

In one or more embodiments, Z₁ in Formula 2 may be a C₁-C₂₀ alkyl group or a phenyl group, each unsubstituted or substituted with at least one of deuterium, a C₁-C₂₀ alkyl group, a phenyl group, or a combination thereof.

In one or more embodiments, the group represented by Formula 2 may be a group represented by Formula 2(1) or a group represented by Formula 2(2), but embodiments are not limited thereto: 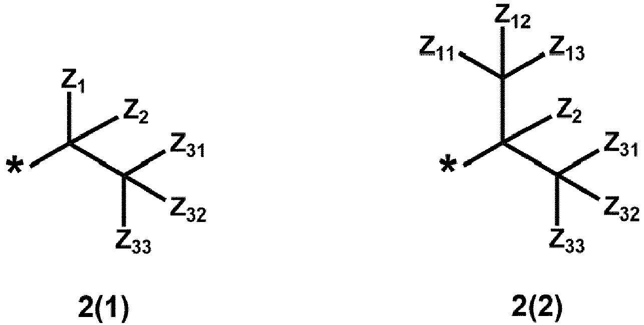 wherein, in Formulae 2(1) and 2(2),
Z₁ and Z₂ are as described herein,
Z₁₁ to Z₁₃ and Z₃₁ to Z₃₃ may each independently be:
   hydrogen or deuterium;
   a C₁-C₁₅ alkyl group that is unsubstituted or substituted with at least one deuterium; or
   a phenyl group that is unsubstituted or substituted with at least one of deuterium, a C₁-C₁₀ alkyl group, or a combination thereof, and
   * indicates a binding site to a neighboring atom.

In one or more embodiments, Z₁₁ to Z₁₃ and Z₃₁ to Z₃₃ in Formulae 2(1) and 2(2) may each independently be:
hydrogen or deuterium;
a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one deuterium atom; or
a phenyl group that is unsubstituted or substituted with at least one of deuterium, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof.

In one or more embodiments, at least one of Z₃₁ to Z₃₃ in Formulae 2(1) and 2(2) may not be hydrogen.

In one or more embodiments, at least one of Z₁₁ to Z₁₃ in Formula 2(2) may not be hydrogen.

In one or more embodiments, the group represented by Formula 2 may be a group represented by one of Formulae 2-1 to 2-24, but embodiments are not limited thereto: 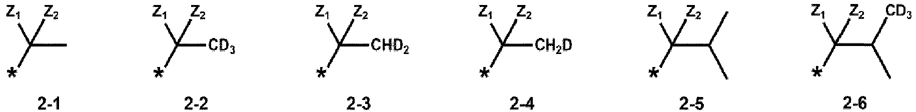 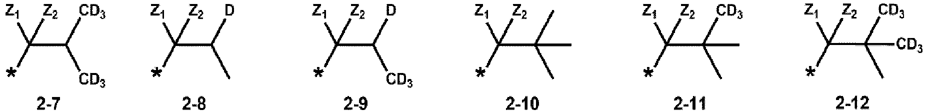 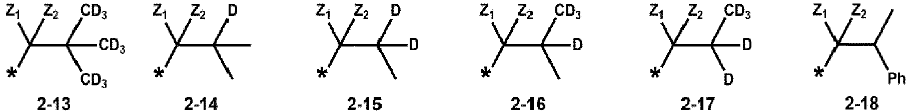 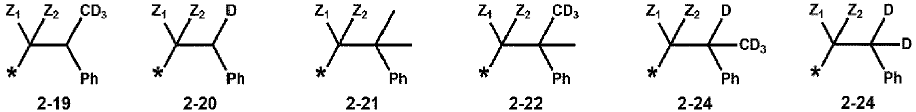 wherein, in Formulae 2-1 to 2-24,
Z₁ may be hydrogen, deuterium, a methyl group, -CD₃, -CHD₂, or -CH₂D,
Z₂ may be hydrogen or deuterium,
Ph is a phenyl group, and
* indicates a binding site to a neighboring atom.

In one or more embodiments, the number of groups represented by Formula 2 included in each of Formulae 1-1 and 1-2 may be 1.

In one or more embodiments, the number of groups represented by Formula 2 included in each of Formulae 1-1 and 1-2 may be 2 or greater (for example, 2, 3, or 4).

In one or more embodiments, the number of carbon atoms included in the group represented by Formula 2 may be 4 or greater (for example, 4, 5, 6, 7, 8, 9, or 10).

The organometallic compound may include at least one deuterium.

For example, the number of deuteriums included in the organometallic compound may be 2 or greater, 4 or greater, 6 or greater, 8 or greater, 10 or greater, or 12 or greater, for example, 2 to 14, 5 to 12, or 7 to 12.

In one or more embodiments, the group represented by Formula 2 may include at least one deuterium. For example, the number of deuteriums included in the group represented by Formula 2 may be 1, 2, 3, 4, 5, 6, 7, 8, 9, or 10.

In one or more embodiments, at least one of R₅₁ to R₅₅, at least one of R₆₁ to Res, or a combination thereof in Formulae 1-1 and 1-2 may include at least one deuterium.

In one or more embodiments, the organometallic compound may be represented by at least one of Compounds 1 to 1080, but embodiments are not limited thereto:

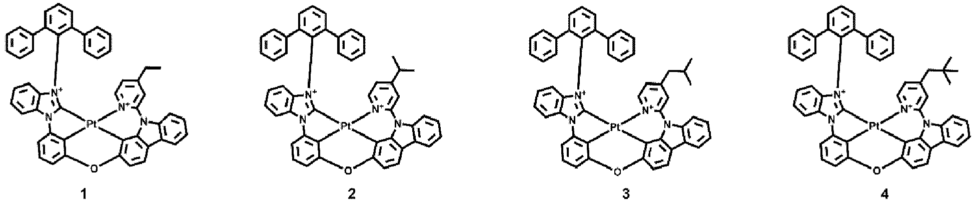

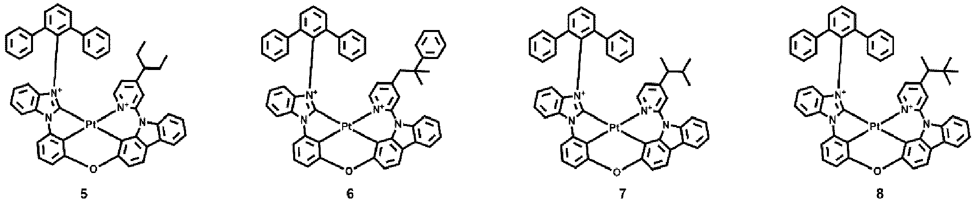

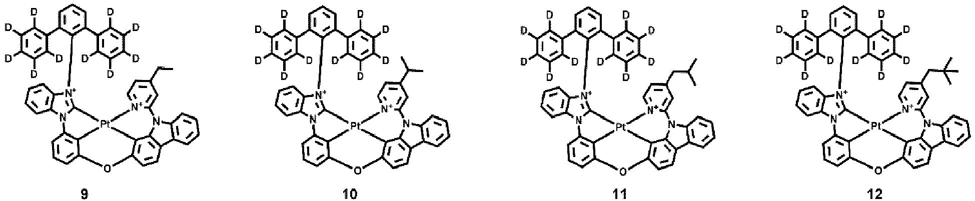

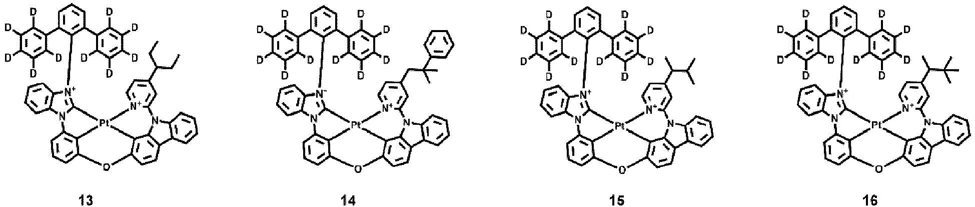

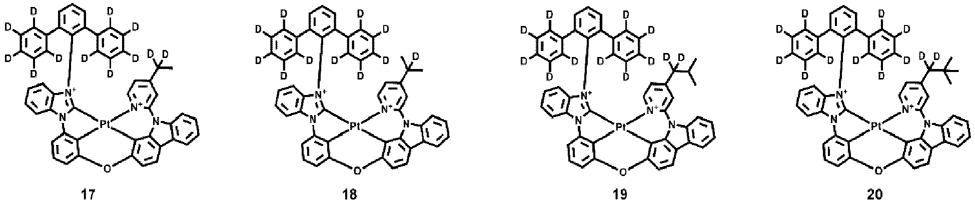

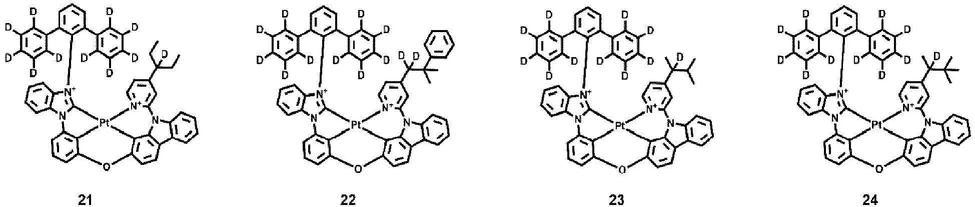

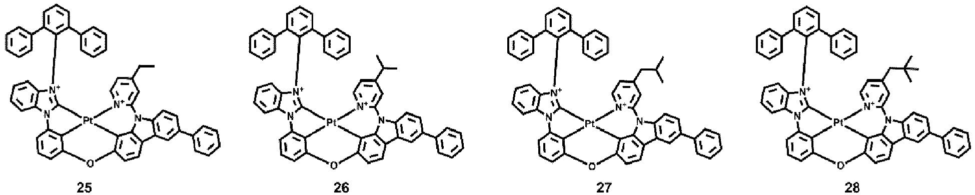

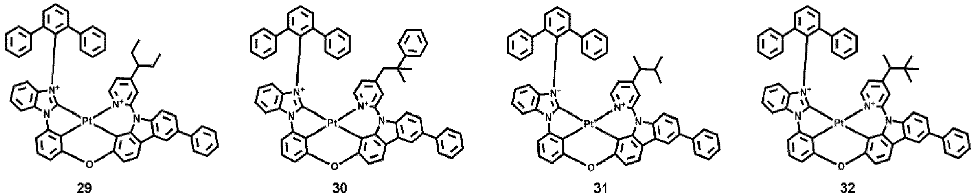

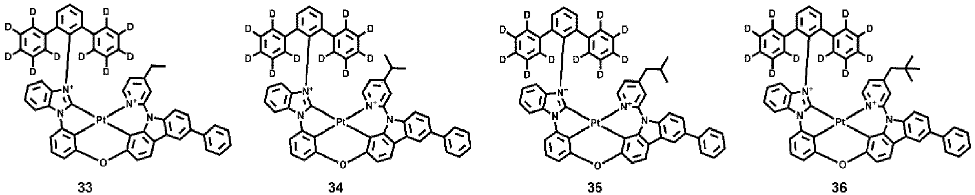

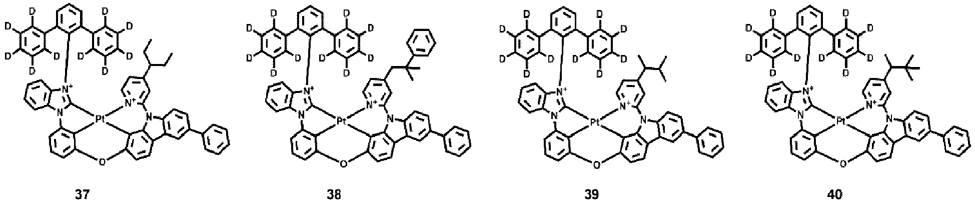

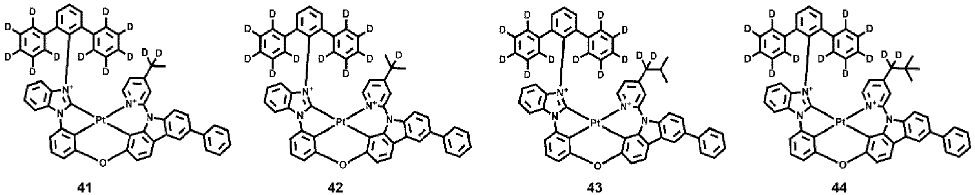

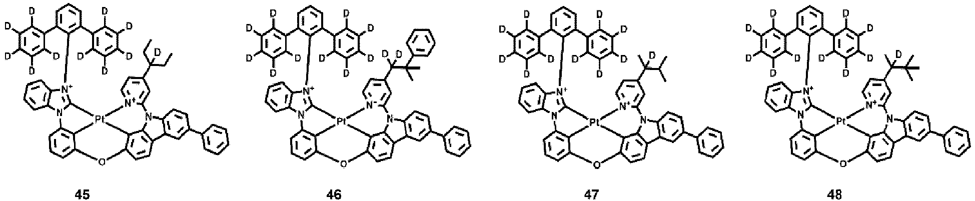

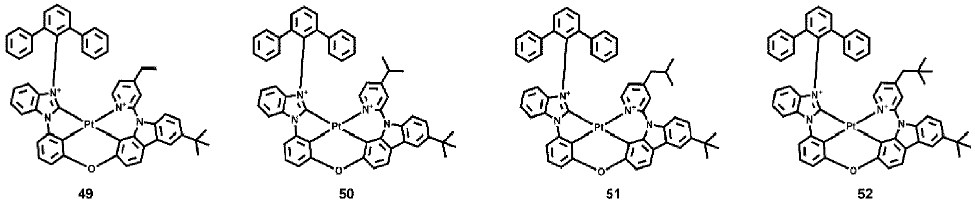

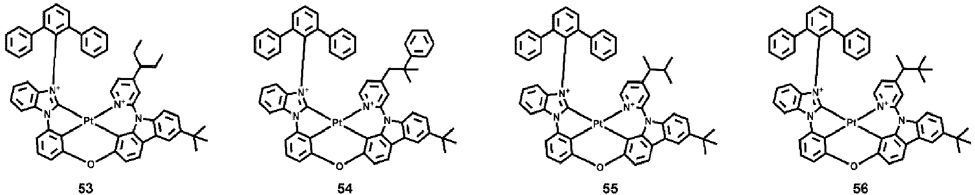

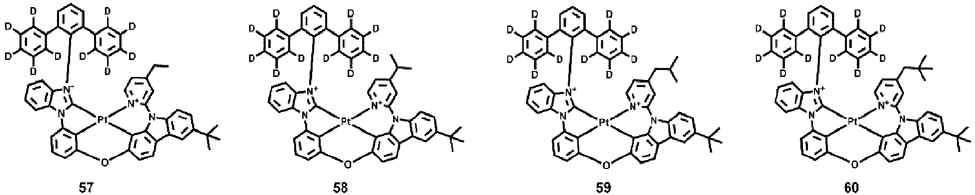

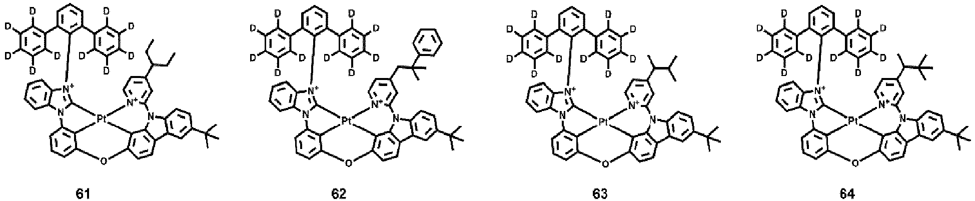

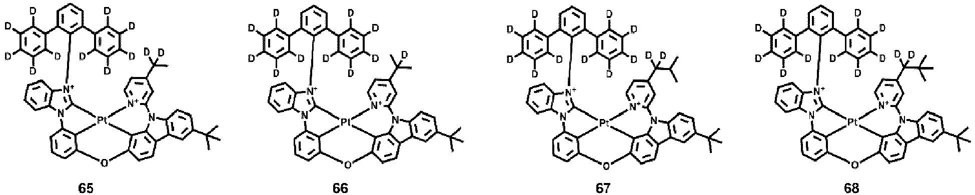

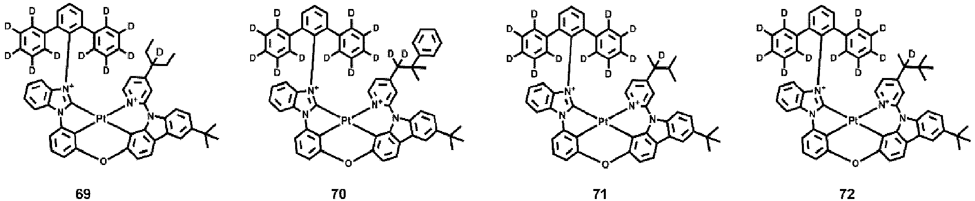

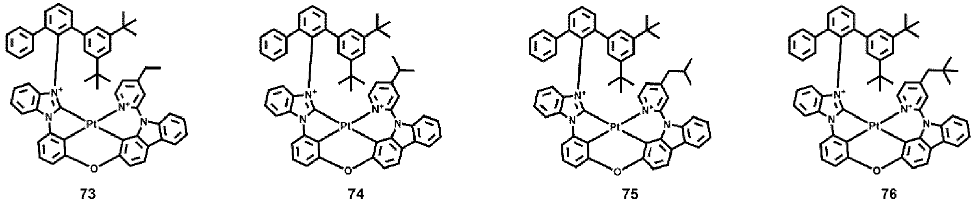

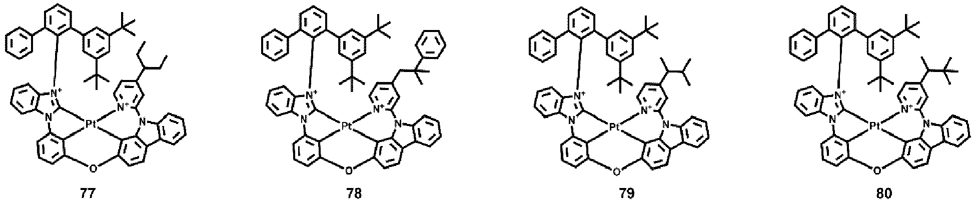

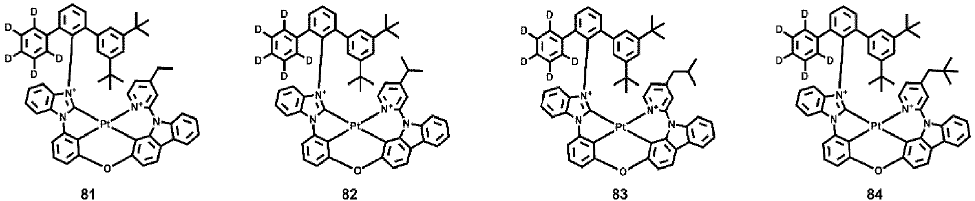

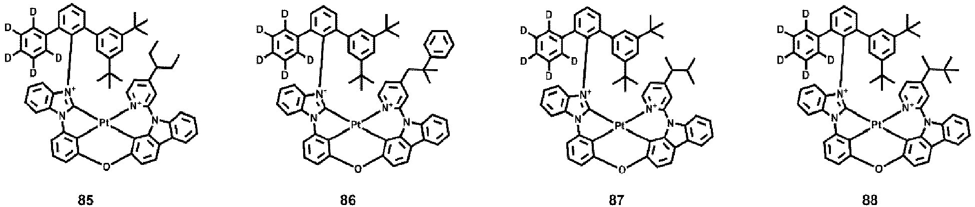

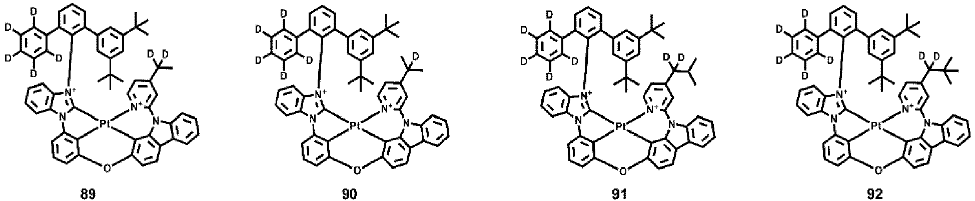

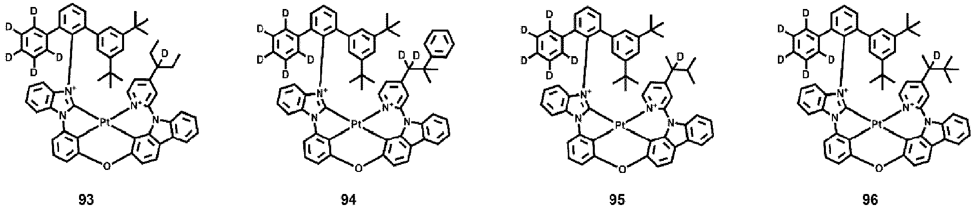

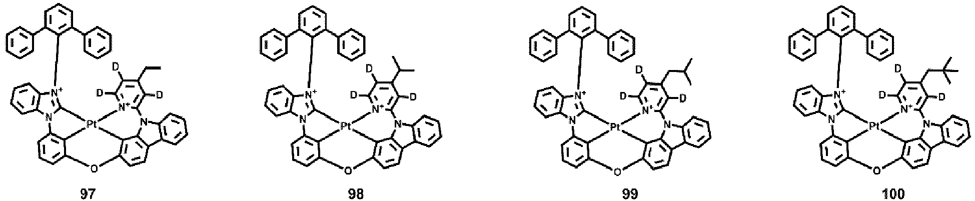

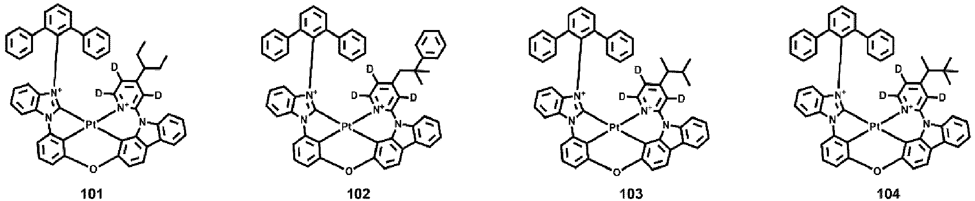

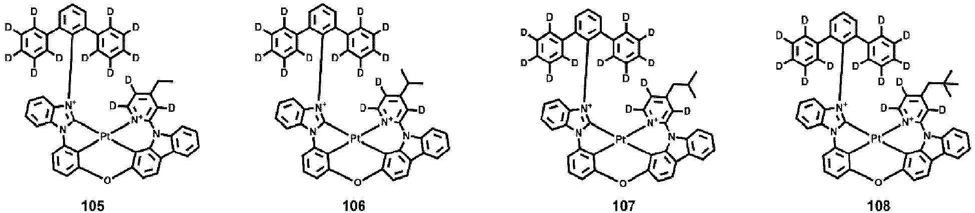

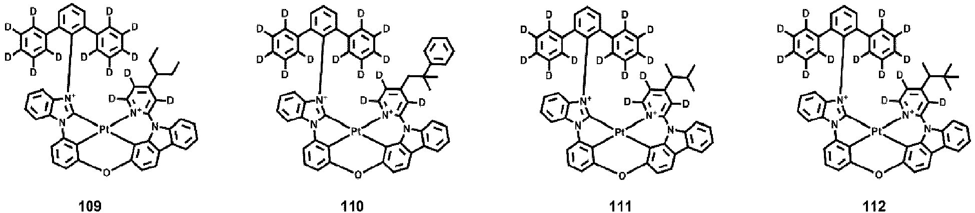

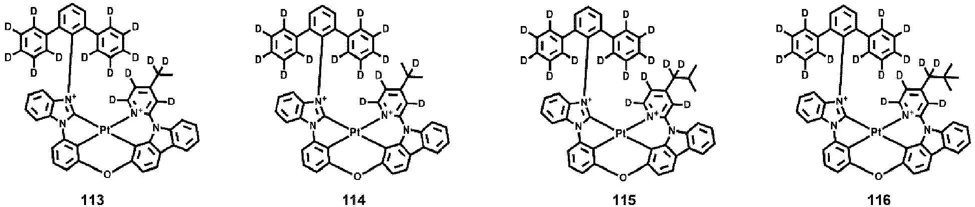

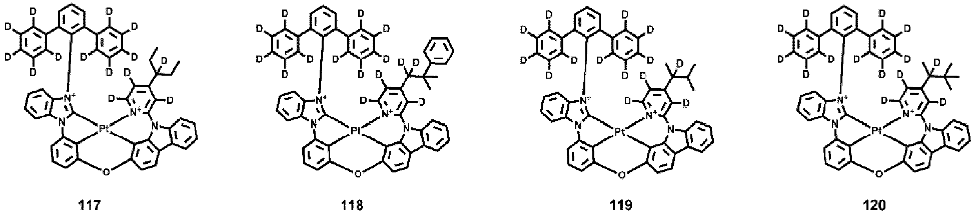

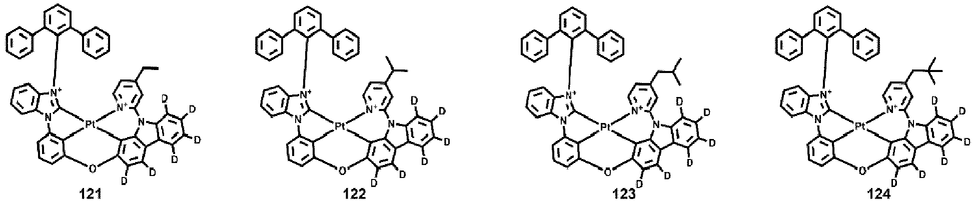

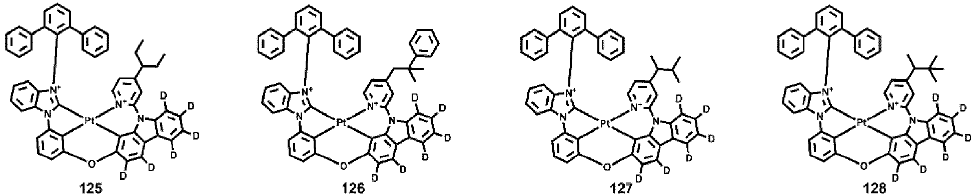

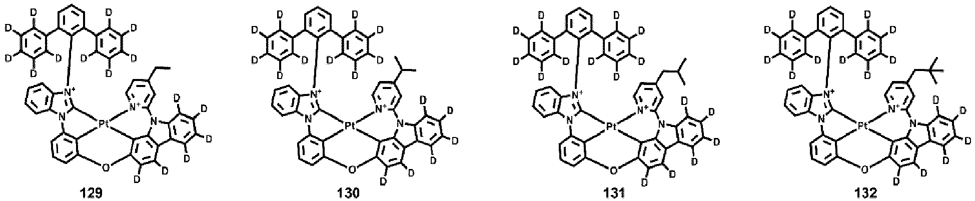

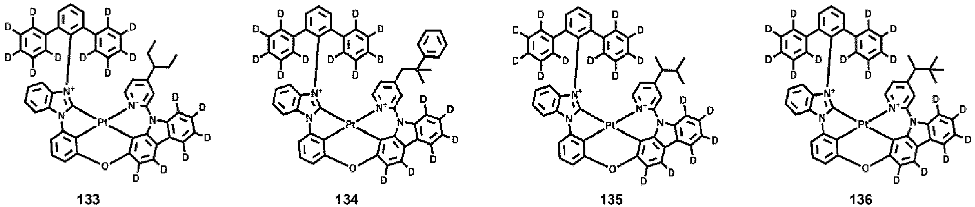

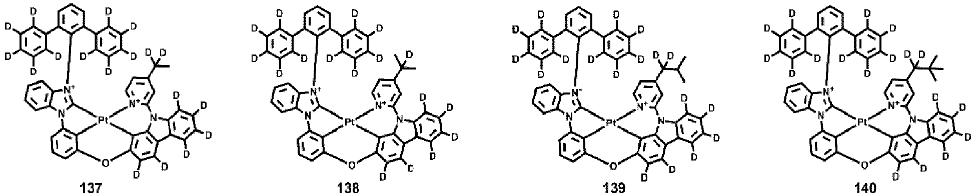

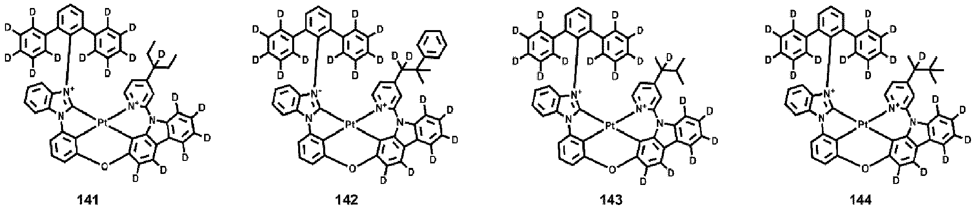

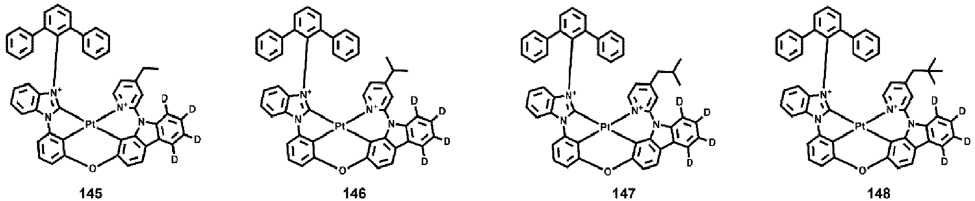

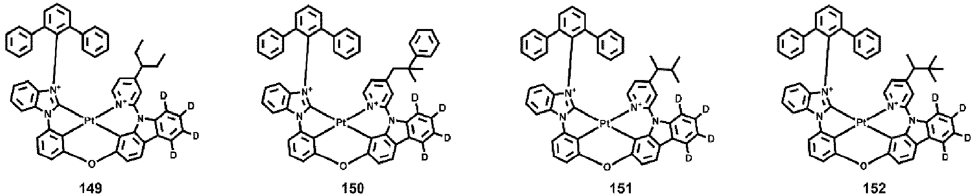

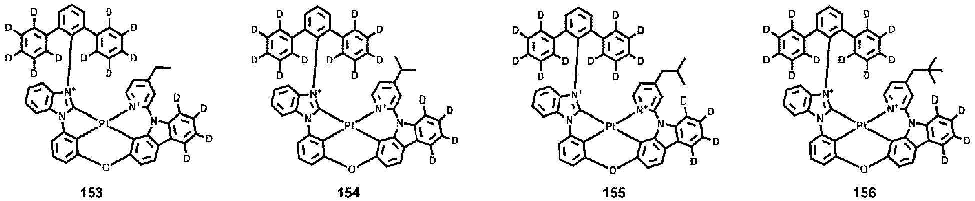

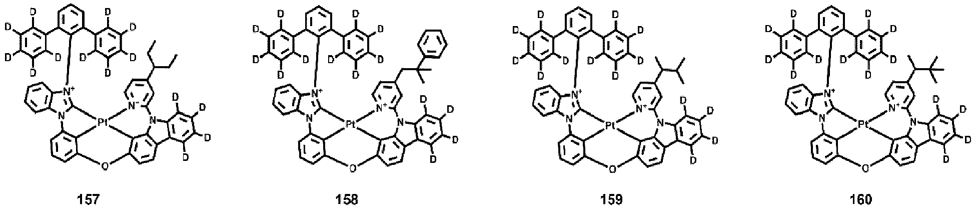

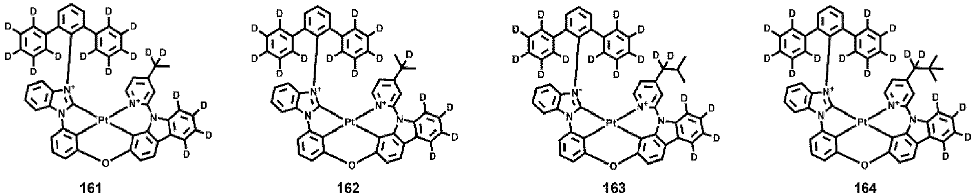

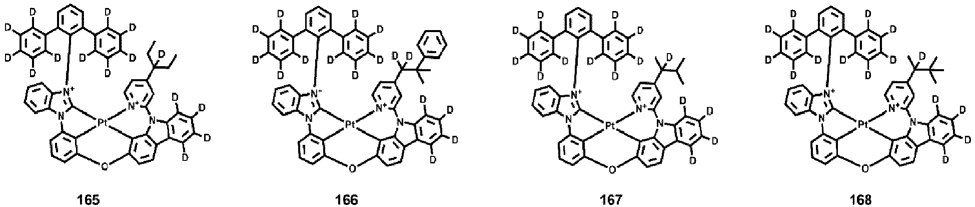

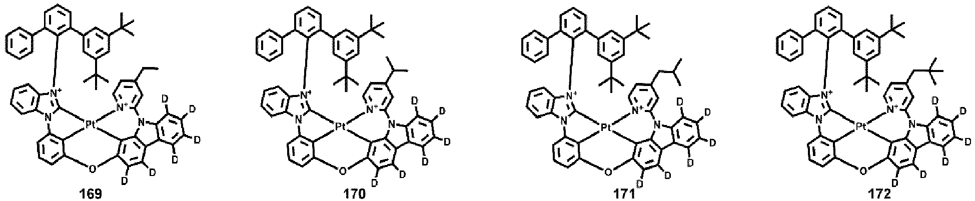

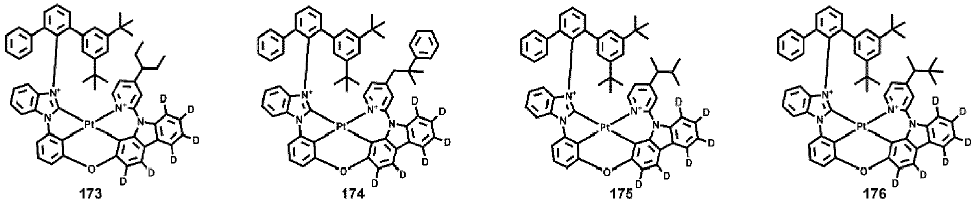

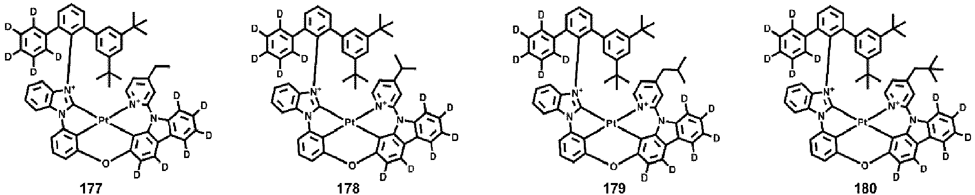

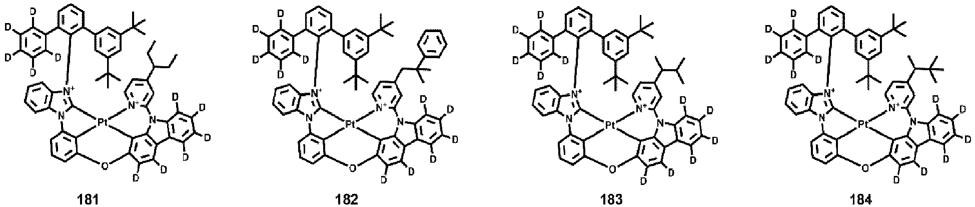

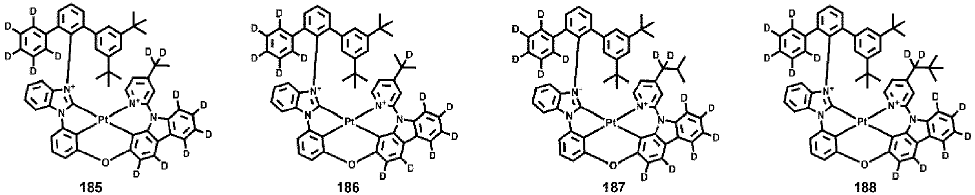

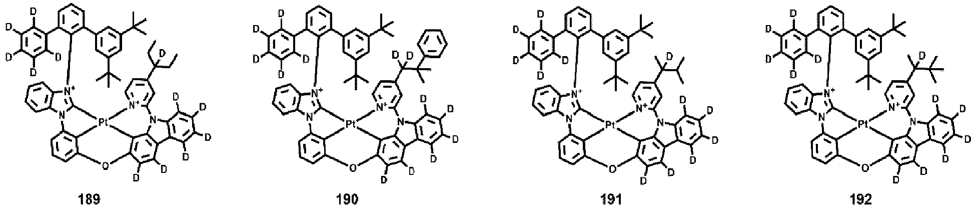

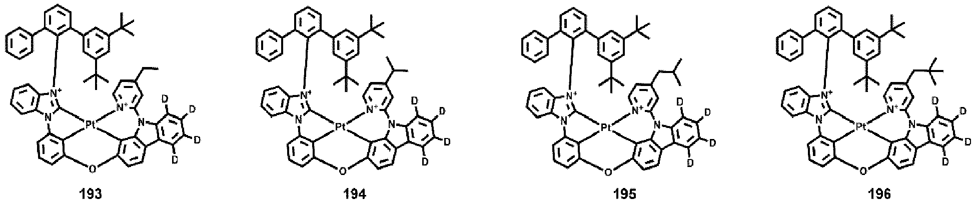

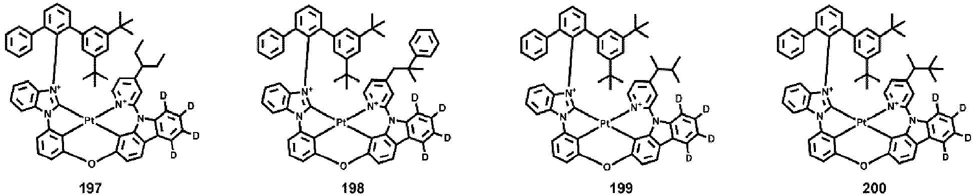

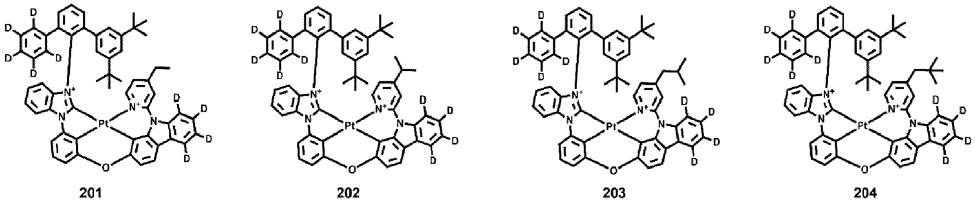

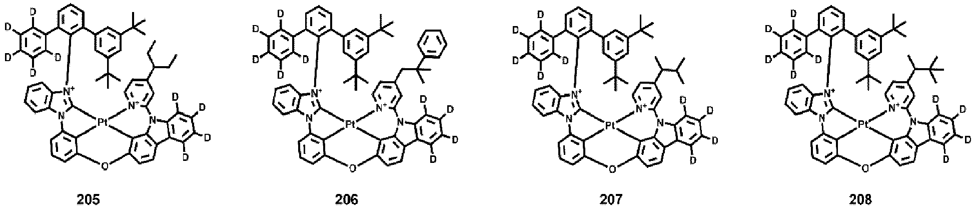

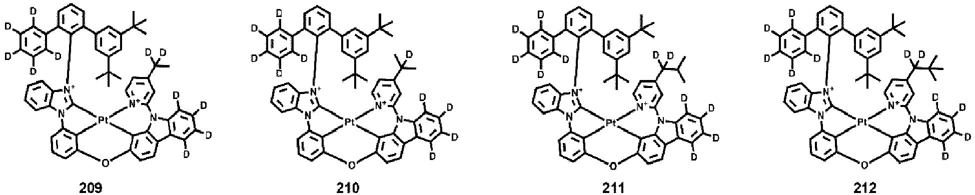

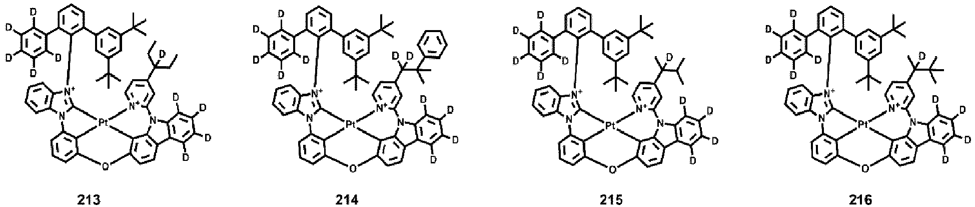

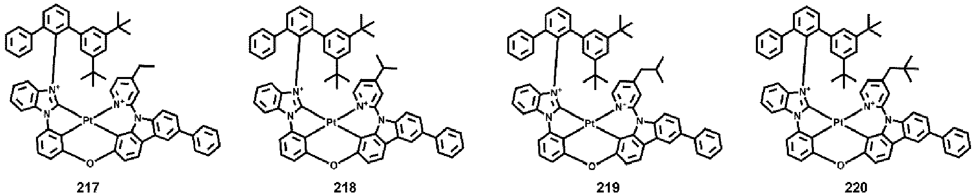

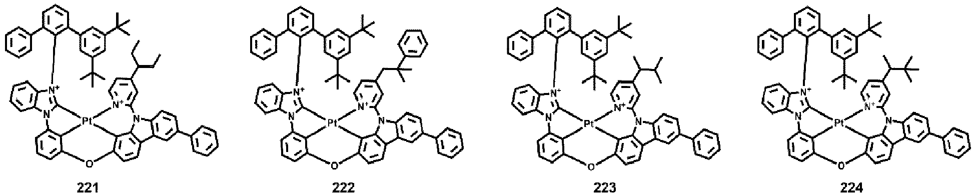

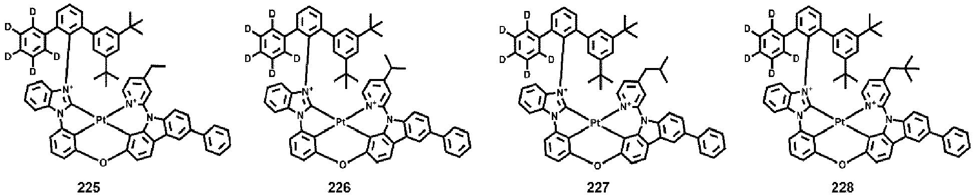

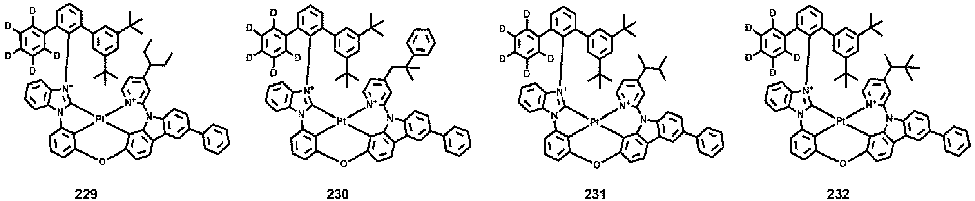

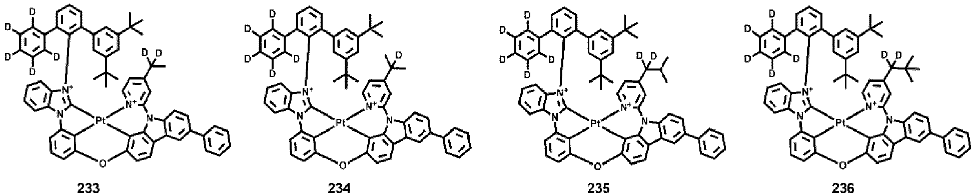

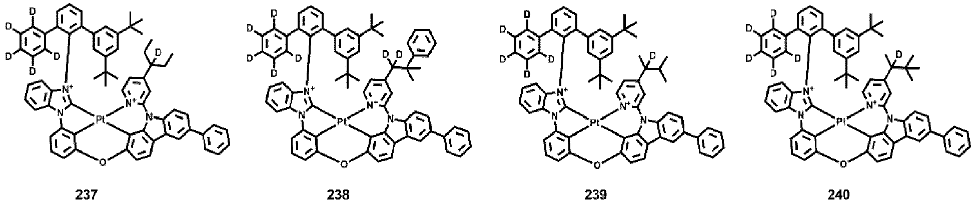

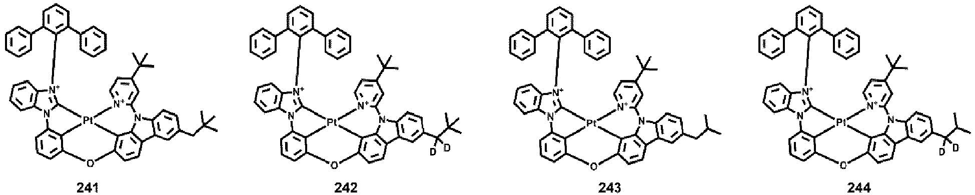

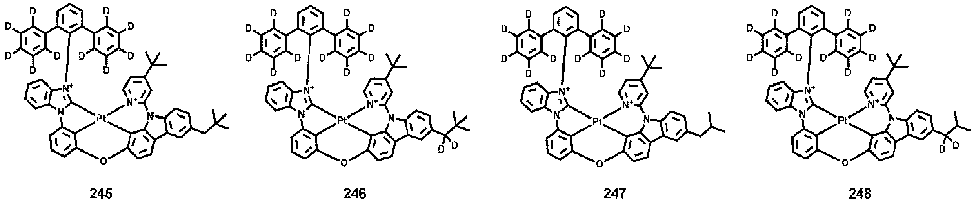

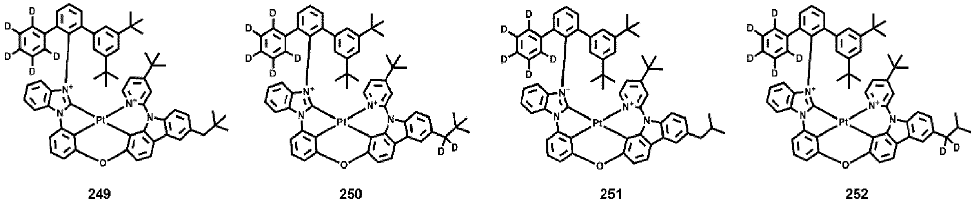

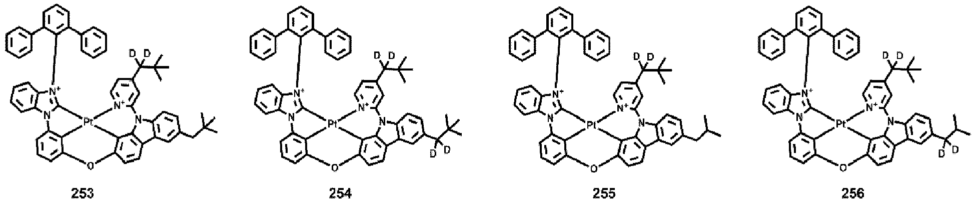

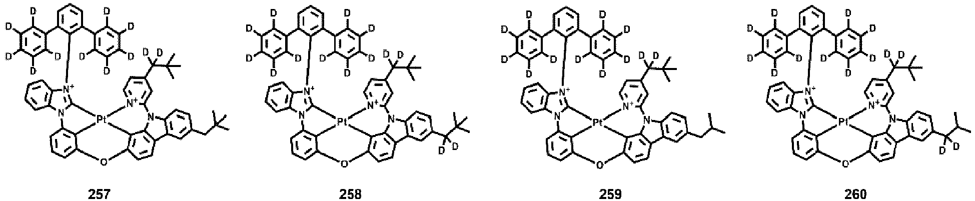

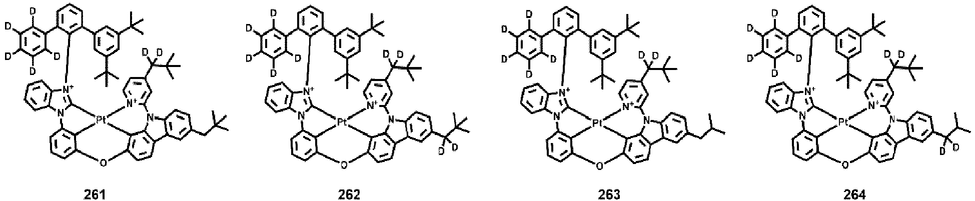

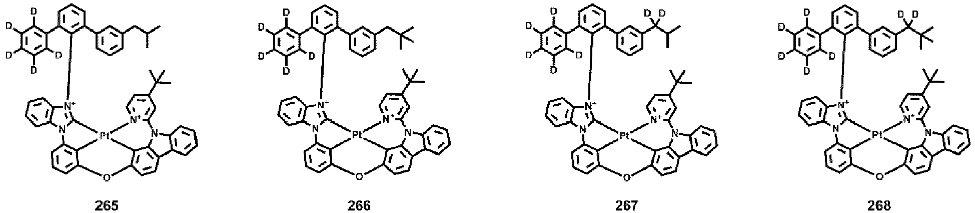

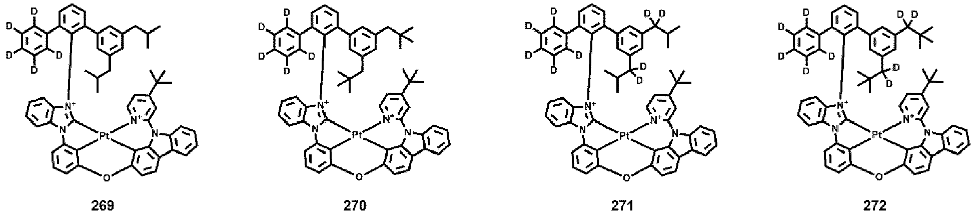

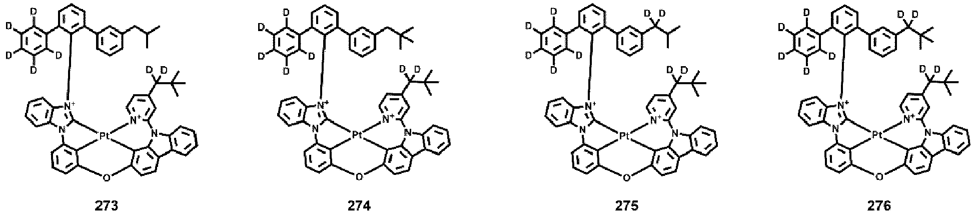

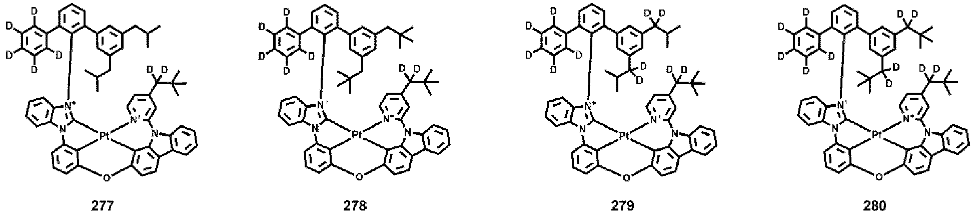

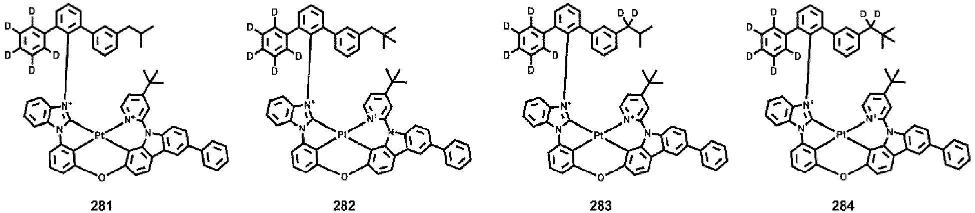

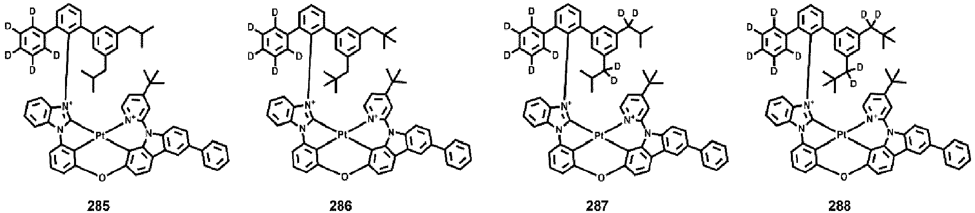

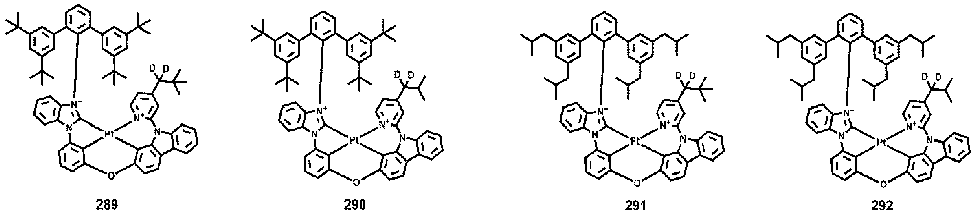

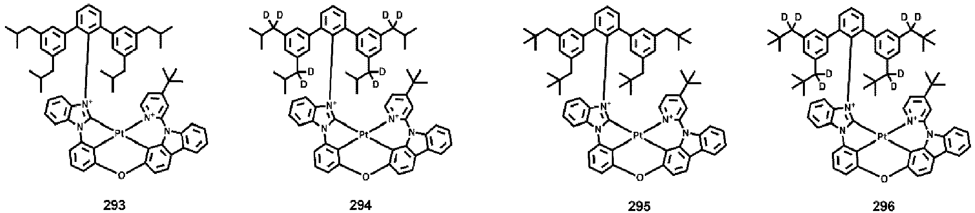

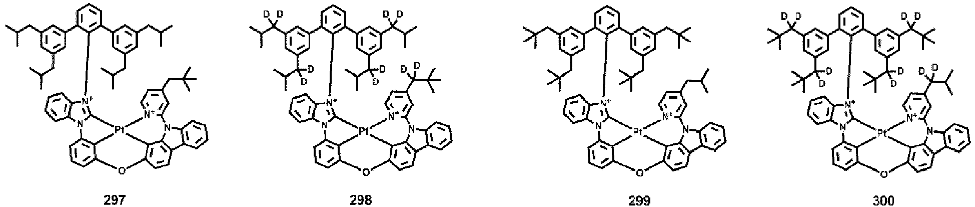

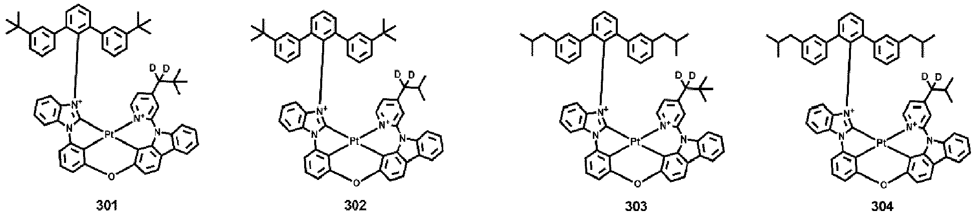

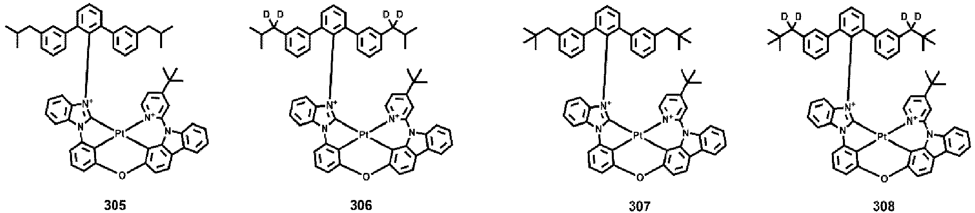

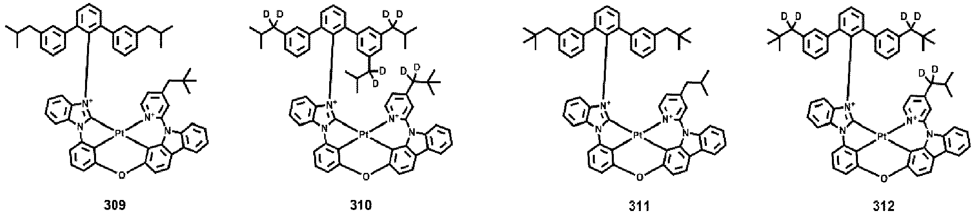

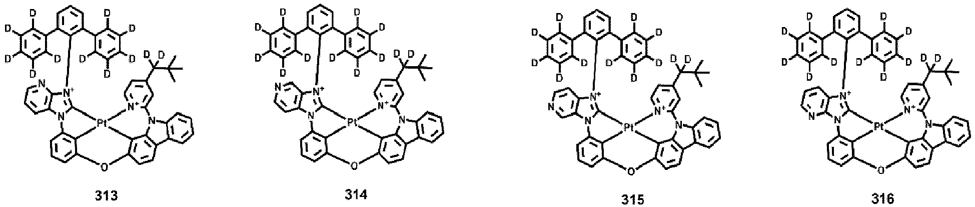

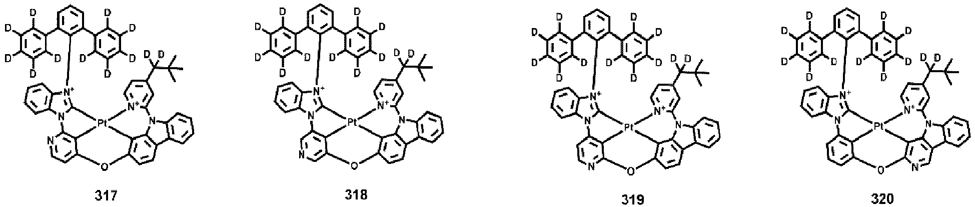

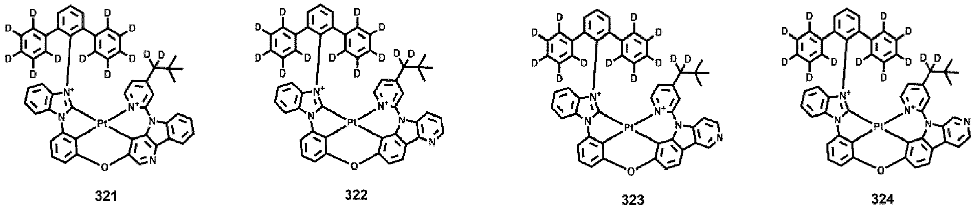

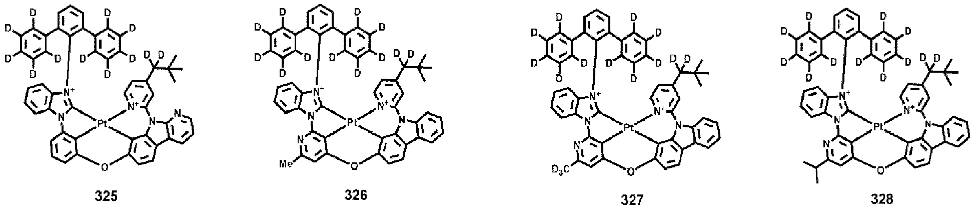

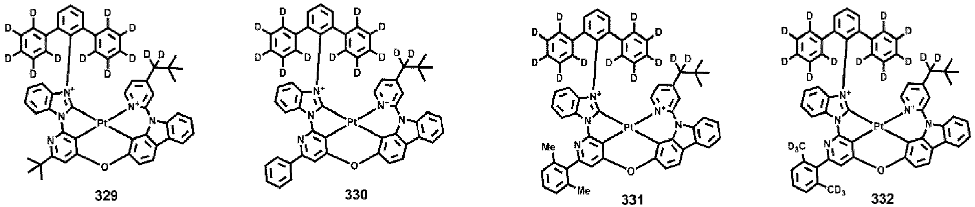

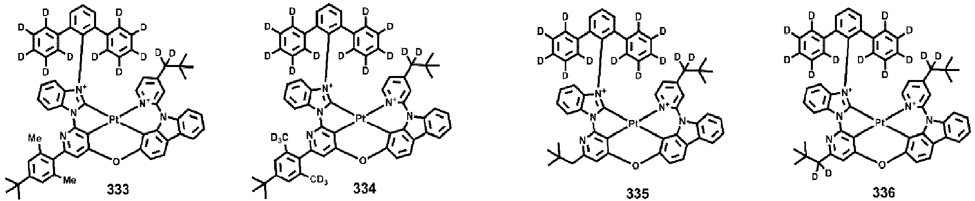

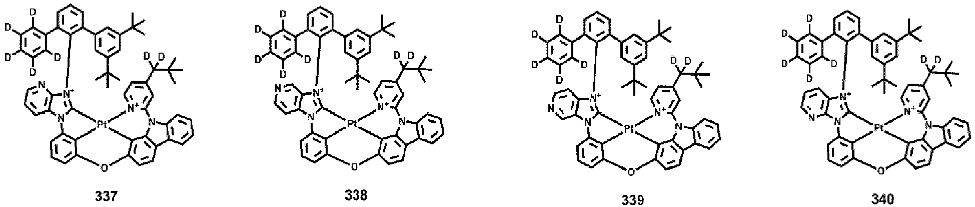

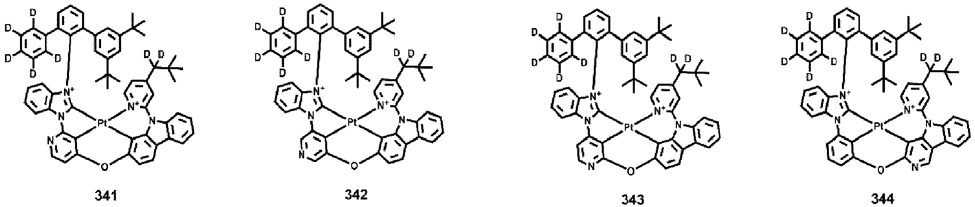

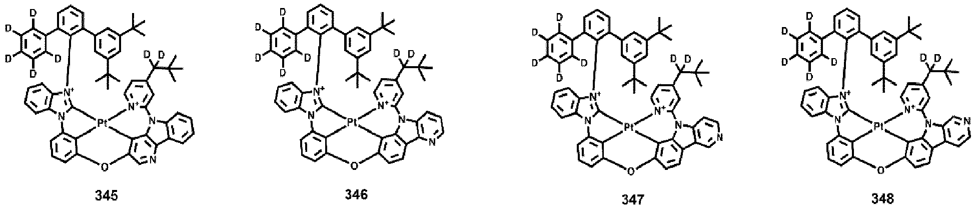

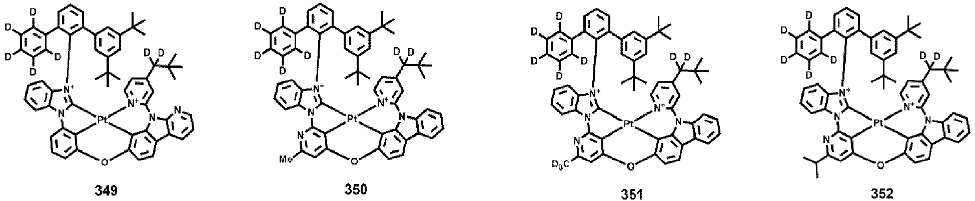

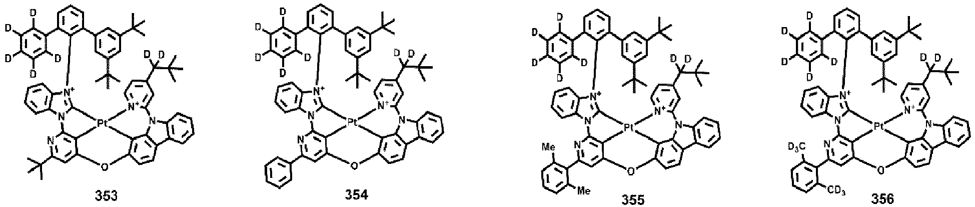

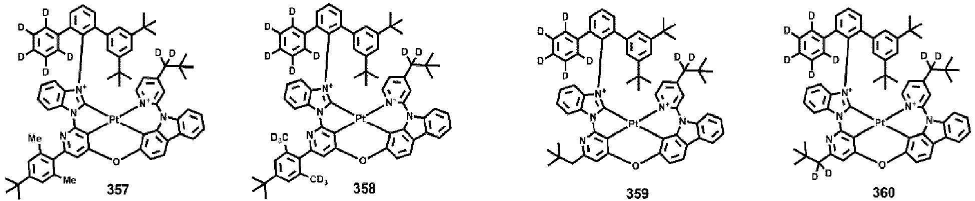

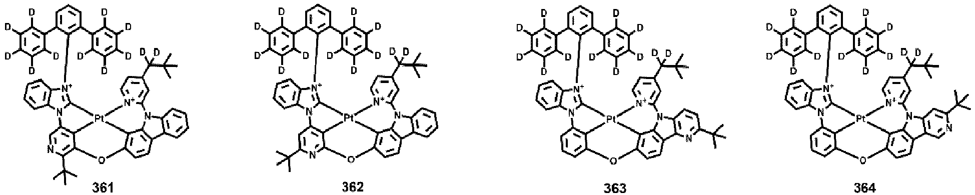

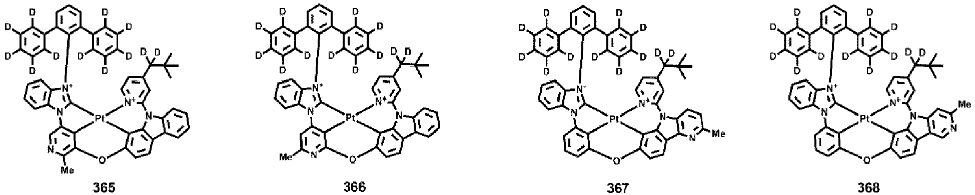

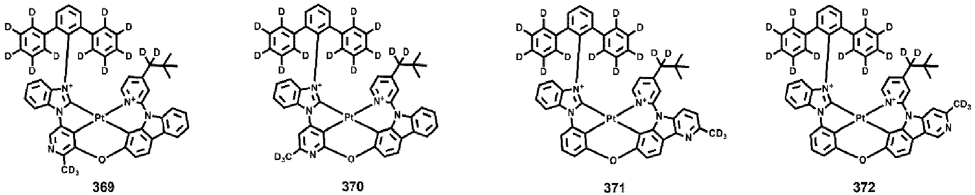

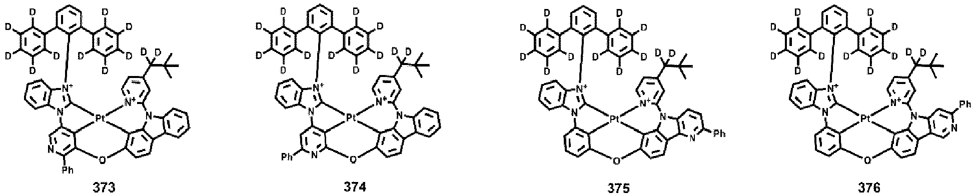

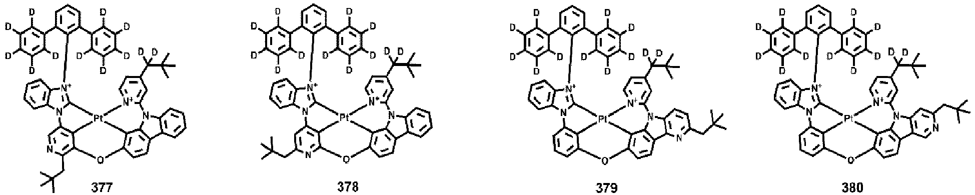

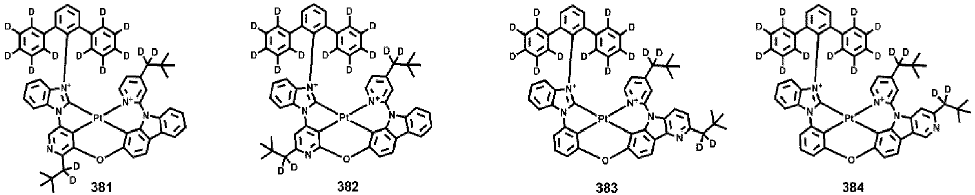

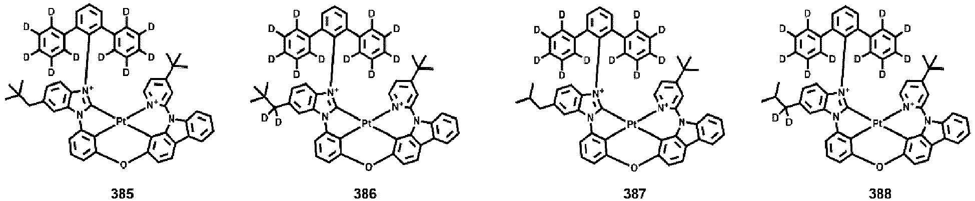

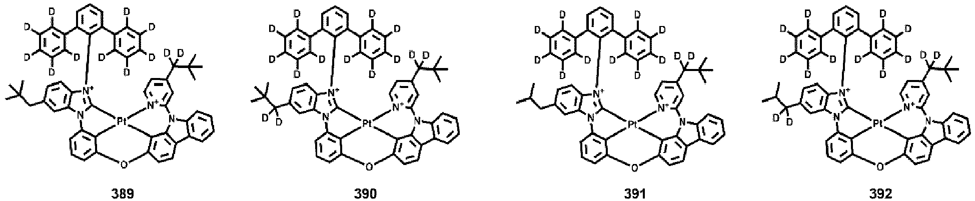

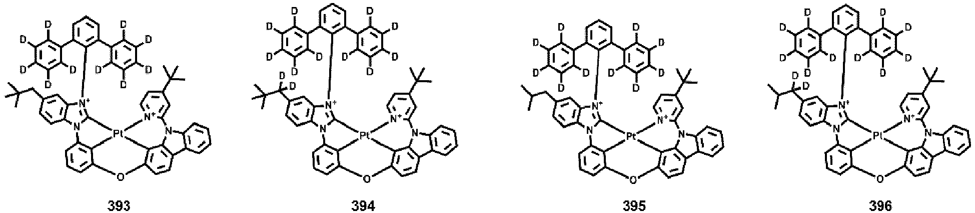

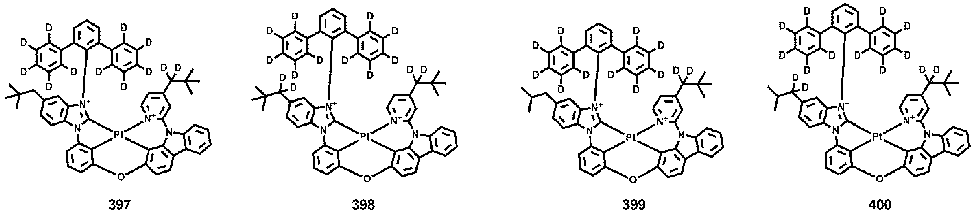

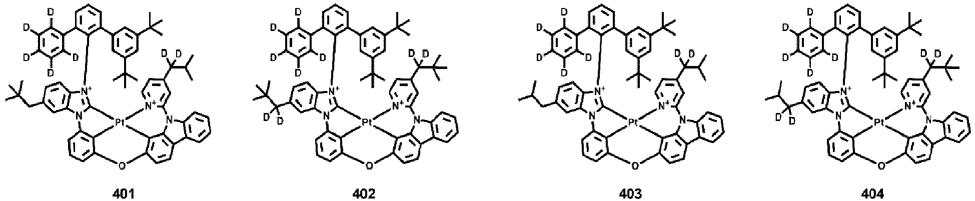

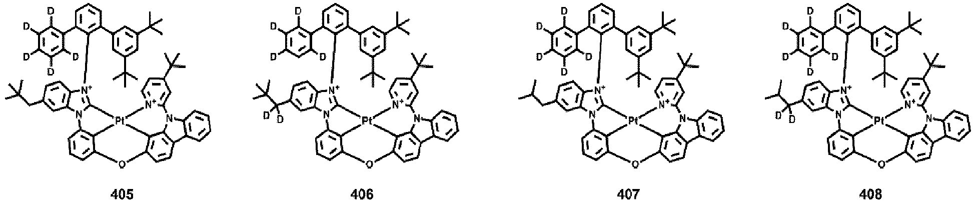

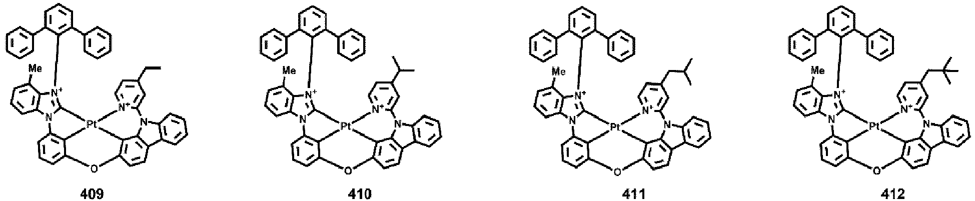

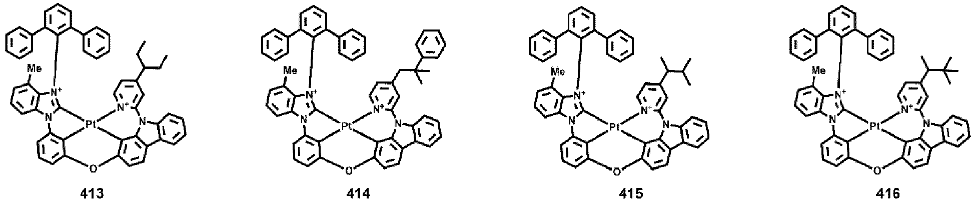

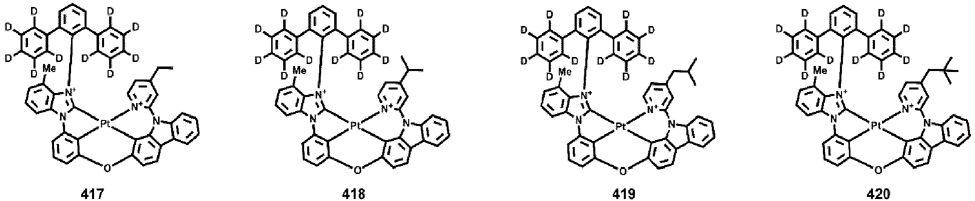

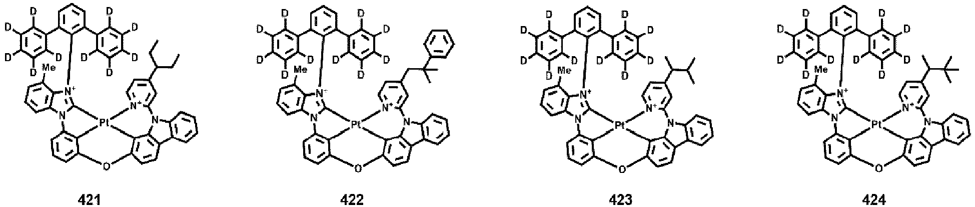

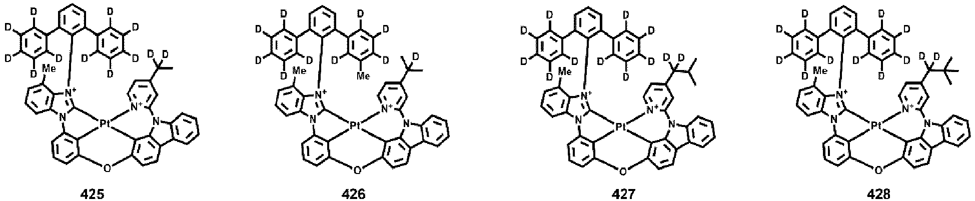

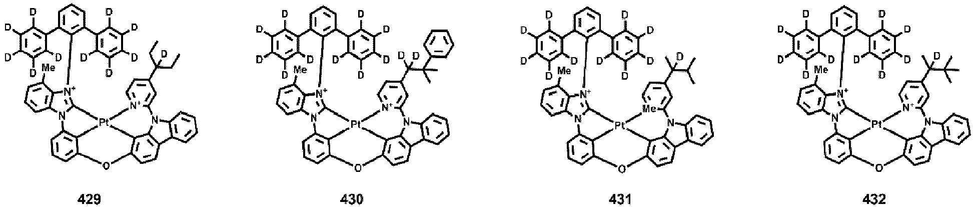

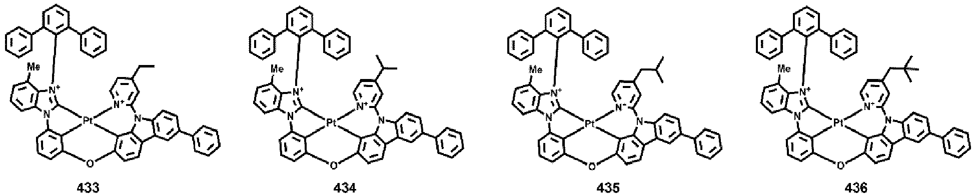

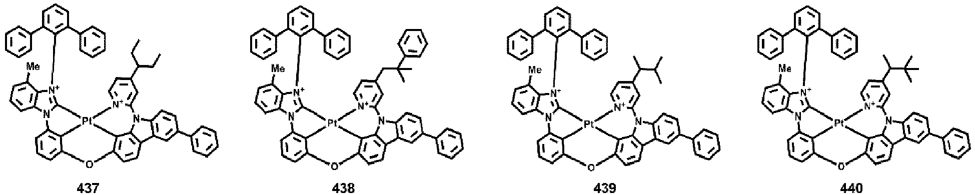

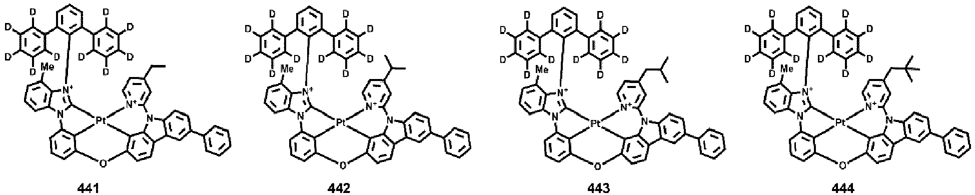

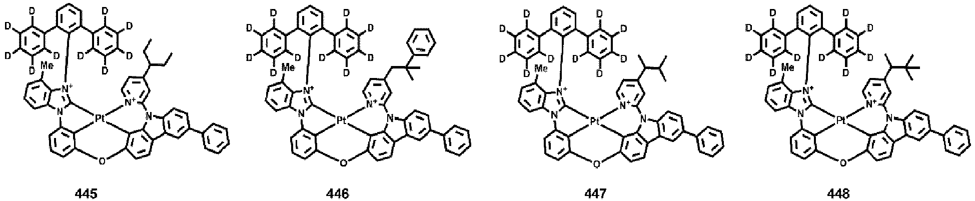

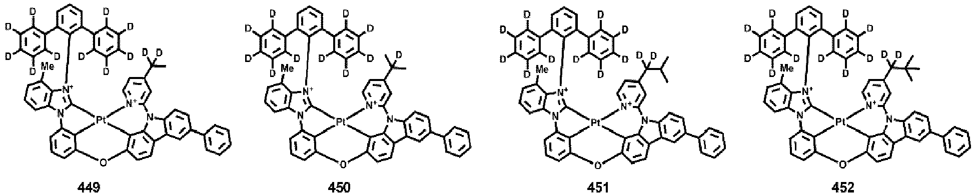

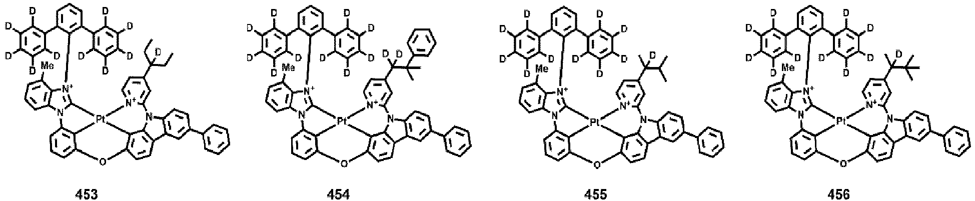

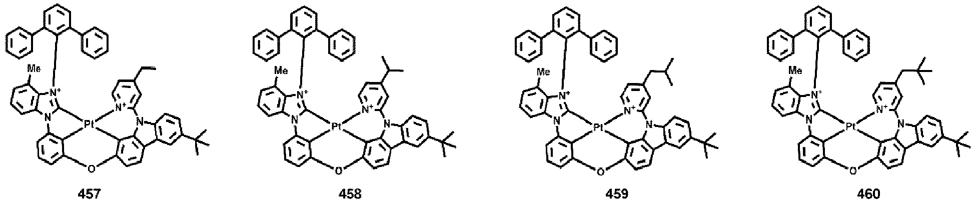

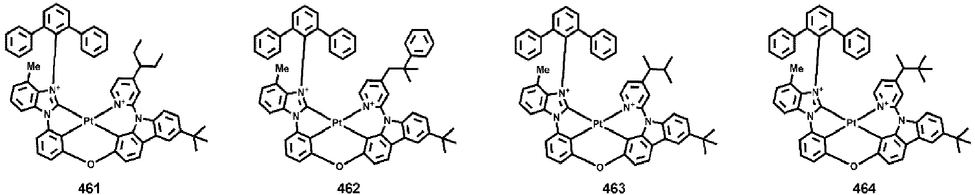

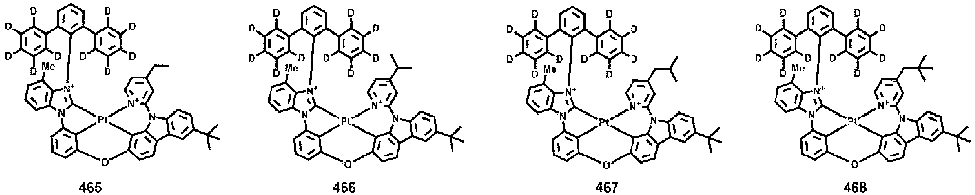

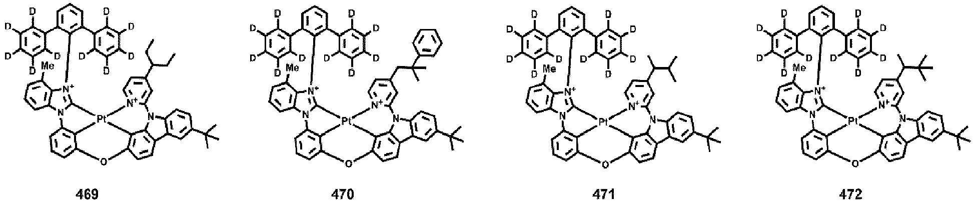

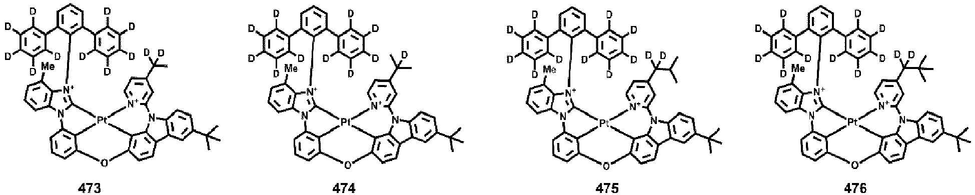

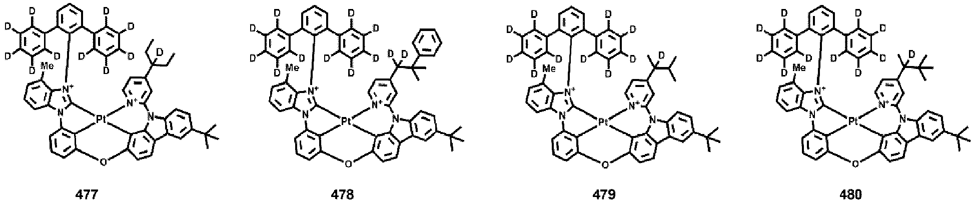

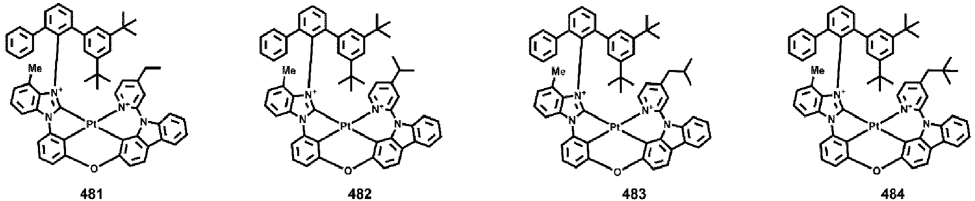

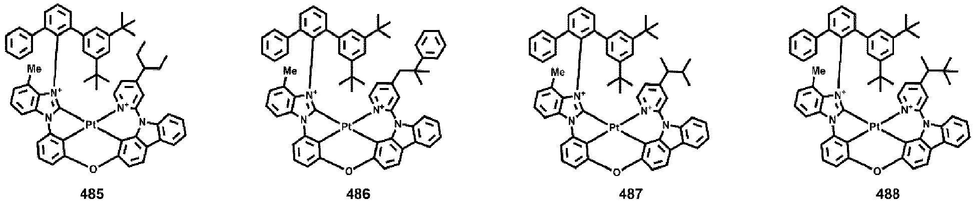

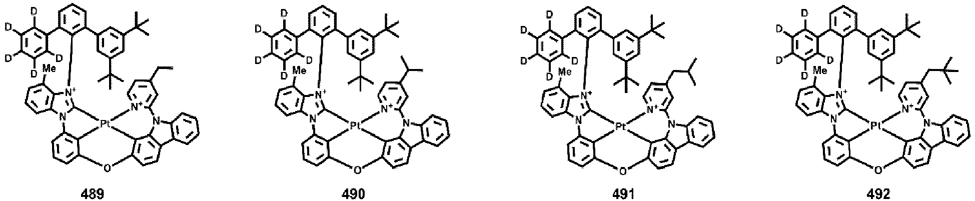

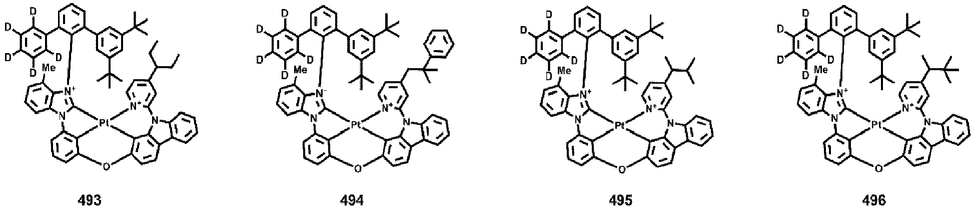

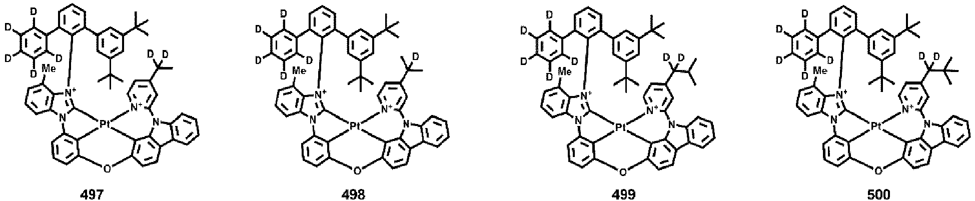

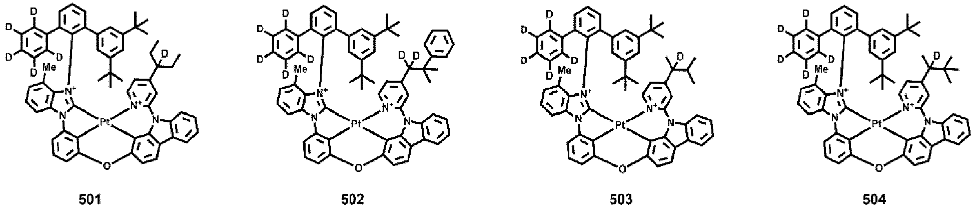

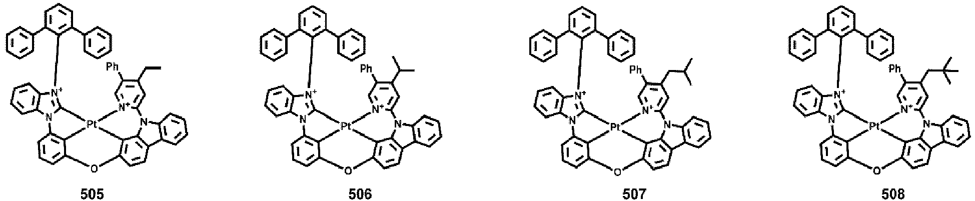

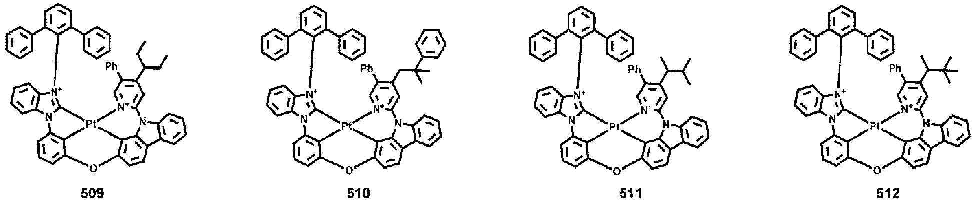

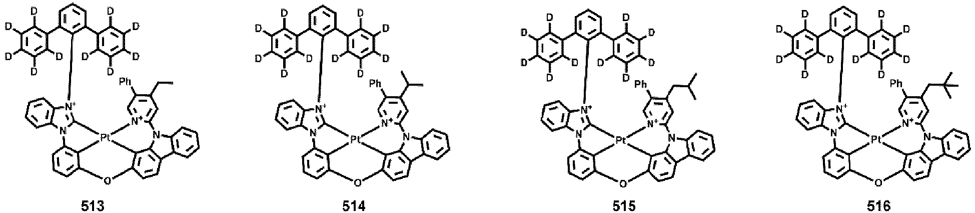

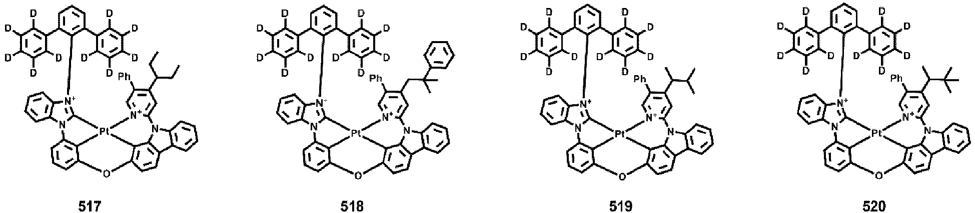

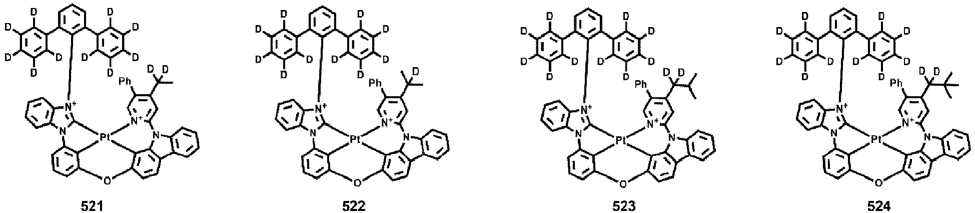

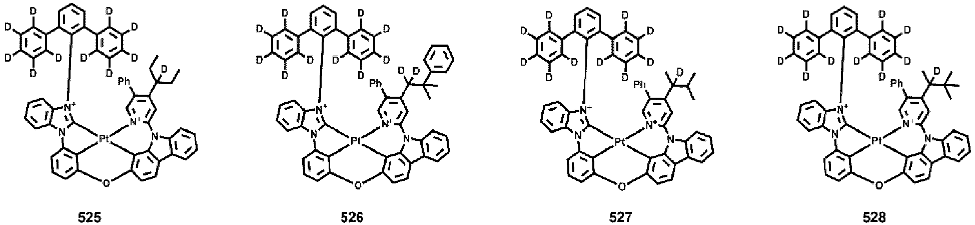

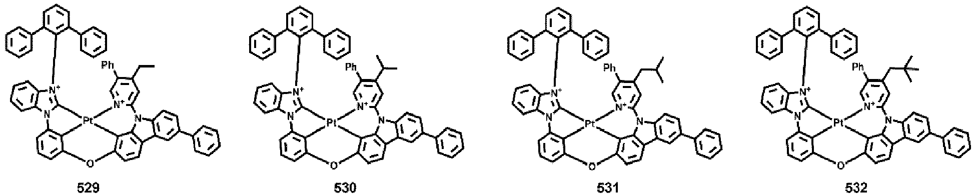

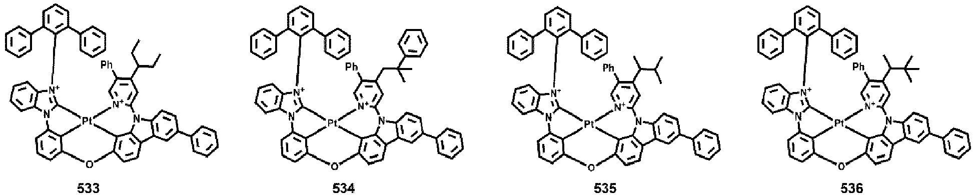

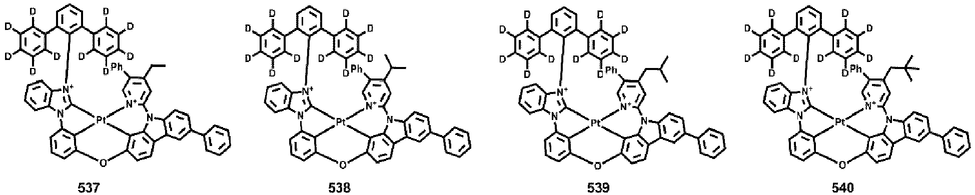

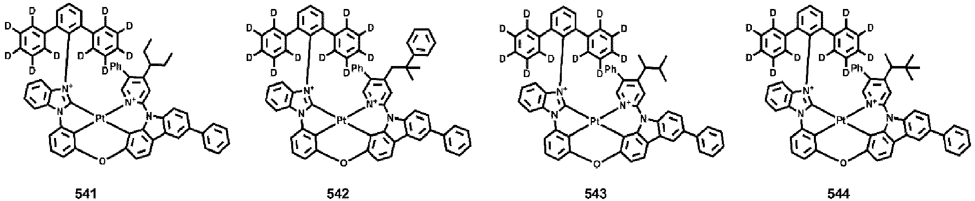

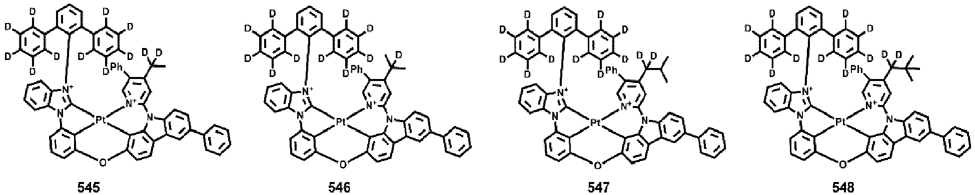

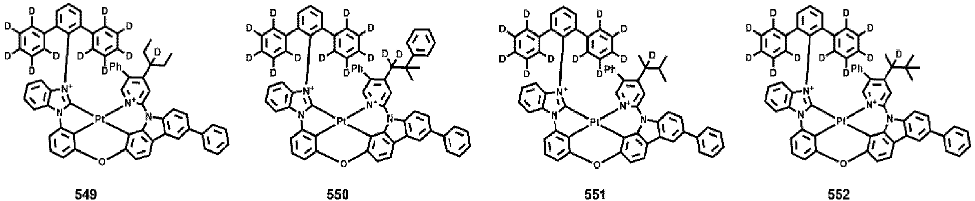

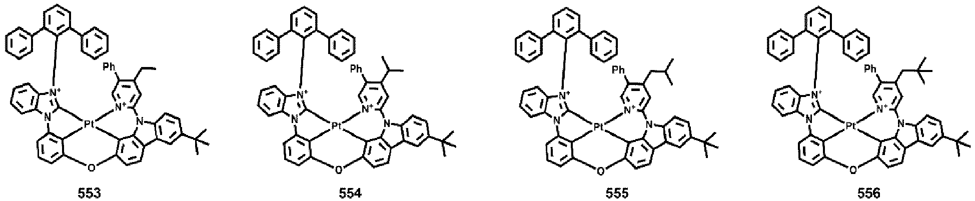

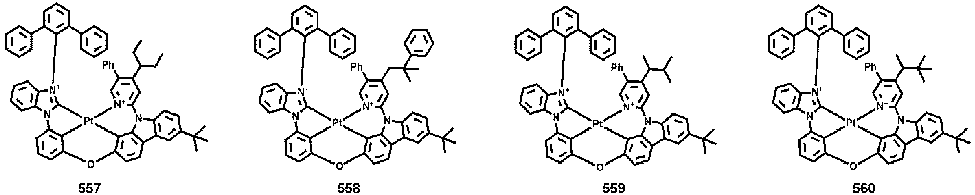

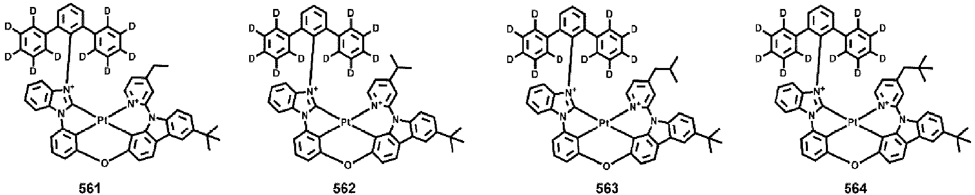

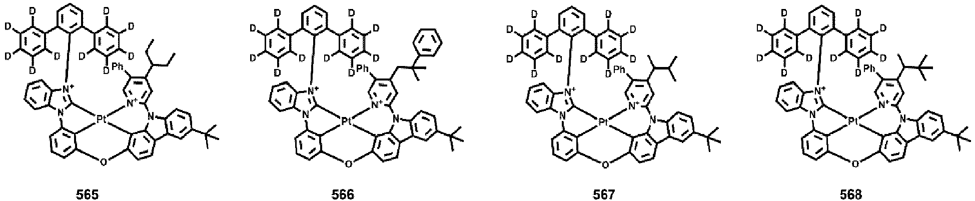

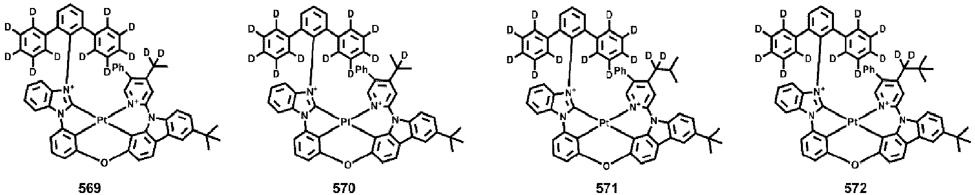

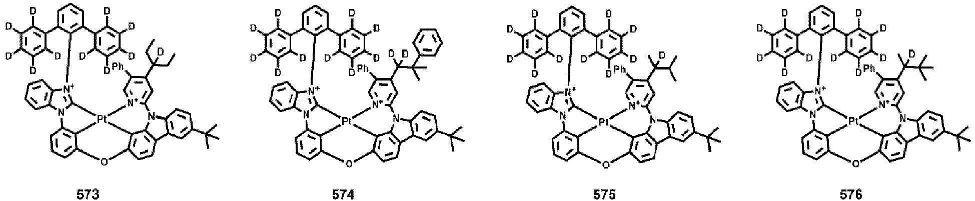

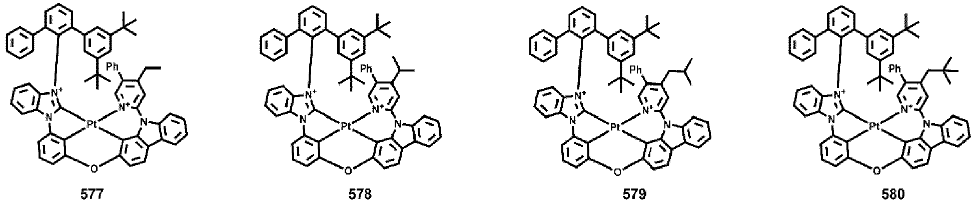

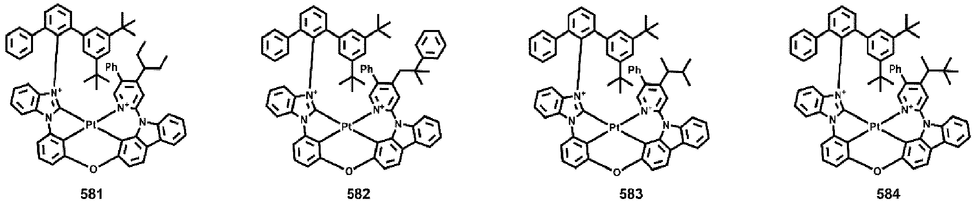

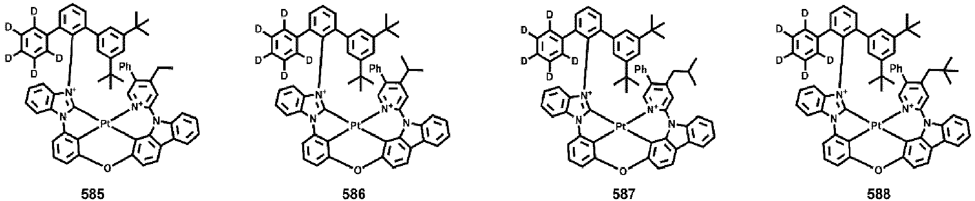

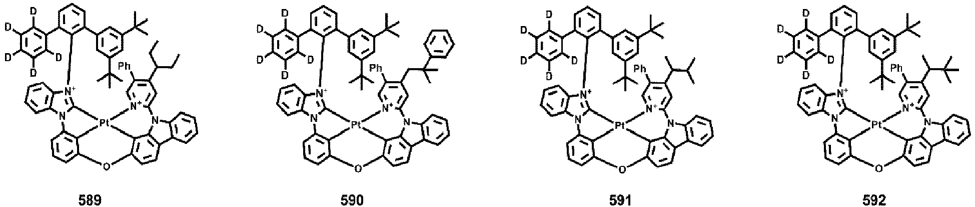

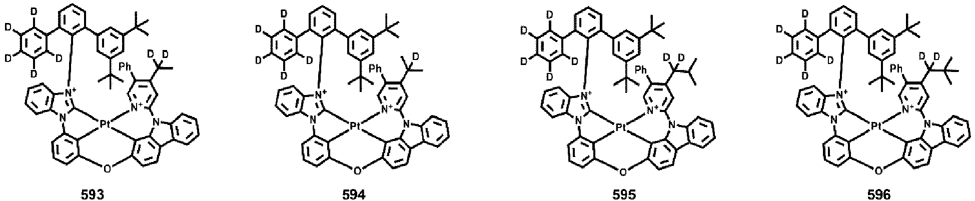

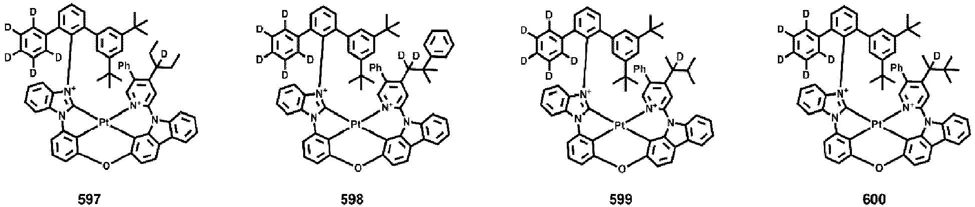

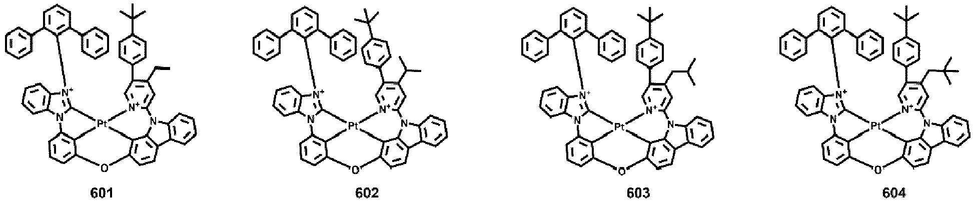

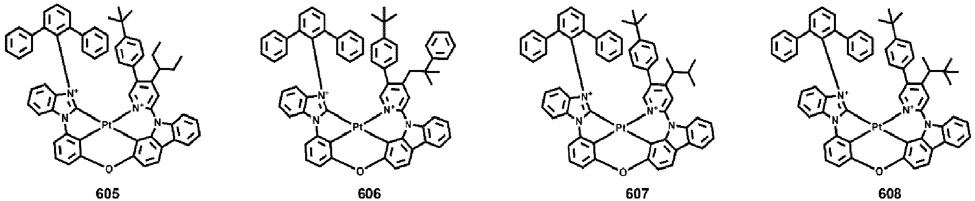

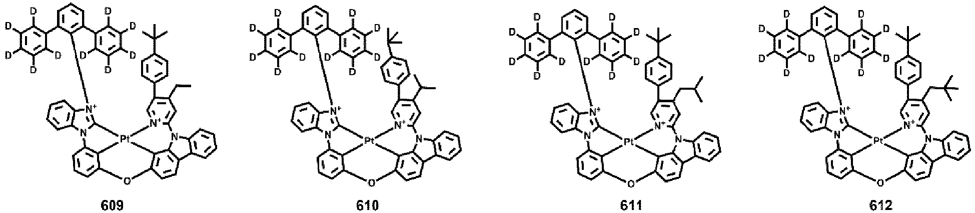

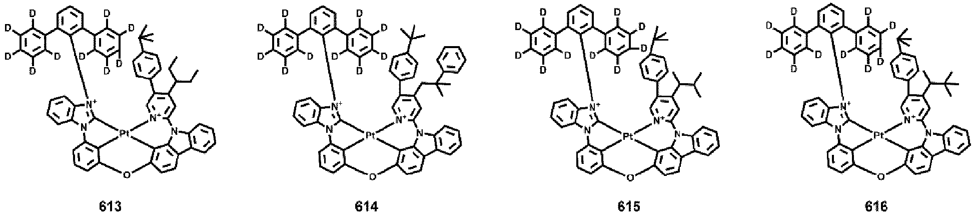

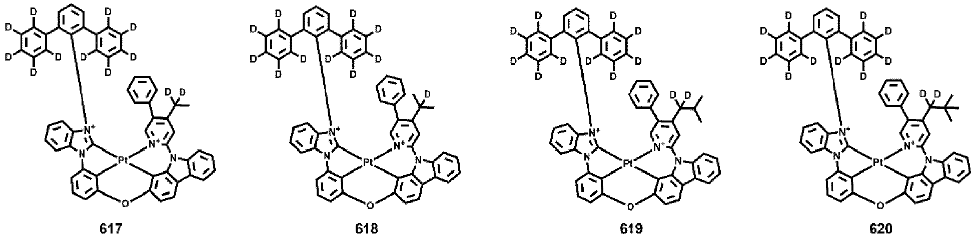

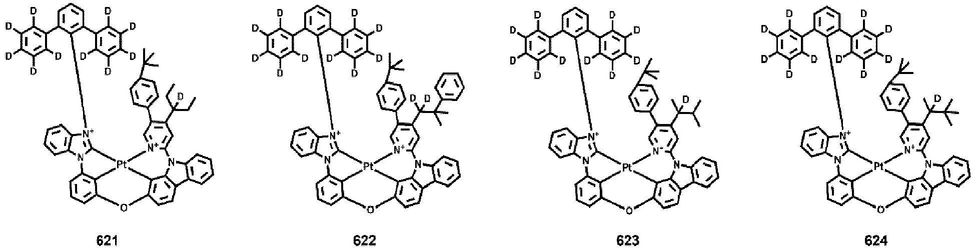

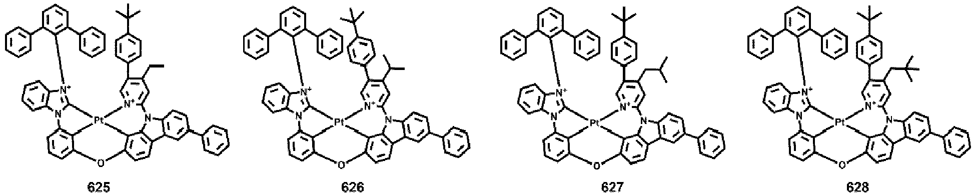

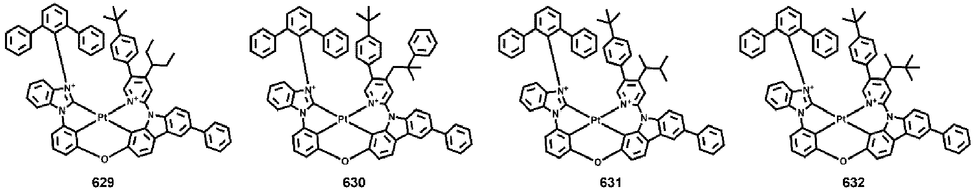

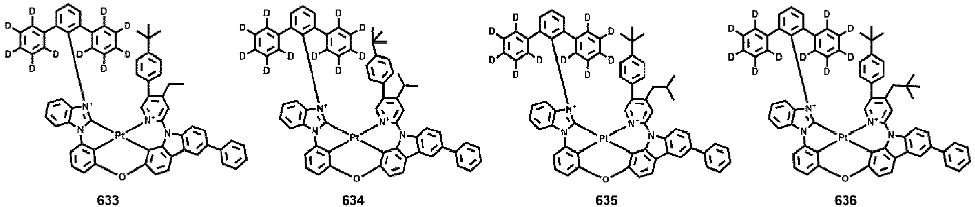

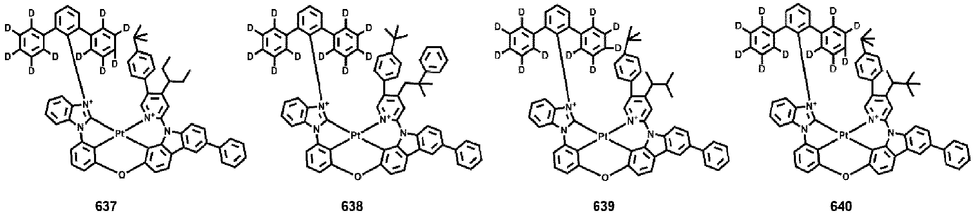

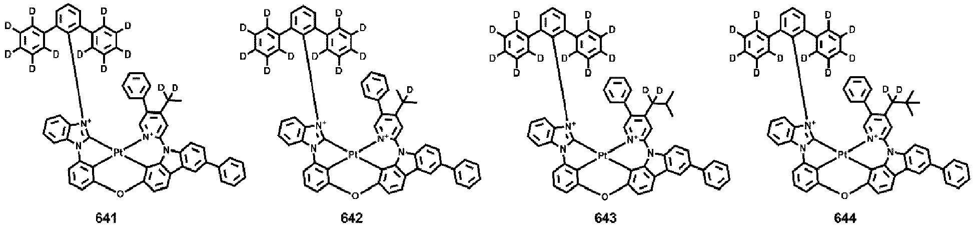

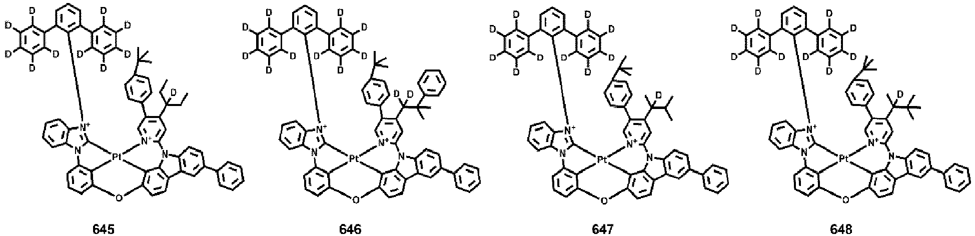

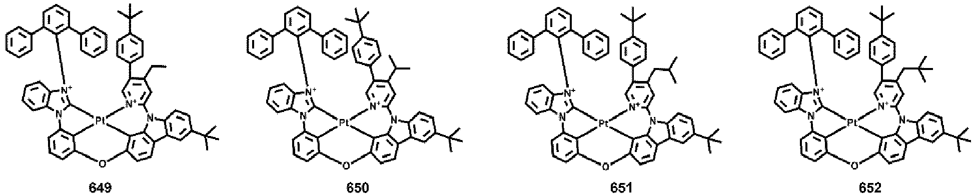

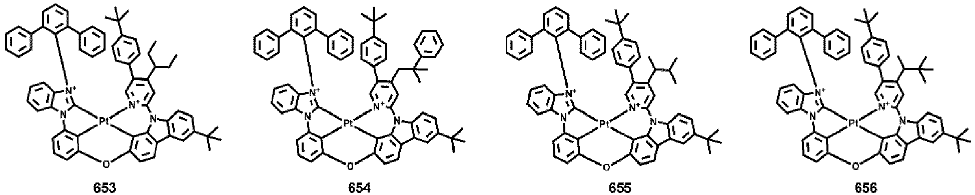

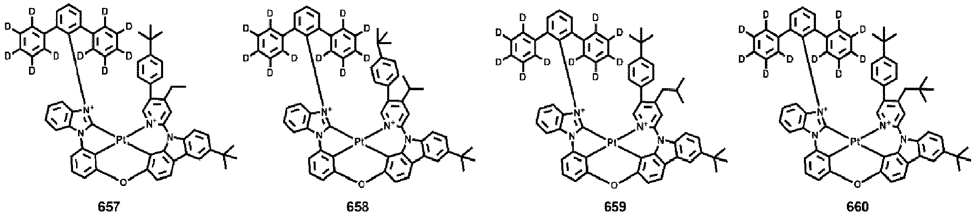

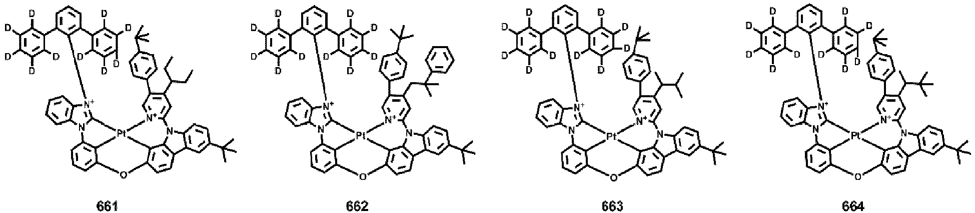

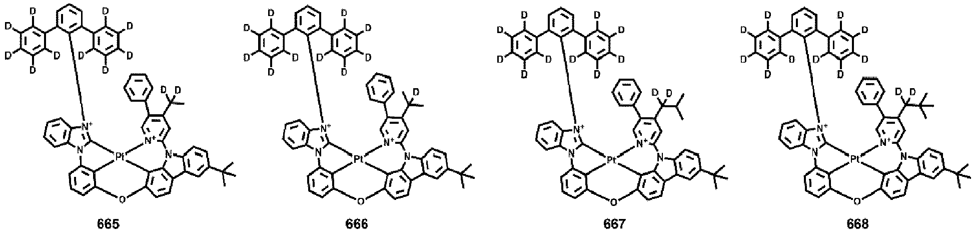

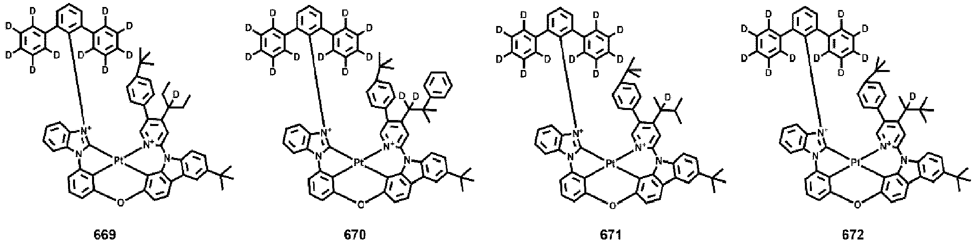

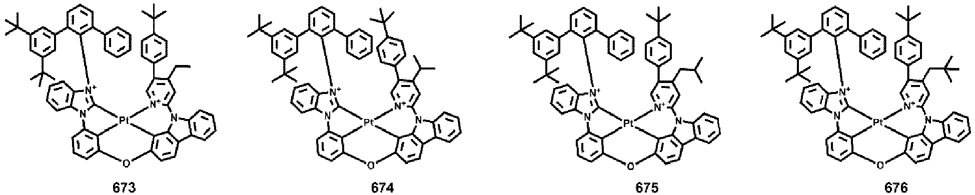

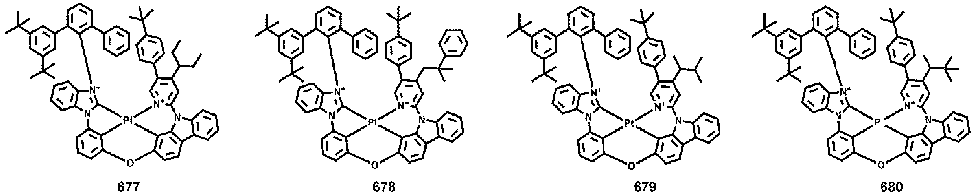

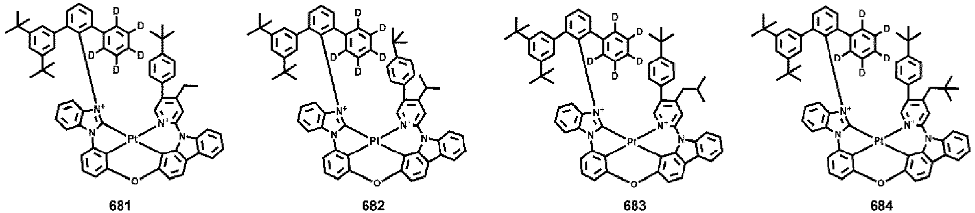

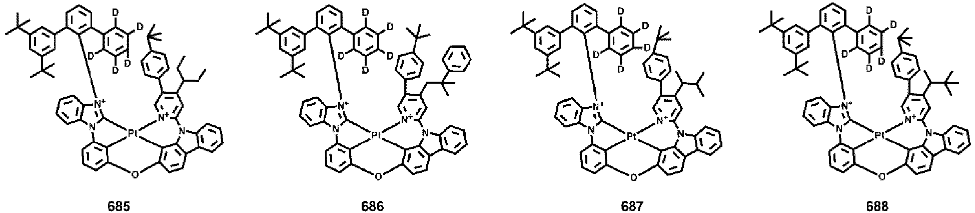

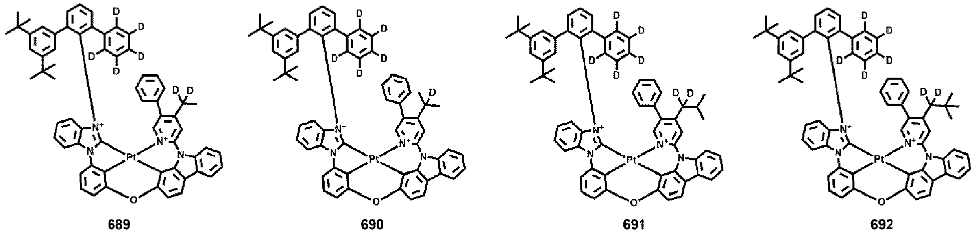

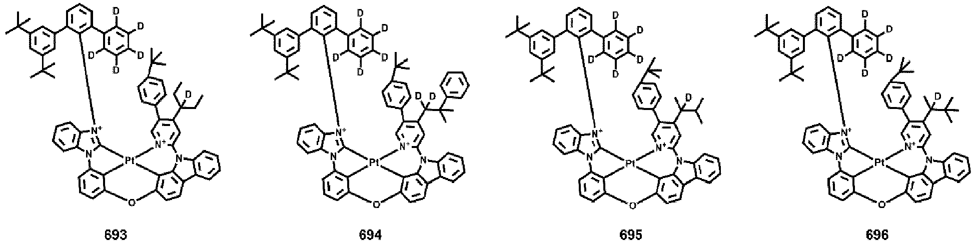

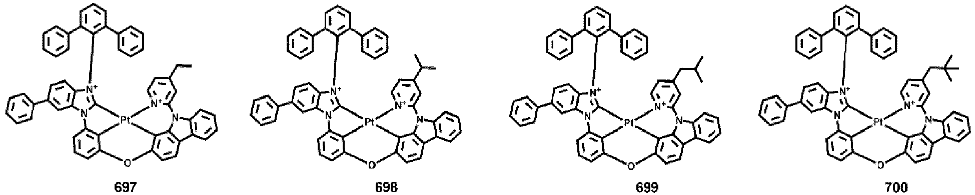

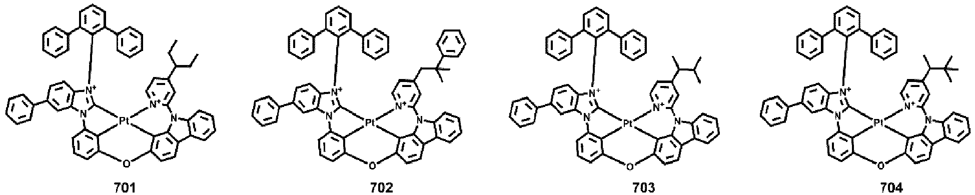

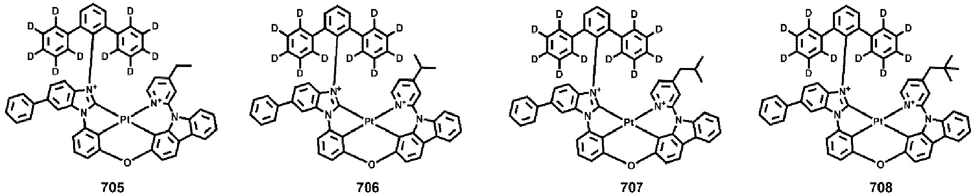

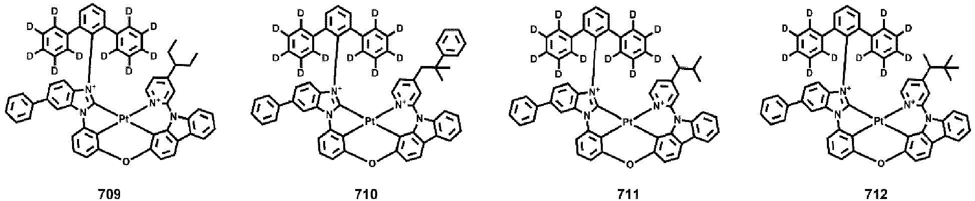

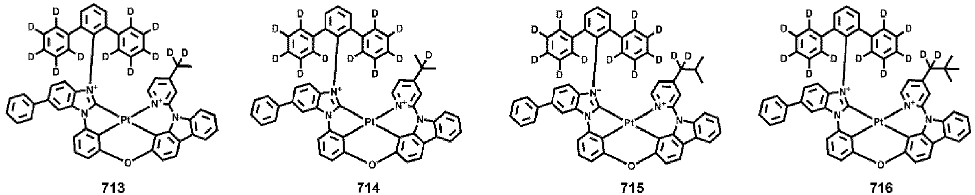

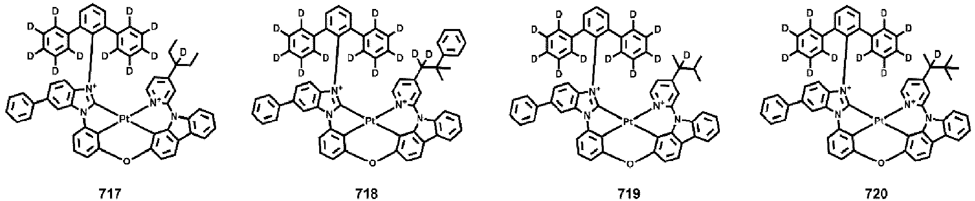

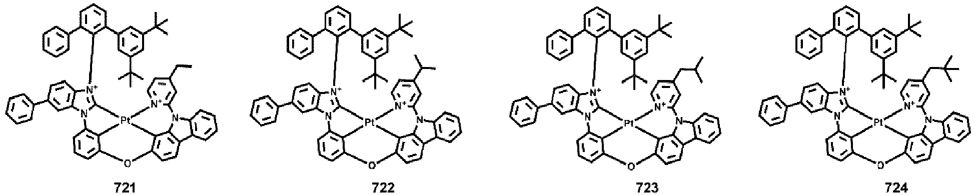

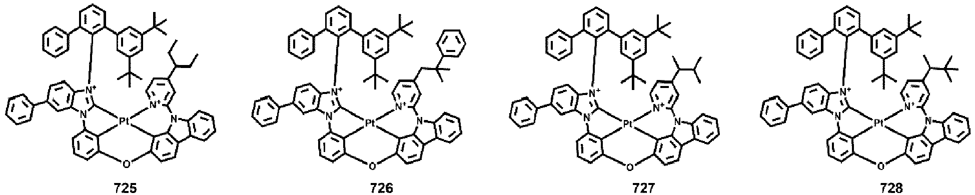

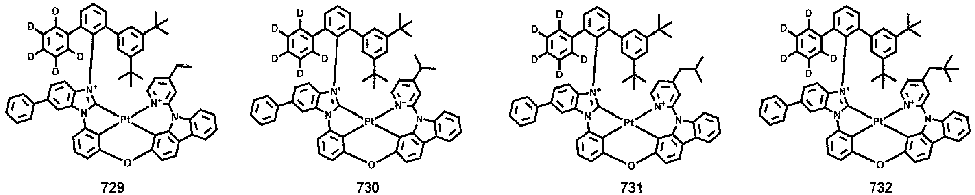

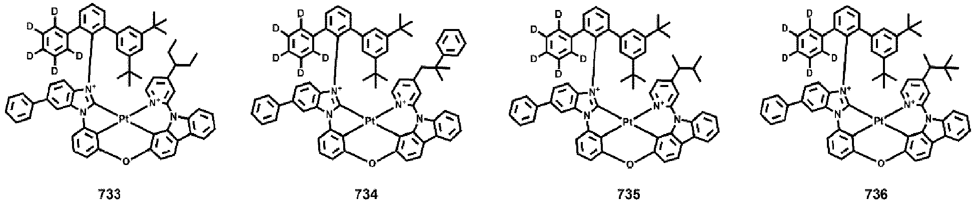

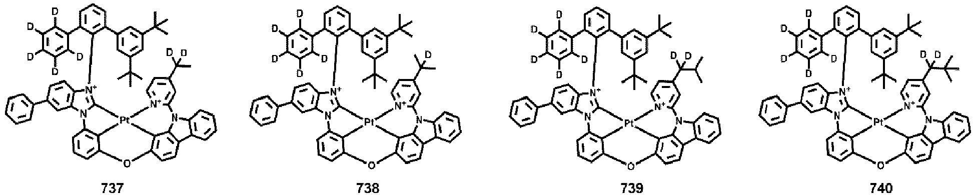

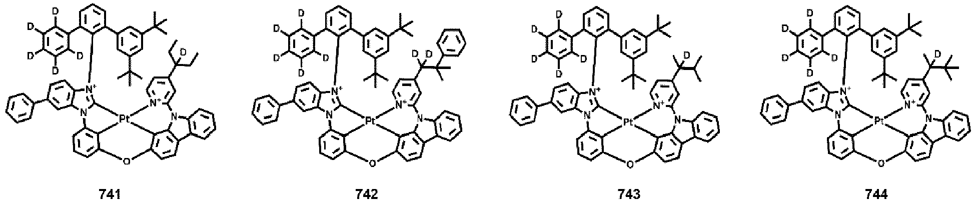

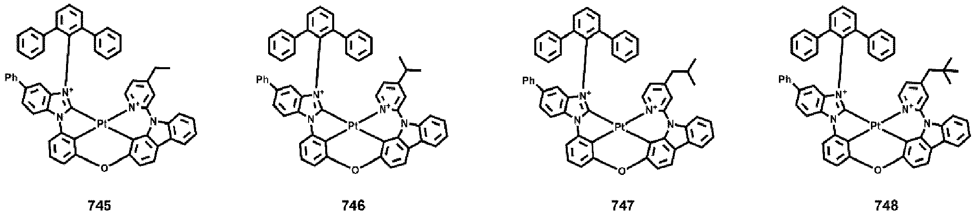

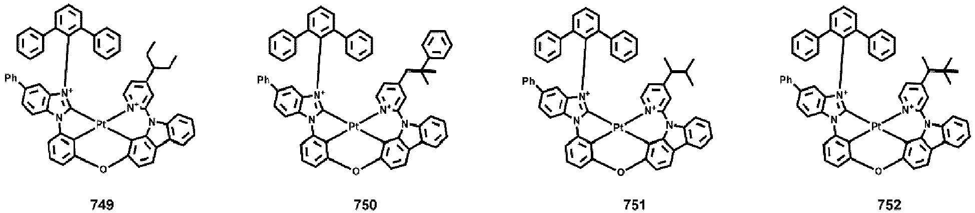

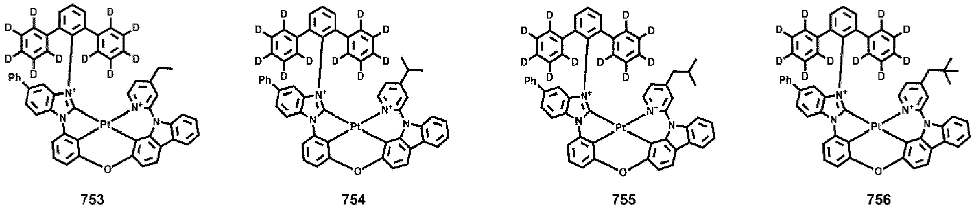

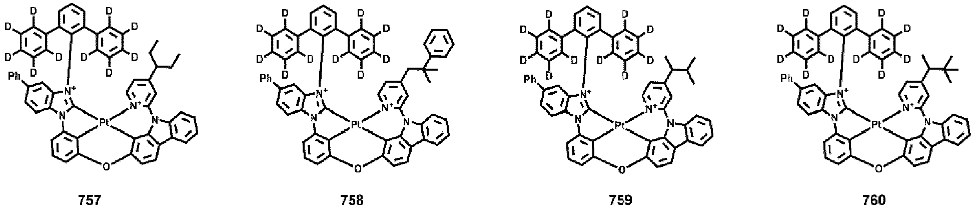

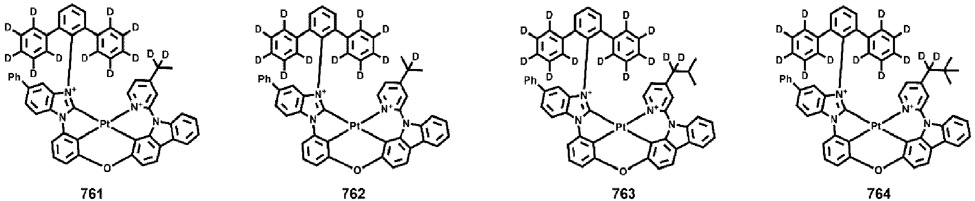

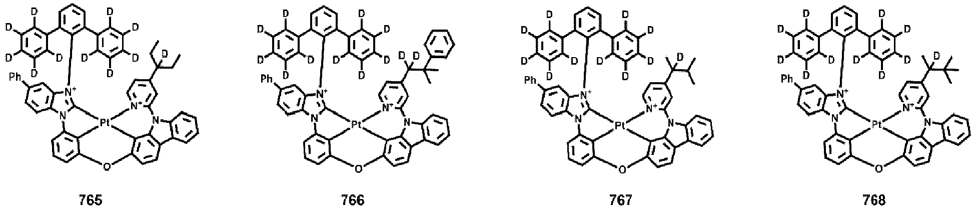

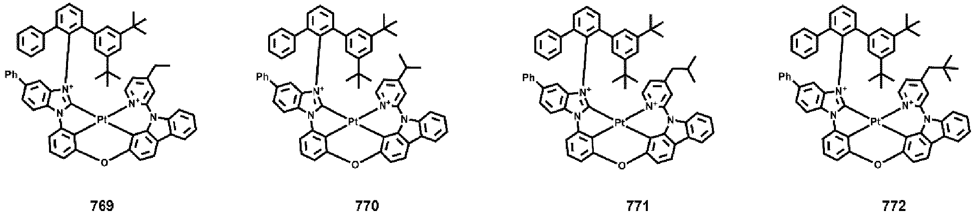

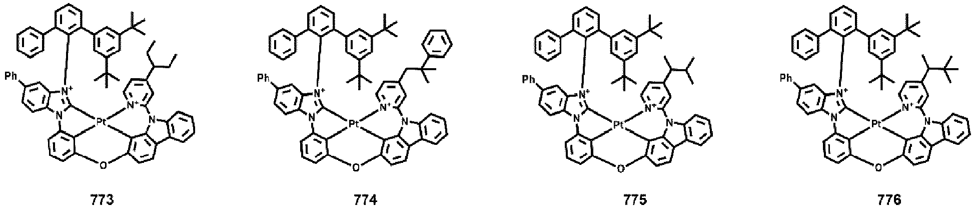

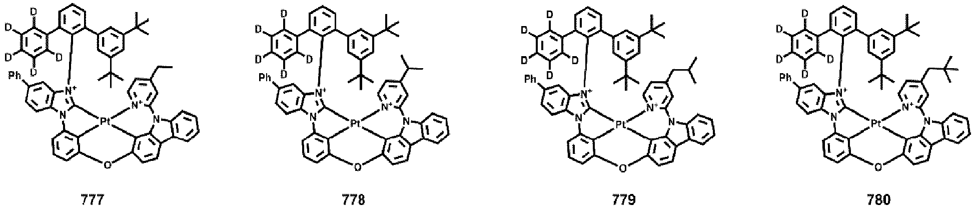

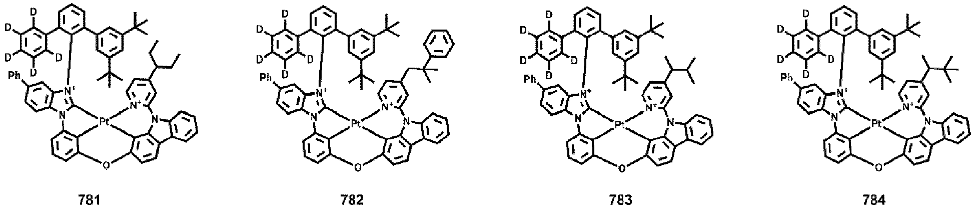

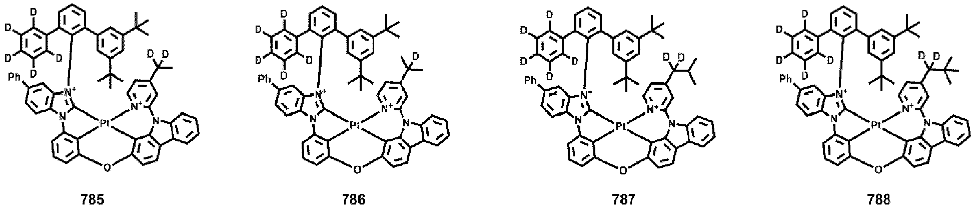

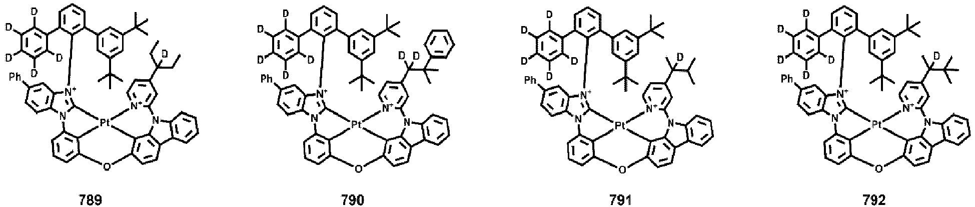

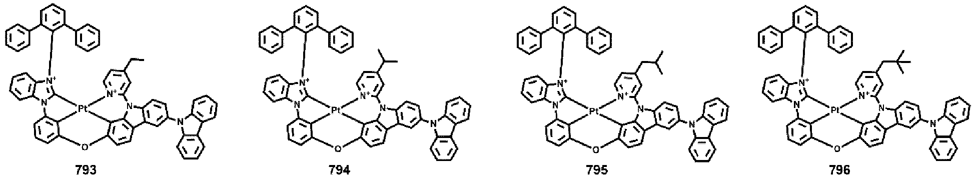

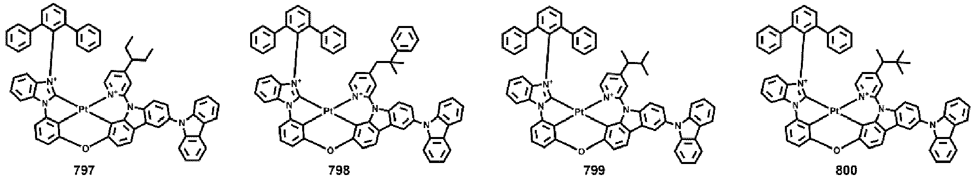

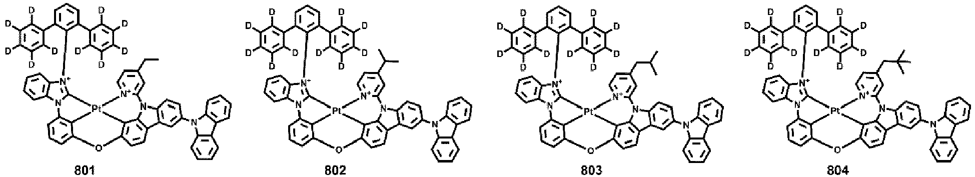

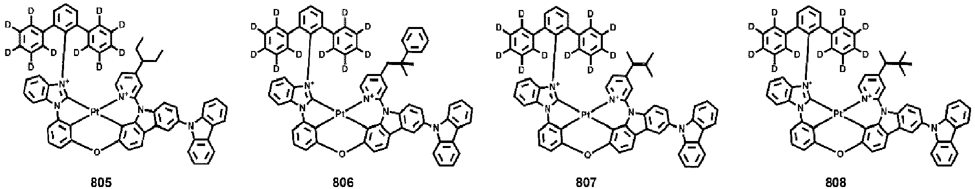

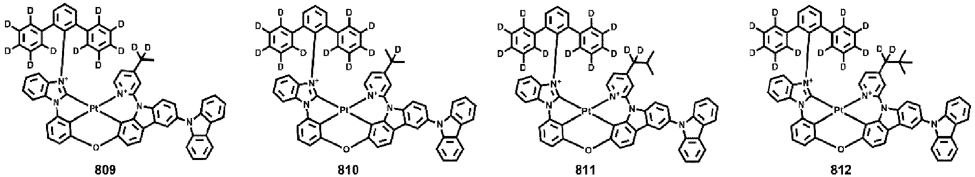

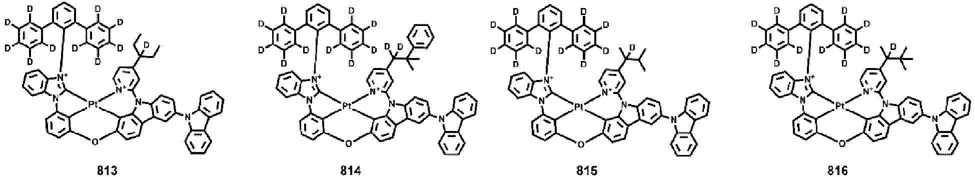

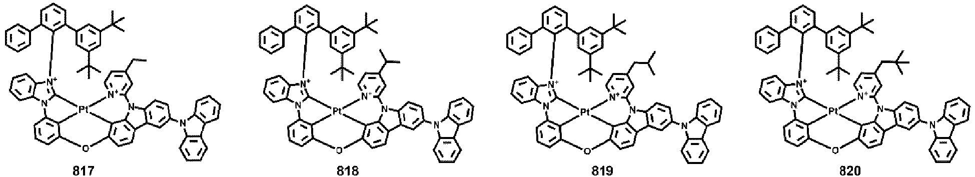

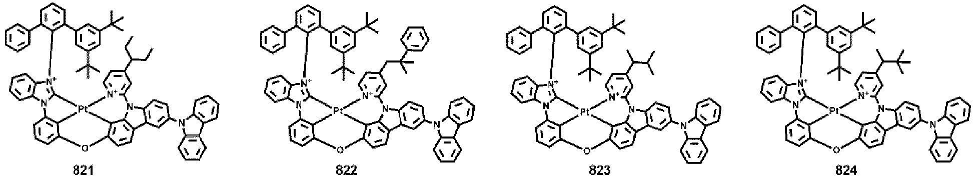

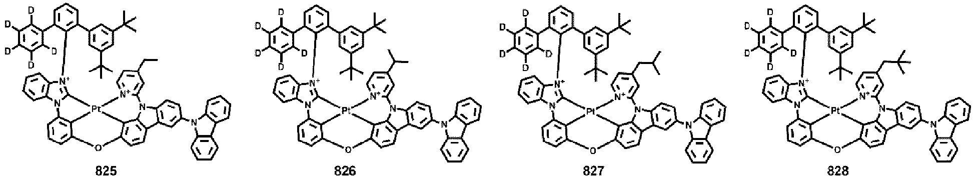

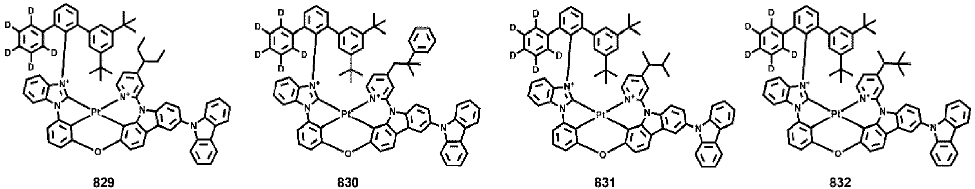

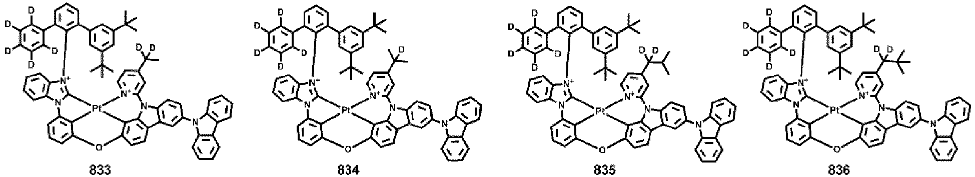

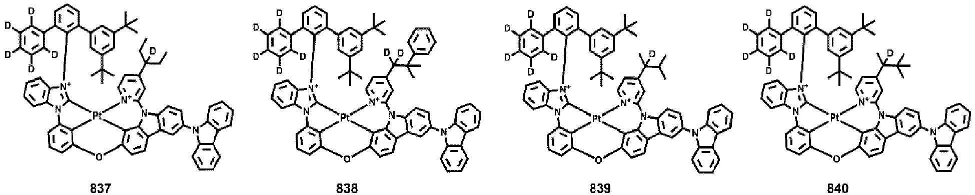

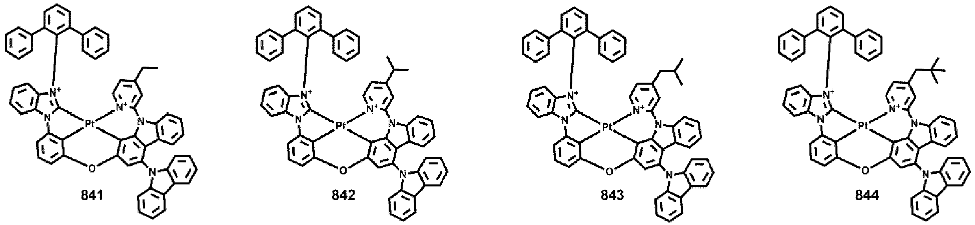

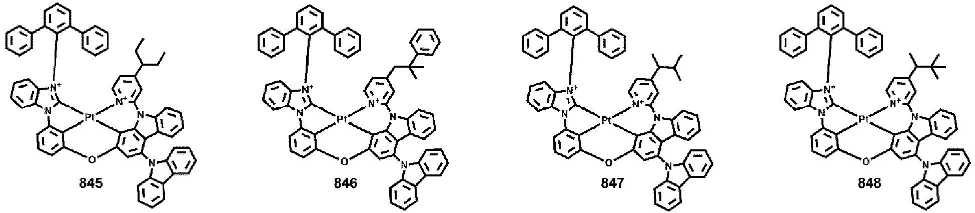

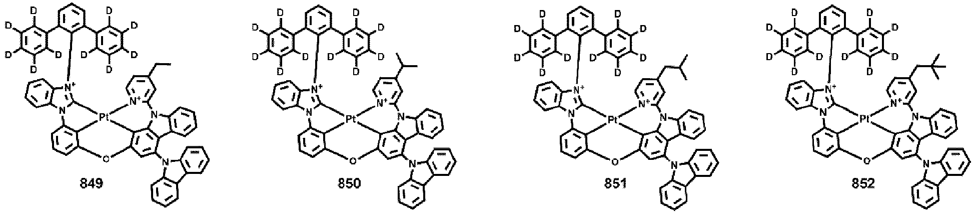

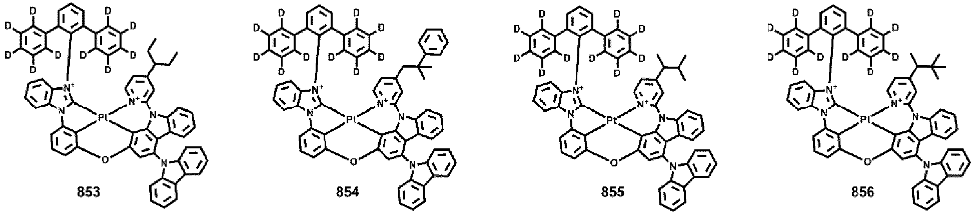

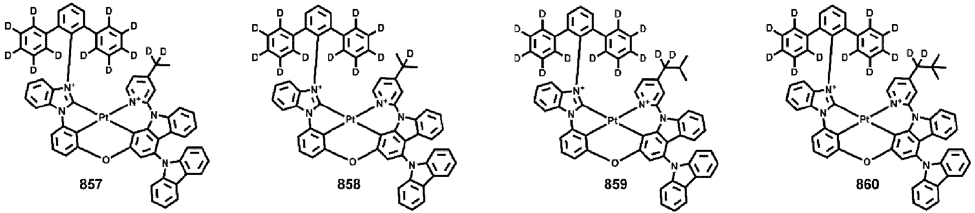

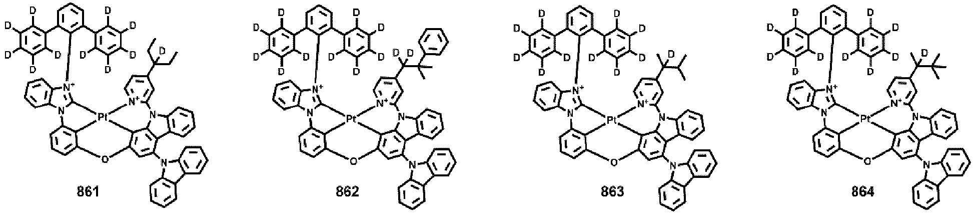

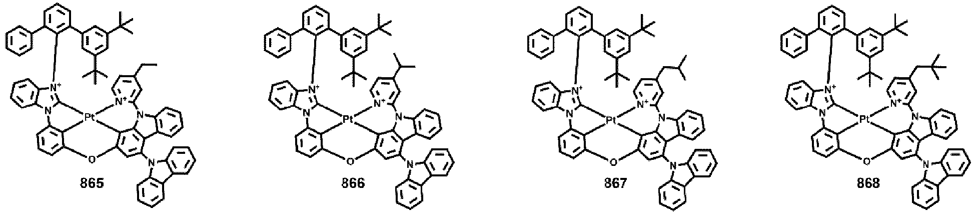

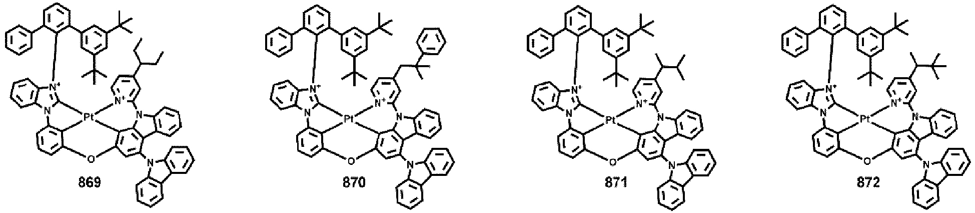

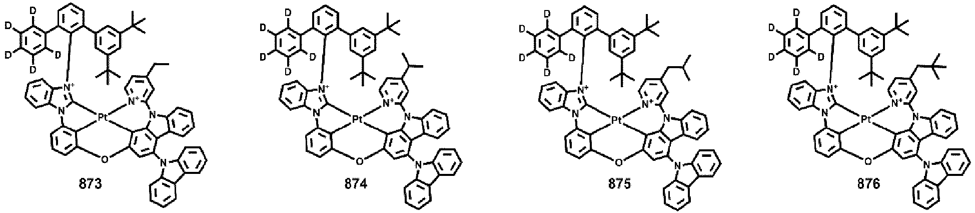

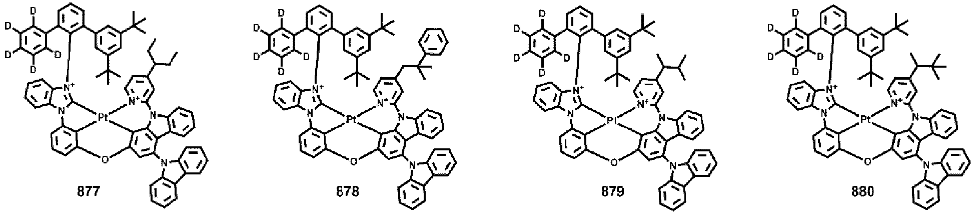

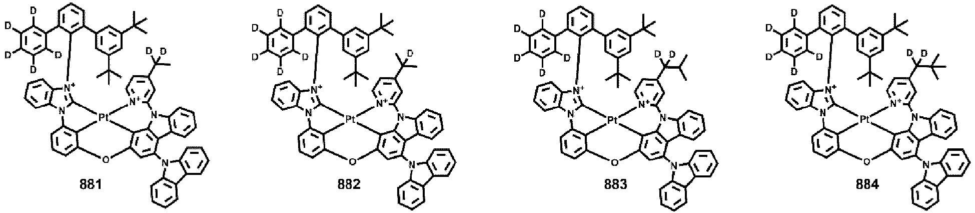

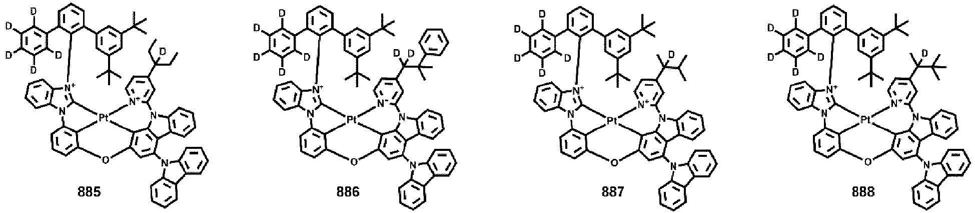

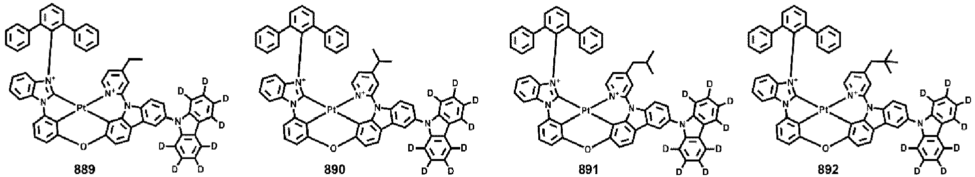

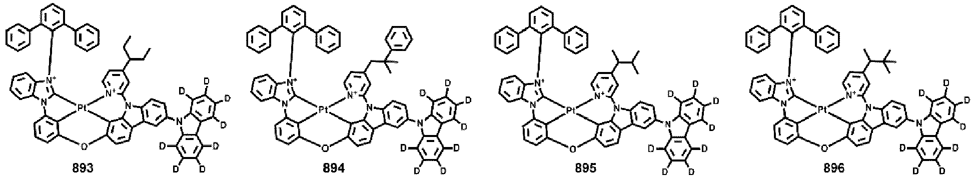

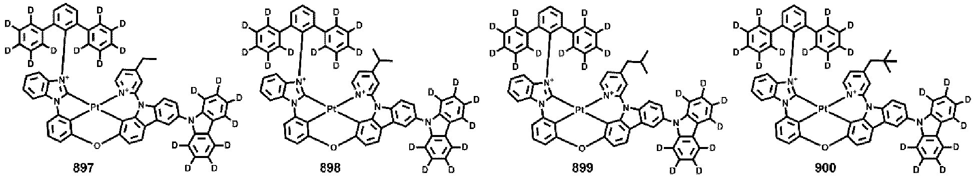

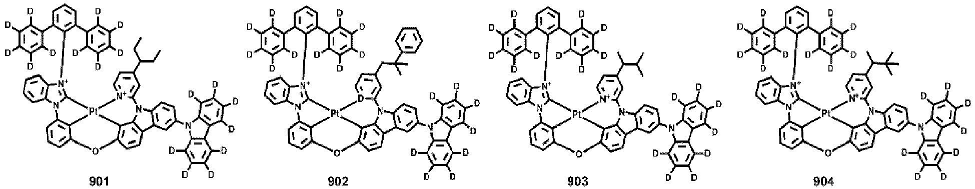

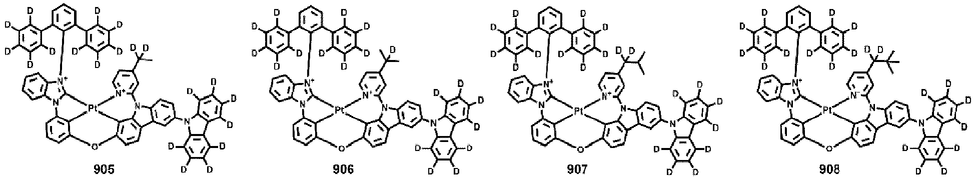

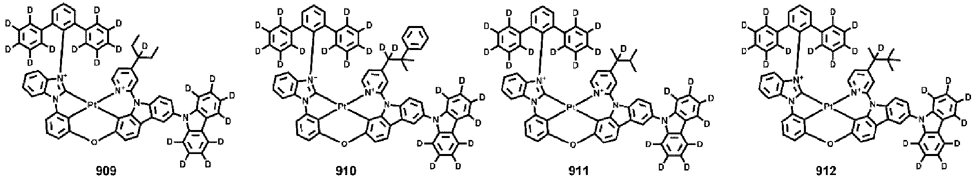

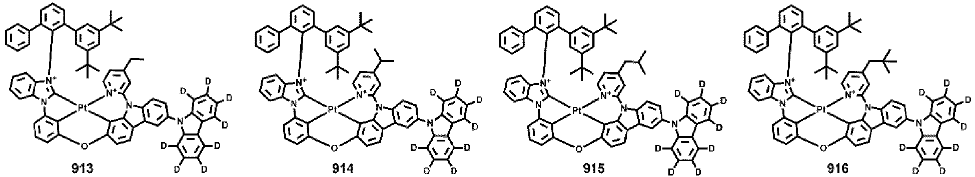

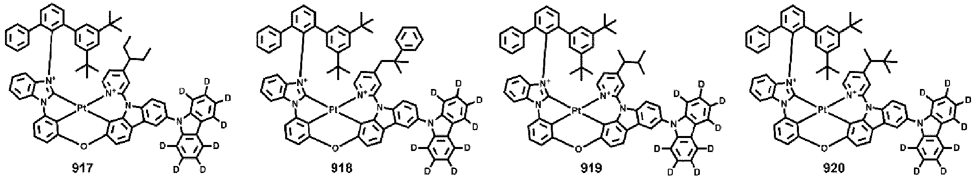

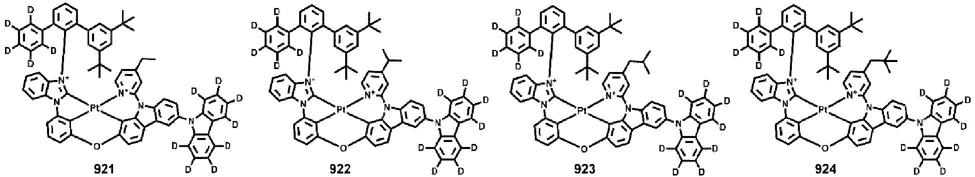

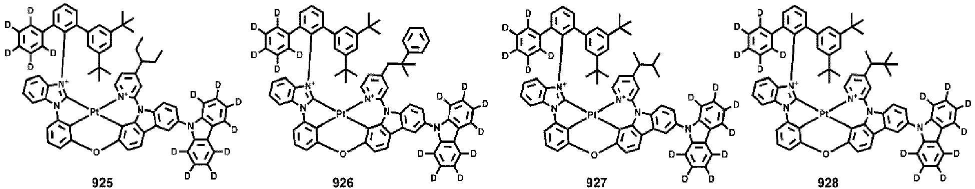

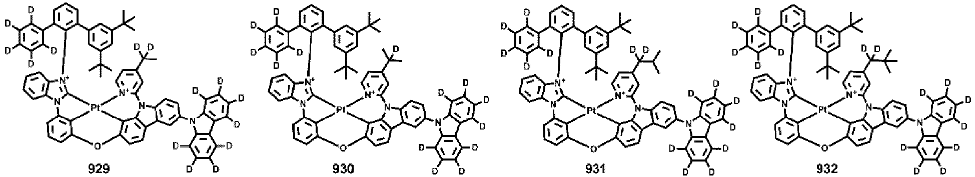

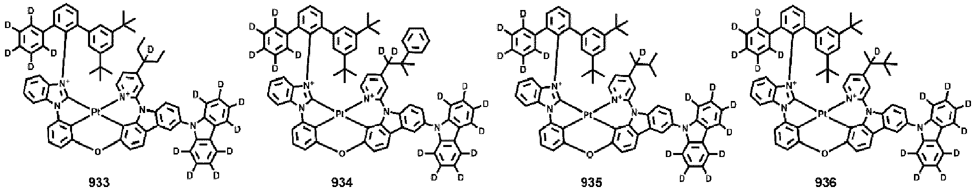

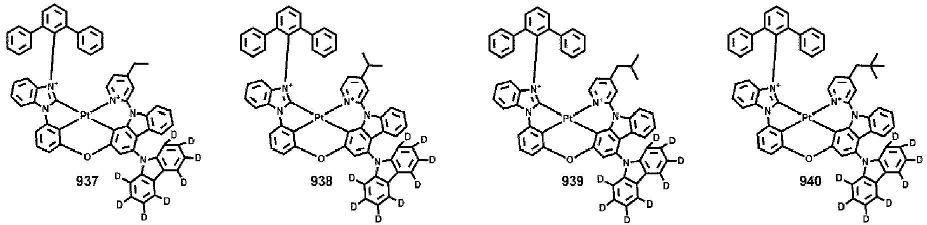

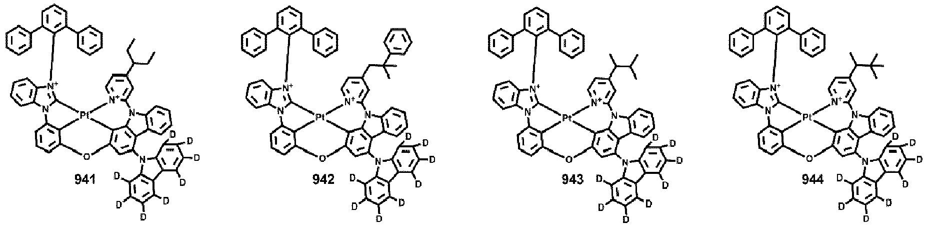

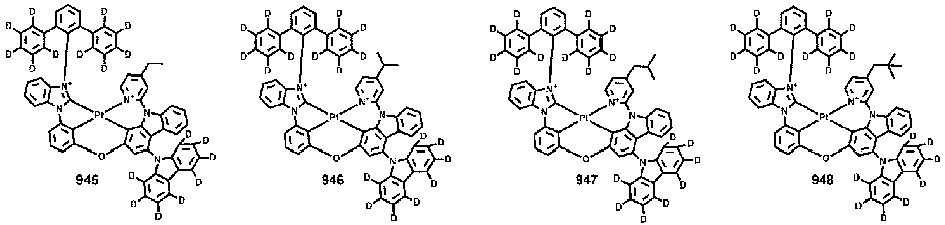

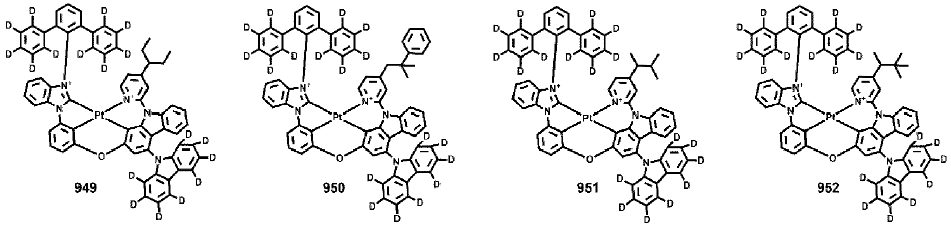

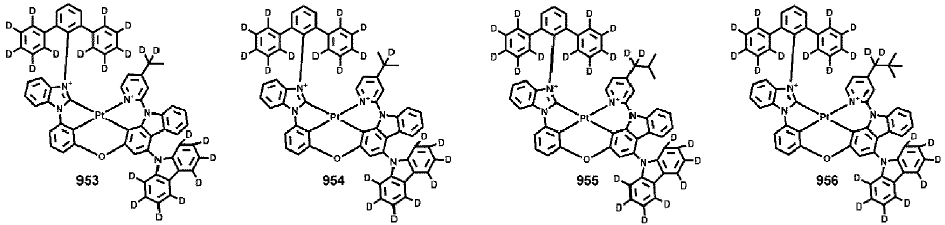

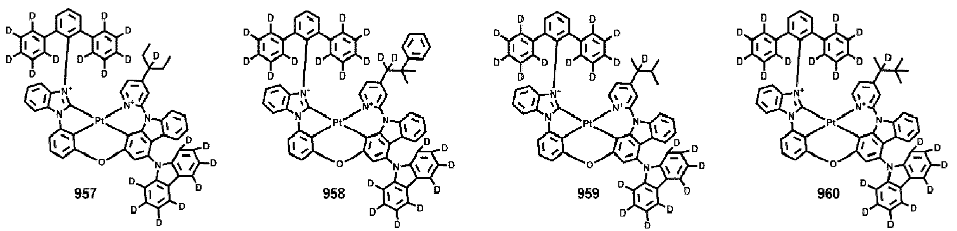

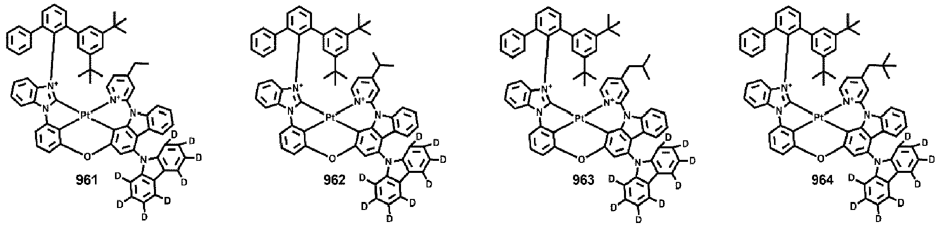

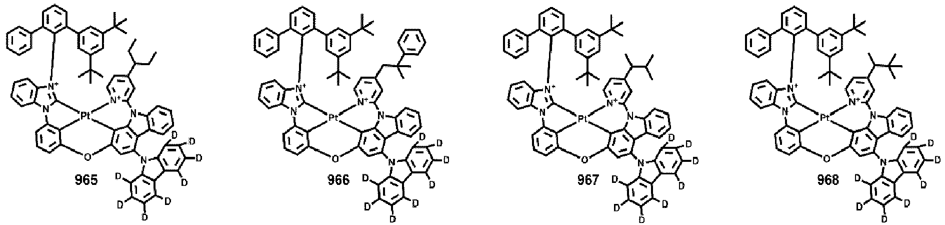

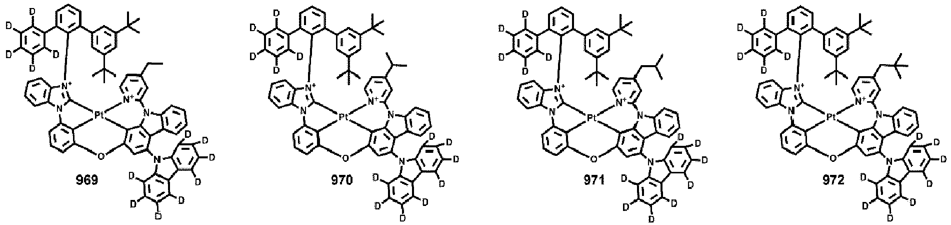

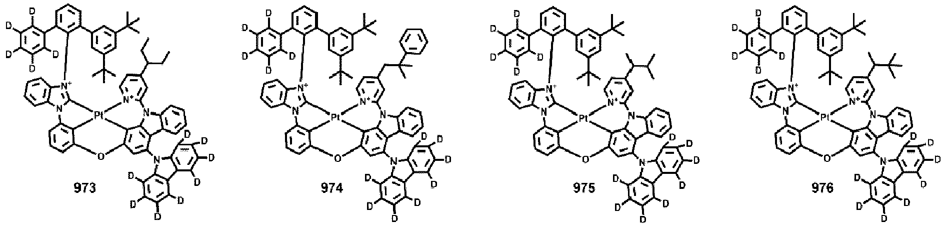

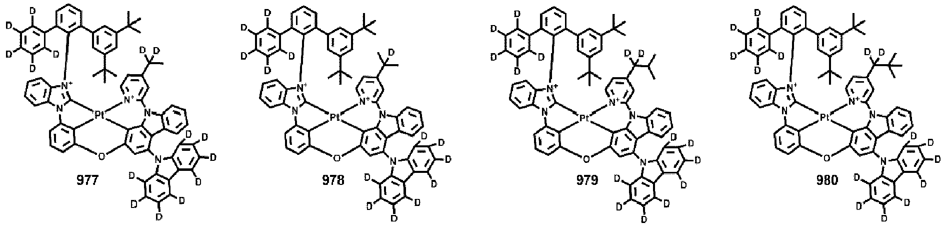

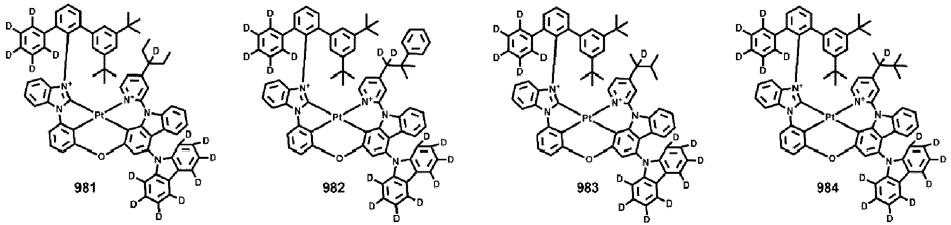

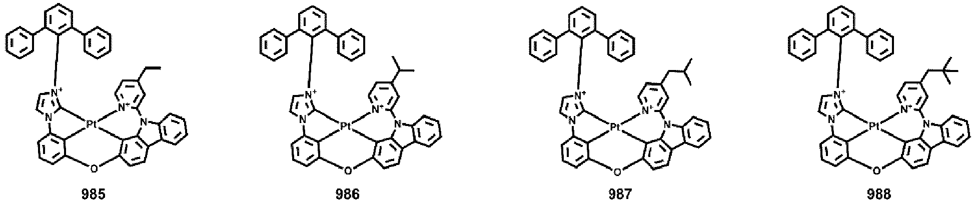

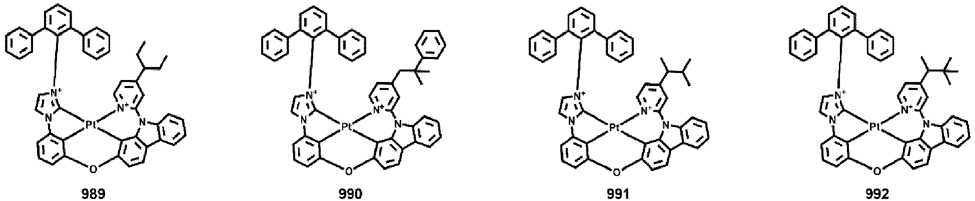

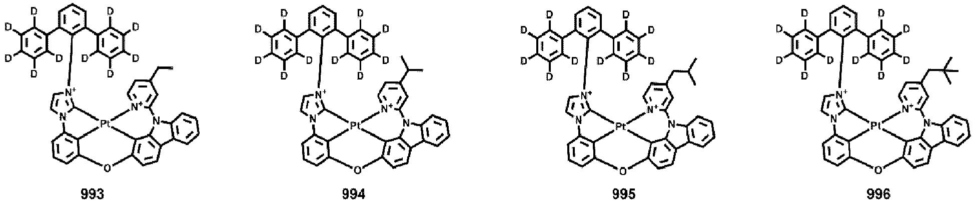

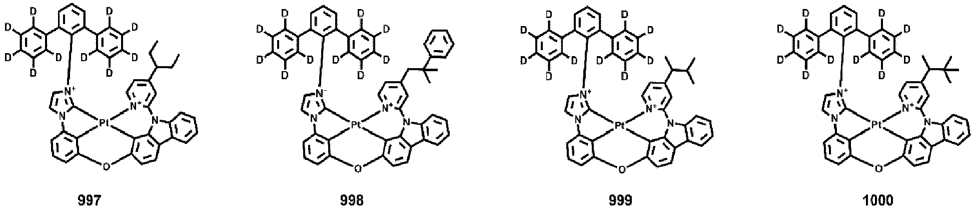

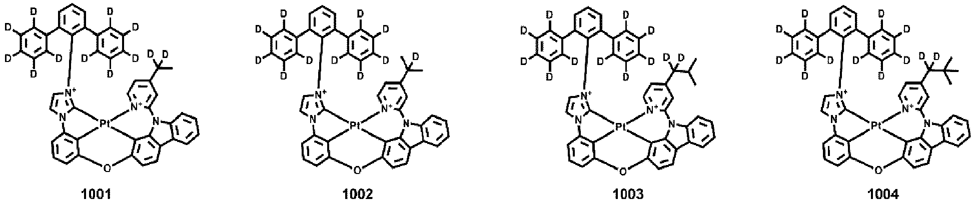

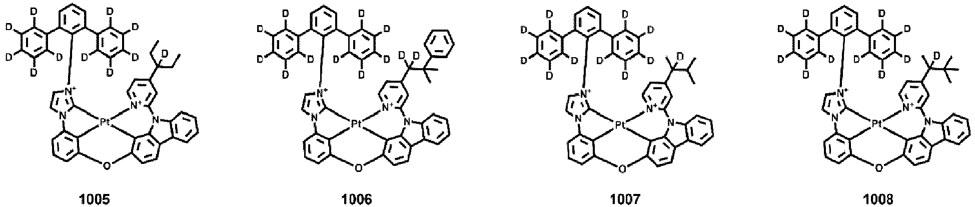

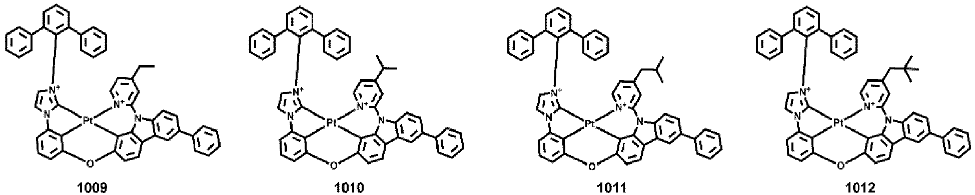

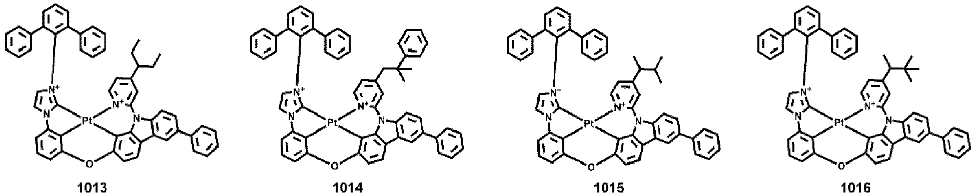

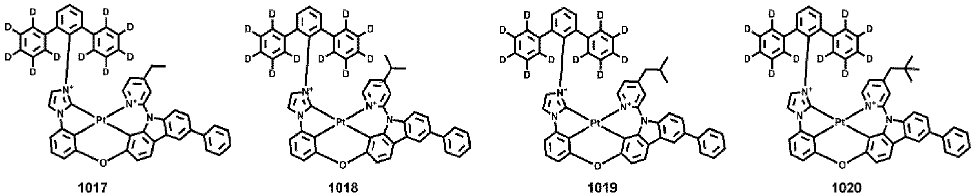

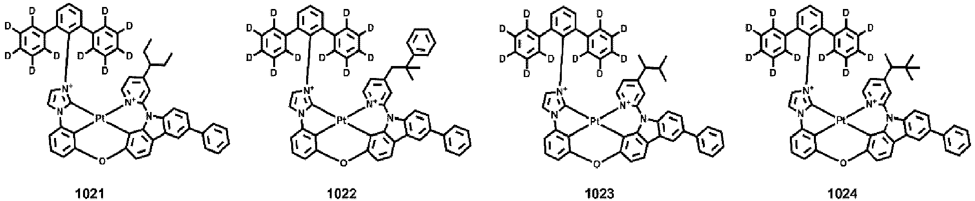

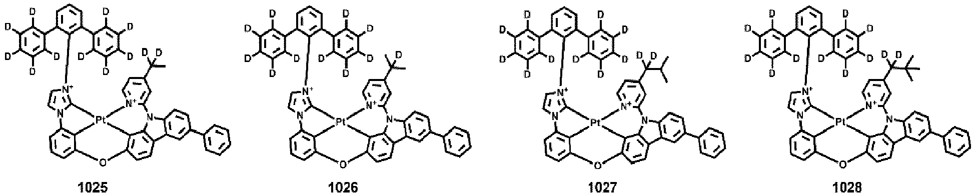

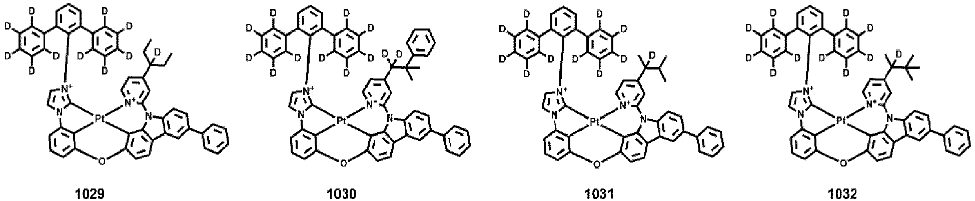

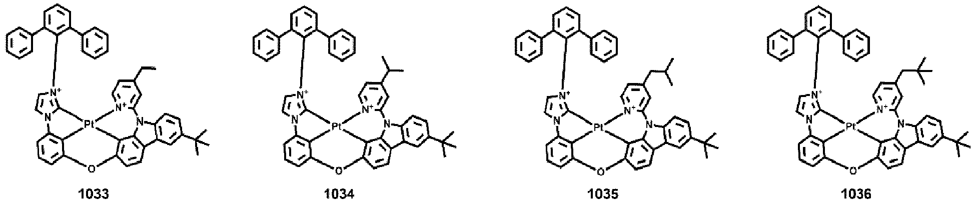

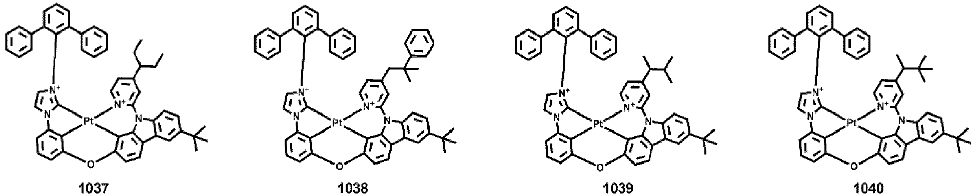

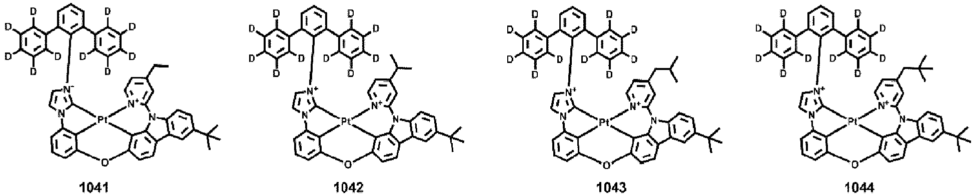

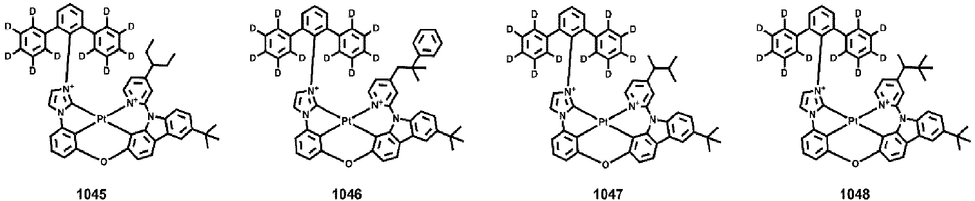

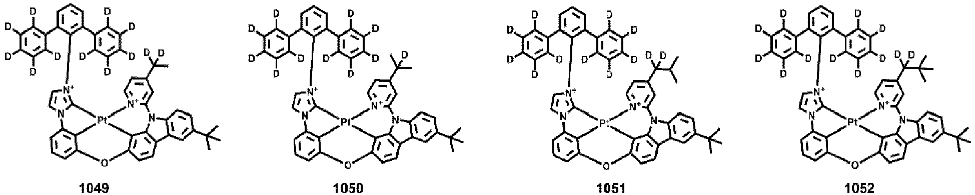

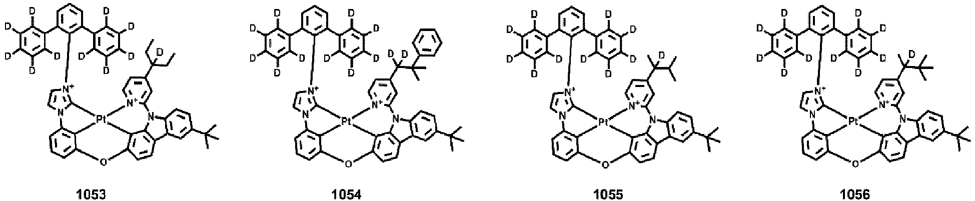

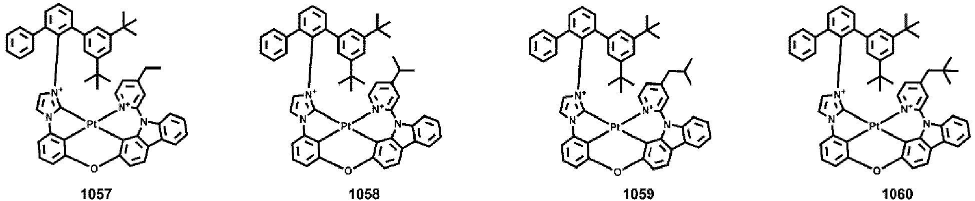

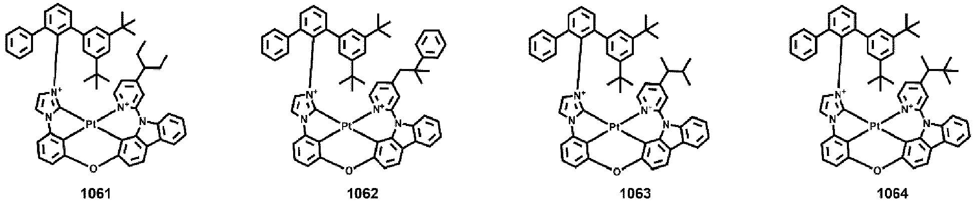

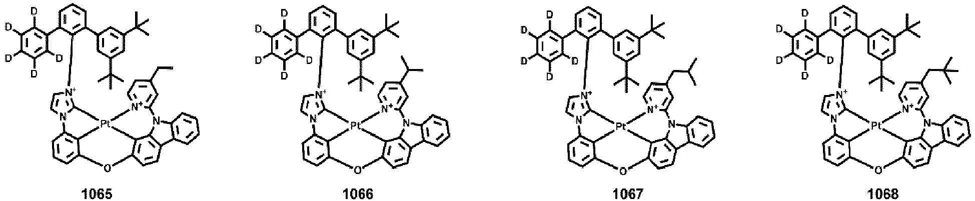

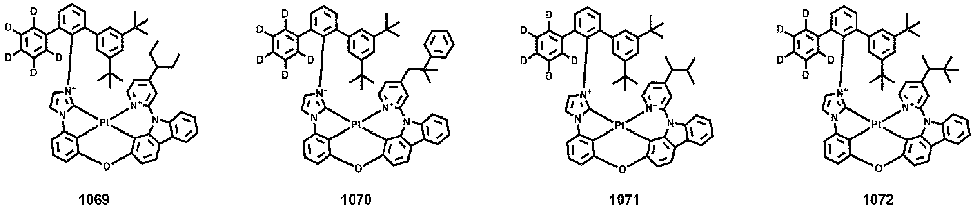

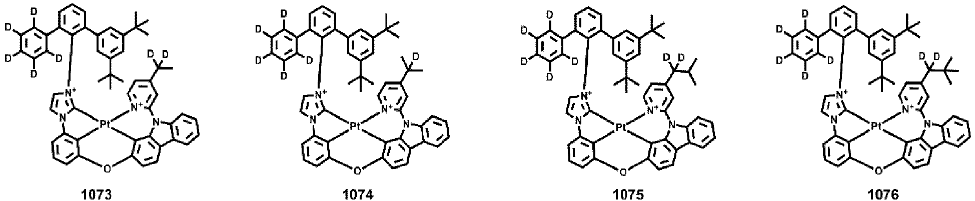

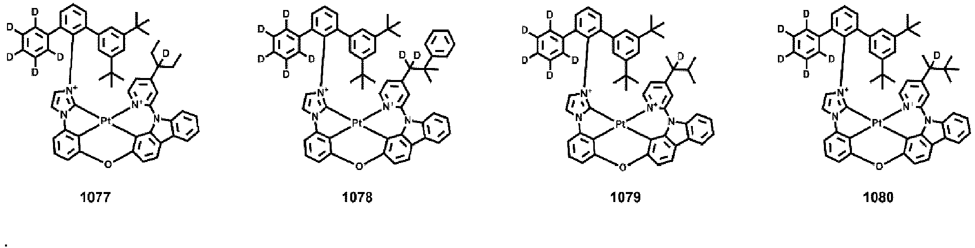

As used herein, "Me" refers to a methyl group, and "Ph" refers to a phenyl group.

Since, as described herein, Formula 1-1 and Formula 1-2 may be same as Formula 1-1' and Formula 1-2', respectively, for example, Compound 19" is same as Compound 19. Compounds 1 to 18 and 20 to 1080 are also understood in the same way.

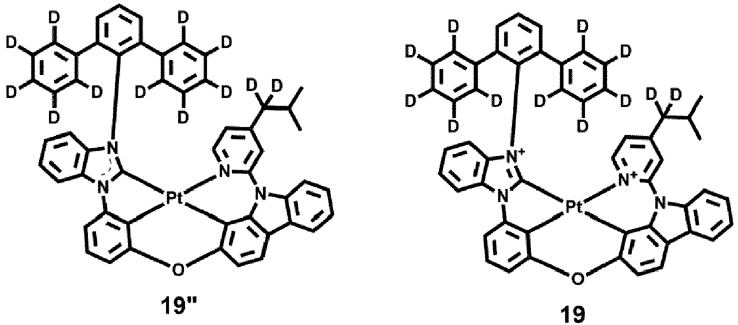

A peak wavelength (an emission peak wavelength, a maximum emission peak wavelength, or a maximum emission wavelength) of a peak having a maximum emission intensity in an emission spectrum of the organometallic compound may be about 440 nanometers (nm) to about 470 nm, about 445 nm to about 470 nm, about 450 nm to about 470 nm, about 455 nm to about 470 nm, about 460 nm to about 470 nm, about 440 nm to about 465 nm, about 445 nm to about 465 nm, about 450 nm to about 465 nm, about 455 nm to about 465 nm, or about 460 nm to about 465 nm.

An emission spectrum of the organometallic compound may further have a peak having a second highest emission intensity. A peak wavelength of a peak having the second highest emission intensity may be about 470 nm to about 510 nm, about 475 nm to about 510 nm, about 480 nm to about 510 nm, about 485 nm to about 510 nm, about 490 nm to about 510 nm, about 470 nm to about 505 nm, about 475 nm to about 505 nm, about 480 nm to about 505 nm, about 485 nm to about 505 nm, about 490 nm to about 505 nm, about 470 nm to about 500 nm, about 475 nm to about 500 nm, about 480 nm to about 500 nm, about 485 nm to about 500 nm, or about 490 nm to about 500 nm.

A FWHM of a peak having a maximum emission intensity in an emission spectrum of the organometallic compound may be about 5 nm to about 50 nm, about 5 nm to about 40 nm, about 5 nm to about 30 nm, about 5 nm to about 20 nm, about 10 nm to about 50 nm, about 10 nm to about 40 nm, about 10 nm to about 30 nm, about 10 nm to about 20 nm, about 15 nm to about 50 nm, about 15 nm to about 40 nm, about 15 nm to about 30 nm, or about 15 nm to about 20 nm.

A triplet energy of the organometallic compound may be about 2.00 eV to about 3.20 eV, about 2.00 eV to about 3.00 eV, about 2.00 eV to about 2.80 eV, about 2.50 eV to about 3.20 eV, about 2.50 eV to about 3.00 eV, or about 2.50 eV to about 2.80 eV.

Each of the organometallic compounds represented by Formulae 1-1 and 1-2 may satisfy one of Condition A and Condition B as described herein. In other words, each of the organometallic compounds represented by Formulae 1-1 and 1-2 includes at least one group represented by Formula 2.

In addition, Z₂ in Formula 2 is hydrogen or deuterium. In other words, Z₂ in Formula 2 may not include carbon. Furthermore, at least two of Z₁ to Z₃ in Formula 2 are not be linked to each other to form a ring. For example, Z₁ and Z₃ in Formula 2 are not linked to each other to form a ring, Z₂ and Z₃ in Formula 2 are not linked to each other to form a ring, and Z₁ and Z₂ in Formula 2 are not linked to each other to form a ring, and Z₁, Z₂ and Z₃ in Formula 2 are not linked to each other to form a ring. In other words, Formula 2 may not be a cyclic group.

Accordingly, carbon-carbon bond energy, that is, bond-dissociation energy (BDE), between a group represented by Formula 2 in the organometallic compounds represented by Formulae 1-1 and 1-2 and carbon to which the group represented by Formula 2 is bonded may be increased, intermolecular bonds are strengthened, and orientation characteristics may be improved. In addition, the introduction of Formula 2 does not change the conjugation length of the organometallic compounds represented by Formulae 1-1 and 1-2, and thus substantially does not affect emission spectrum characteristics of the organometallic compounds represented by Formulae 1-1 and 1-2. Therefore, the organometallic compounds represented by Formulae 1-1 and 1-2 may emit a blue light of high purity and simultaneously have excellent electrical stability and excellent thermal stability. Thus, an electronic device, for example, an organic light-emitting device, including at least one of the organometallic compounds represented by Formulae 1-1 and 1-2 may have excellent emission efficiency and excellent lifespan characteristics, and simultaneously emit a blue light of high color purity.

Highest occupied molecular orbital (HOMO) energy levels, lowest unoccupied molecular orbital (LUMO) energy levels, triplet (T₁) energy levels, emission peak wavelengths (maximum emission peak wavelengths, PLₘₐₓ, nm), S₀ BDE (kilocalories per mole, kcal/mol), and T₁ BDE (kcal/mol) of Compounds Y, Z, 3, and 4 were calculated using a density functional theory (DFT) method of the Gaussian 09 program with the molecular structure optimized at the B3LYP level, and results thereof are shown in Table 1. The energy levels are expressed in electron volts (eV). S₀ BDE and T₁ BDE are evaluations of BDE for a carbon-carbon bond marked by an "oval" in Compounds Z, 3, and 4, as shown below.

**Table 1**

| Compound No. | HOMO (eV) | LUMO (eV) | T₁ (eV) | PLₘₐₓ (nm) | S₀ BDE (kcal/mol) | T₁ BDE (kcal/mol) |
|---|---|---|---|---|---|---|
| Y | -4.68 | -1.29 | 2.62 | 467 | - | - |
| Z | -4.63 | -1.23 | 2.63 | 465 | 68.7 | 10.2 |
| 3 | -4.64 | -1.25 | 2.63 | 464 | 79.6 | 21.1 |
| 4 | -4.64 | -1.25 | 2.63 | 465 | 78.0 | 19.6 |

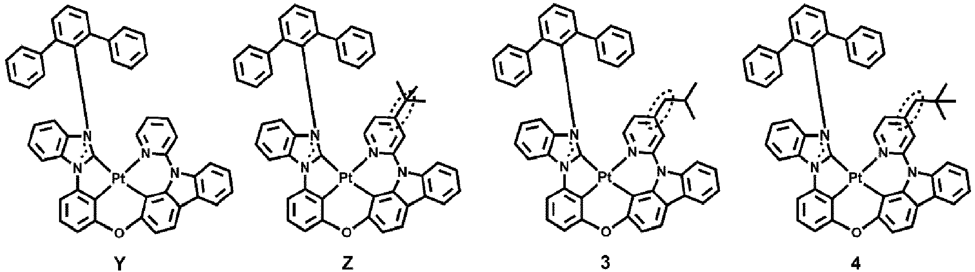

From Table 1, it was found that each of the organometallic compounds represented by Formulae 1-1 and 1-2 had excellent BDE.

A synthesis method of each of the organometallic compounds represented by Formulae 1-1 and 1-2 may be recognized by those skilled in the art and with reference to the Synthesis Examples described herein.

Therefore, each of the organometallic compounds represented by Formulae 1-1 and 1-2 is suitable for use as a material for an organic layer of an organic light-emitting device, for example, a material in an emission layer of the organic layer. Thus, according to one or more embodiments, there is provided an organic light-emitting device including a first electrode; a second electrode; and an organic layer located between the first electrode and the second electrode, wherein the organic layer includes an emission layer, and wherein the organic layer further includes at least one organometallic compound represented by Formula 1-1 or 1-2.

Since the organic light-emitting device has the organic layer including the at least one organometallic compound represented by Formula 1-1 or 1-2 as described herein, the organic light-emitting device may have excellent driving voltage, excellent external quantum efficiency, a relatively narrow full width at half maximum (FWHM) of an emission peak of an electroluminescence (EL) spectrum, and/or excellent lifespan characteristics.

The organometallic compound represented by Formula 1-1 or 1-2 may be used between a pair of electrodes of the organic light-emitting device. For example, the organometallic compound represented by Formula 1-1 or 1-2 may be included in the emission layer. The emission layer may further include a host. An amount of the host in the emission layer may be greater than an amount of the at least one of the organometallic compounds in the emission layer, based on weight. The emission layer may emit a red light, a green light, and/or a blue light. For example, the organometallic compound may emit a blue light.

In one or more embodiments, a CIEy coordinate of light emitted from the emission layer may be about 0.040 to about 0.170, about 0.050 to about 0.170, about 0.060 to about 0.170, about 0.040 to about 0.165, about 0.050 to about 0.165, or about 0.060 to about 0.165.

In one or more embodiments, a CIEy coordinate of light emitted from the emission layer including the organometallic compound represented by Formula 1-1 or 1-2 as an emitter may be about 0.130 to about 0.170, about 0.135 to about 0.170, about 0.140 to about 0.170, about 0.145 to about 0.170, about 0.150 to about 0.170, about 0.130 to about 0.165, about 0.135 to about 0.165, about 0.140 to about 0.165, about 0.145 to about 0.165, or about 0.150 to about 0.165.

In one or more embodiments, a CIEy coordinate of light emitted from the emission layer including the organometallic compound represented by Formula 1-1 or 1-2 as a sensitizer may be about 0.070 to about 0.140, about 0.080 to about 0.140, about 0.090 to about 0.140, about 0.070 to about 0.135, about 0.080 to about 0.135, about 0.090 to about 0.135, about 0.070 to about 0.130, about 0.080 to about 0.130, about 0.090 to about 0.130, about 0.070 to about 0.125, about 0.080 to about 0.125, about 0.090 to about 0.125, about 0.070 to about 0.120, about 0.080 to about 0.120, about 0.090 to about 0.120, about 0.070 to about 0.115, about 0.080 to about 0.115, or about 0.090 to about 0.115.

In one or more embodiments, a maximum emission peak wavelength of light emitted from an emission layer may be about 440 nm to about 470 nm, about 445 nm to about 470 nm, about 450 nm to about 470 nm, about 455 nm to about 470 nm, about 460 nm to about 470 nm, about 440 nm to about 465 nm, about 445 nm to about 465 nm, about 450 nm to about 465 nm, about 455 nm to about 465 nm, or about 460 nm to about 465 nm.

The emission layer may further include a host. The host may be as described herein.

For example, the emission layer may include a first Embodiment or a second Embodiment:

### First Embodiment of Emission Layer

The emission layer may include at least one of the organometallic compounds represented by Formula 1-1 or 1-2, and the organometallic compound may act as an emitter, for example, a phosphorescent emitter. In other words, the organometallic compound may be an emitter. For example, of the total emission components of the emission layer, emission components emitted from the organometallic compound may account for at least about 80%, at least about 85%, at least about 90%, or at least about 95% of a total light emitted by the emission layer. The light emitted from the organometallic compound may be a blue light.

### Second Embodiment of Emission Layer

The emission layer may include, at least one of the organometallic compounds represented by Formulae 1-1 or 1-2, and, in addition, the emission layer may further include a phosphorescent dopant, a fluorescent dopant, or a combination thereof, which is different from the organometallic compound. In this regard, the organometallic compound may serve, not as a phosphorescence emitter, but as a sensitizer or an auxiliary dopant. For example, the organometallic compound may be a sensitizer. As another example, the emission layer may further include a fluorescent compound, and the fluorescent compound may be different from the organometallic compound. Of the total emission components of the emission layer, emission components emitted from the fluorescent compound may account for at least about 80%, at least about 85%, at least about 90%, or at least about 95% of a total light emitted from the emission layer. The fluorescent compound may be an emitter. The light emitted from the fluorescent compound may be a blue light.

In the second embodiment of the emission layer, an amount of the fluorescent compound may be about 1 parts by weight to about 100 parts by weight, about 5 parts by weight to about 50 parts by weight, or about 10 parts by weight to about 20 parts by weight, based on 100 parts by weight of the at least one organometallic compounds represented by Formula 1-1 or 1-2.

In the second embodiment of the emission layer, a total amount of the at least one organometallic compounds represented by Formula 1-1 or 1-2 and the fluorescent compound may be about 1 parts by weight to about 30 parts by weight, about 3 parts by weight to about 20 parts by weight, or about 5 parts by weight to about 15 parts by weight, based on 100 parts by weight of the emission layer.

The fluorescent compound that may be used in the second embodiment of the emission layer may not include a transition metal.

In one or more embodiments, the fluorescent compound that may be used in the second embodiment of the emission layer may be a fluorescence emitting material without a cyano group (-CN) and a fluoro group (-F).

In one or more embodiments, the fluorescent compound may include a prompt (nondelayed) type fluorescence compound, a thermally activated delayed fluorescence (TADF) compound, or a combination thereof.

In one or more embodiments, the fluorescent dopant that may be used in the second embodiment may be a condensed ring-containing compound, an amino group-containing compound, a styryl group-containing compound, or a boron-containing compound.

In one or more embodiments, the fluorescent compound that may be used in the second embodiment may include an amino group, or may include a 6-membered ring including at least one nitrogen atom and at least one boron atom.

In one or more embodiments, the fluorescent compound that may be used in the second embodiment of the emission layer may include an amino group-containing compound.

In one or more embodiments, the fluorescent compound that may be used in the second embodiment of the emission layer may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group (tetracene group), a picene group, a perylene group, a pentaphene group, an indenoanthracene group, a group represented by one of Formulae 501-1 to 501-21, or a combination thereof, but embodiments are not limited thereto:

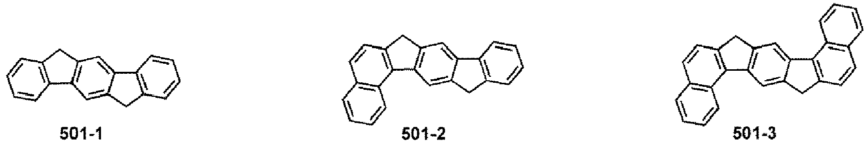

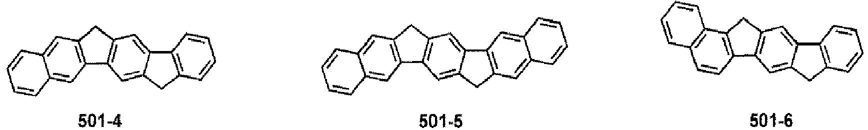

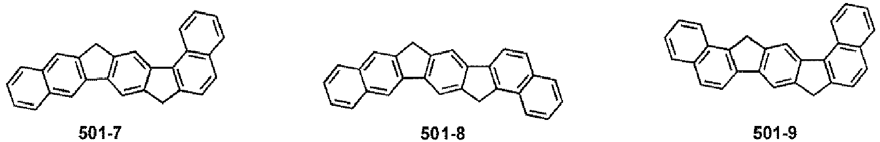

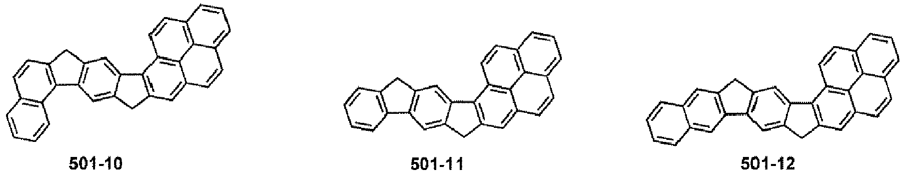

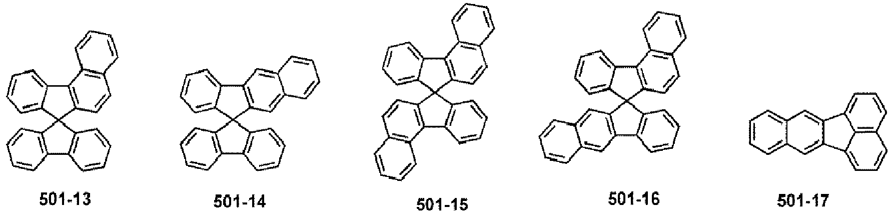

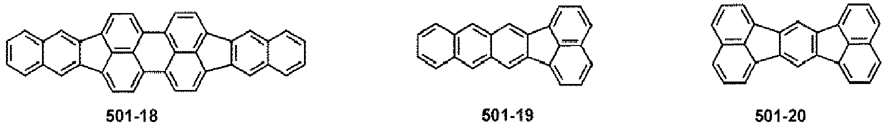

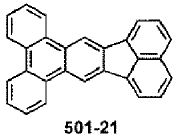

In one or more embodiments, the fluorescent compound that may be used in the second embodiment of the emission layer may include a compound represented by Formula 501A or 501B, but embodiments are not limited thereto: 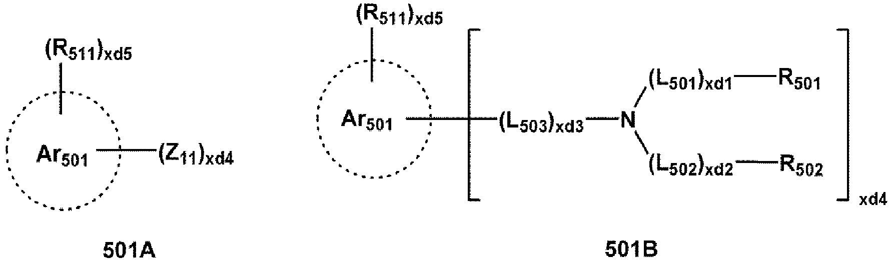 wherein, in Formulae 501A and 501B,
Ar₅₀₁ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, or a group represented by one of Formulae 501-1 to 501-21,
R₅₁₁ may be hydrogen, deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or -Si(Q₅₀₁)(Q₅₀₂)(Q₅₀₃),
xd5 may be an integer from 0 to 10,
L₅₀₁ to L₅₀₃ may each independently be:
   a single bond; or
   a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, or a divalent non-aromatic condensed heteropolycyclic group, each unsubstituted or substituted with at least one of deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   xd1 to xd3 may each independently be 1, 2, or 3,
   R₅₀₁ and R₅₀₂ may each independently be a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a dibenzosilolyl group, each unsubstituted or substituted with at least one of deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   Z₁₁ may be a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   xd4 may be 1, 2, 3, 4, 5, or 6, and
   Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group.

In one or more embodiments, the fluorescent compound may include the compound represented by Formula 501A or 501B, wherein xd4 in Formula 501A may be 1, 2, 3, 4, 5, or 6, and xd4 in Formula 501B may be 2, 3, or 4.

In one or more embodiments, the fluorescent compound that may be used in the second embodiment of the emission layer may include a compound represented by Formula 503-1 or 503-2, but embodiments are not limited thereto: 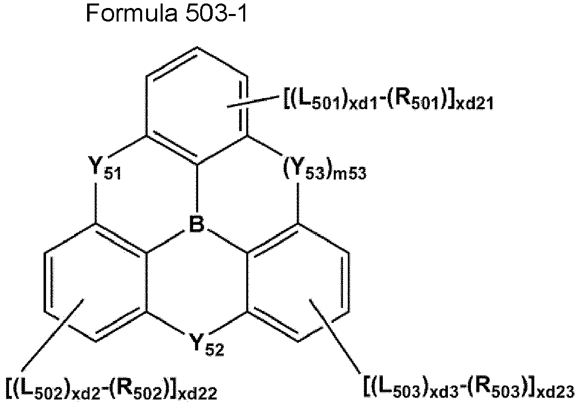 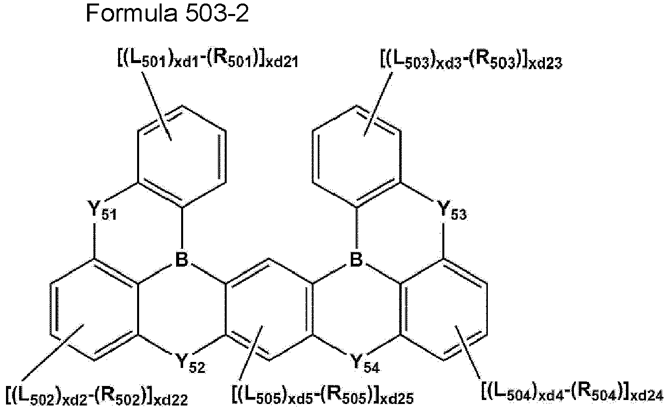 wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₆₀₆)_{xd6}-R₆₀₆][(L₆₀₇)_{xd7}-R_{607]},
m53 may be 0 or 1,
L₅₀₁ to L₅₀₇ may each be understood by referring to the description of L₅₀₁ in Formula 501B,
xd1 to xd7 may each be understood by referring to the description of xd1 in Formula 501B,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd21 and xd23 may each independently be 0, 1, 2, 3, or 4,
   xd22 and xd24 may each independently be 0, 1, 2, or 3,
   xd25 may be 0, 1, or 2, and
   two of R₅₀₁ to R₅₀₇ may optionally be bonded together to form a saturated or unsaturated ring group.

The fluorescent dopant may include, for example, at least one of Compounds FD(1) to FD(16), Compounds FD1 to FD14, or a combination thereof, but embodiments are not limited thereto:

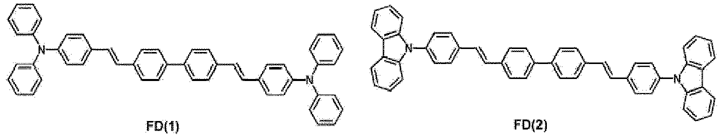

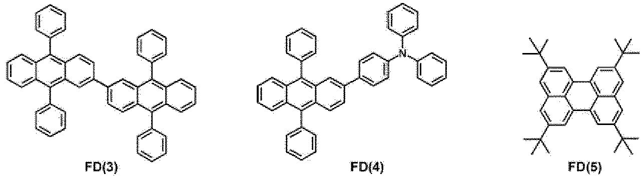

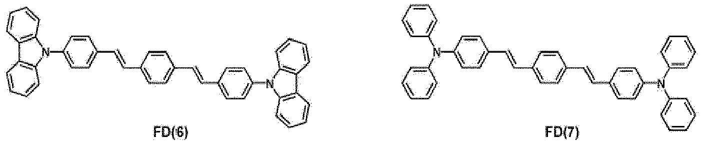

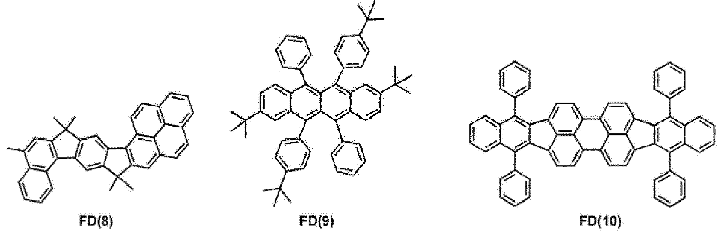

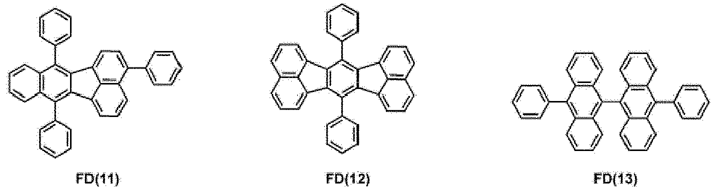

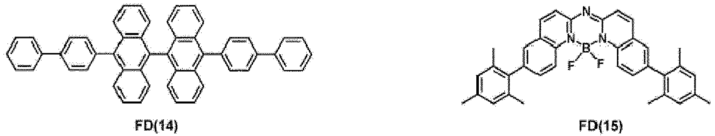

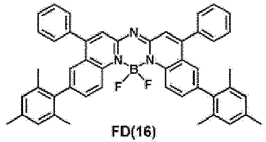

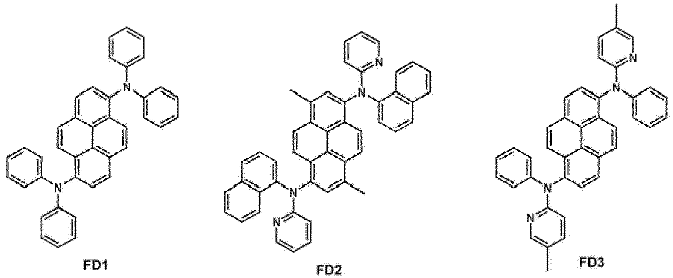

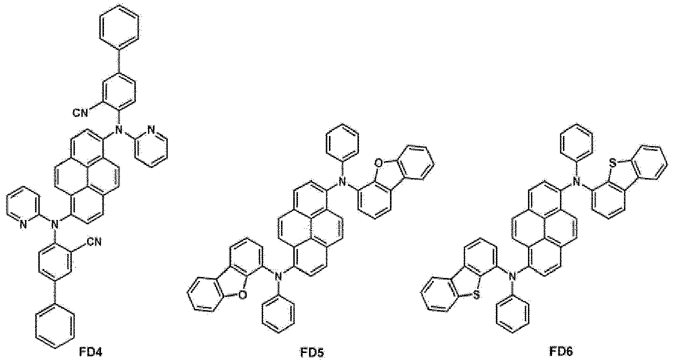

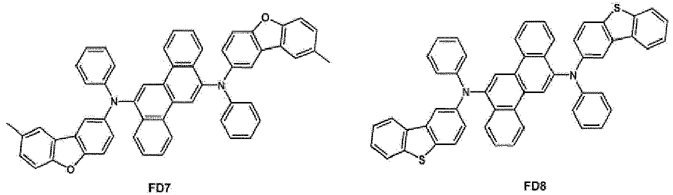

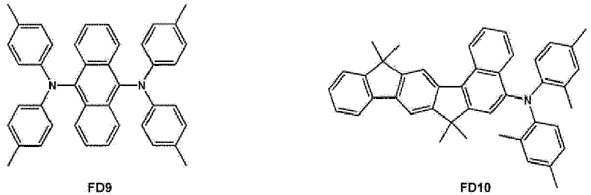

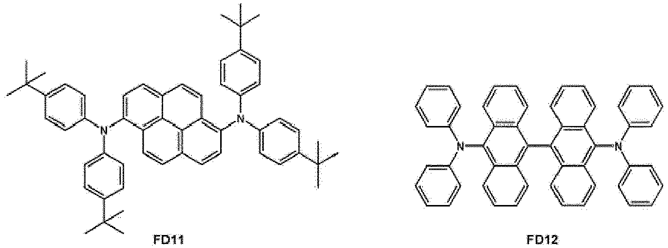

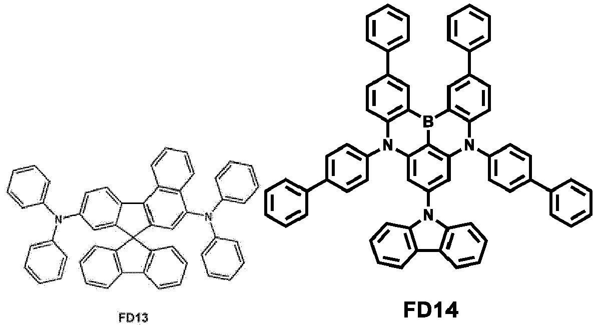

The expression "(organic layer) includes at least one organometallic compound represented by Formula 1-1 or 1-2" as used herein means that the (organic layer) may include one kind of organometallic compound represented by Formula 1-1 or 1-2 or two or more different kinds of organometallic compounds, each represented by Formula 1-1 or 1-2.

For example, the organic layer may include, as the at least one organometallic compound represented by Formula 1-1 or 1-2, only Compound 1. In this regard, Compound 1 may exist in the emission layer of the organic light-emitting device. In one or more embodiments, the organic layer may include, as the at least one organometallic compound represented by Formula 1-1 or 1-2, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the organic light-emitting device, the first electrode may be an anode, the second electrode may be a cathode, the organic layer may further include a hole transport region arranged between the first electrode and the emission layer, and an electron transport region arranged between the emission layer and the second electrode, the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers between the first electrode and the second electrode of the organic light-emitting device. The "organic layer" may include, in addition to an organic compound, an organometallic complex including a metal.

The FIGURE is a schematic view of an organic light-emitting device 10 according to one or more embodiments. Hereinafter, the structure of an organic light-emitting device according to one or more embodiments and a method of manufacturing an organic light-emitting device according to one or more embodiments will be described in connection with the FIGURE. The organic light-emitting device 10 includes a first electrode 11, an organic layer 15, and a second electrode 19, which are sequentially stacked in the stated order.

A substrate may be additionally located under the first electrode 11 or above the second electrode 19. For use as the substrate, any substrate that is used in organic light-emitting devices may be used, and the substrate may be a glass substrate or a transparent plastic substrate, each having excellent mechanical strength, thermal stability, transparency, surface smoothness, ease of handling, and/or water resistance.

In one or more embodiments, the first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 may be located above the first electrode 11.

The organic layer 15 may include a hole transport region, an emission layer, an electron transport region, or a combination thereof.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition, but embodiments are not limited thereto.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec. However, the deposition conditions are not limited thereto.

When the hole injection layer is formed using spin coating, coating conditions may vary according to a compound that is used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto:

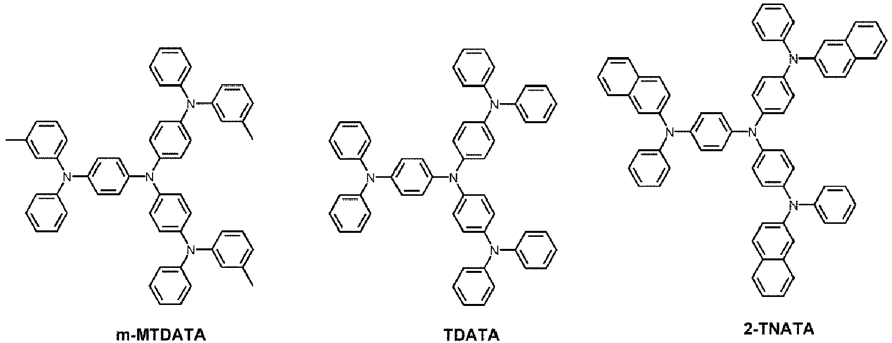

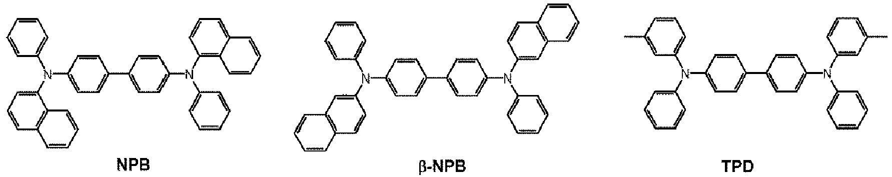

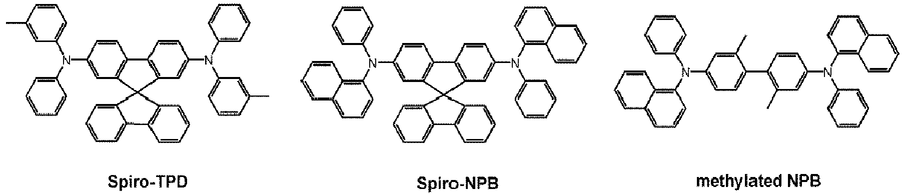

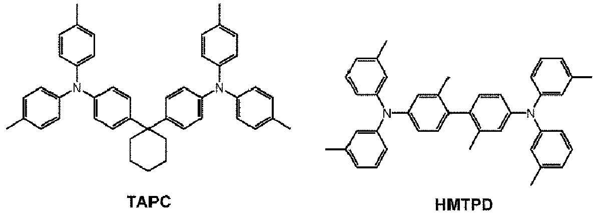

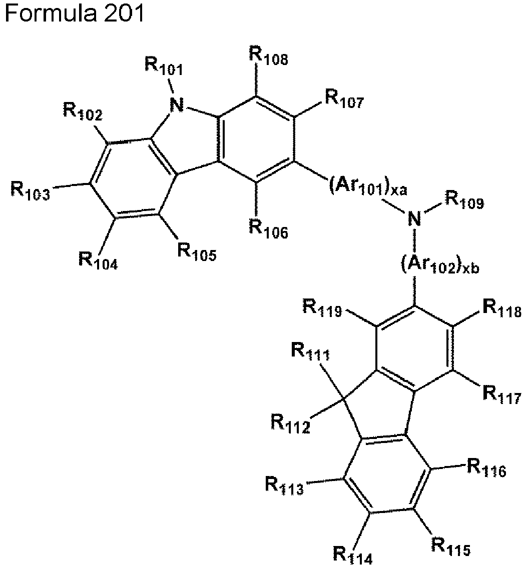

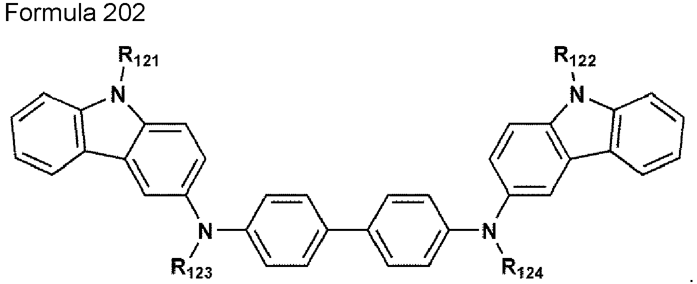

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0, but xa and xb are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, - Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A: 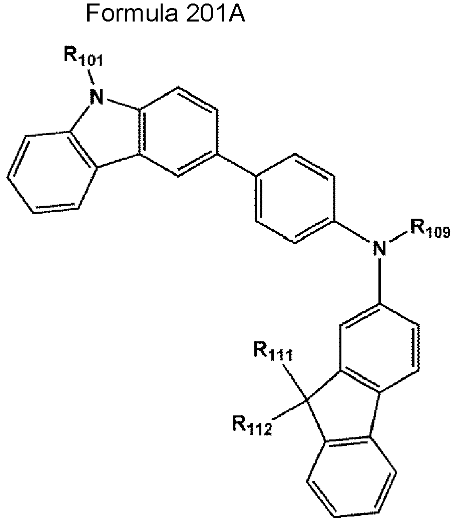 wherein, in Formula 201A, R₁₀₁, R₁₁₁, R₁₁₂, and R₁₀₉ may be understood by referring to the descriptions provided herein.

For example, the hole transport region may include one of Compounds HT1 to HT20, or a combination thereof, but embodiments are not limited thereto:

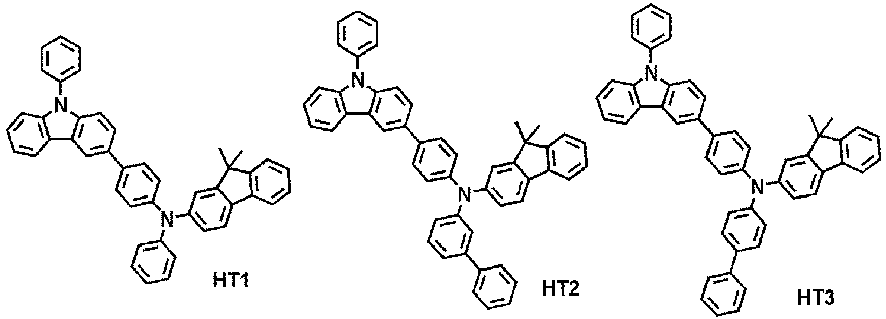

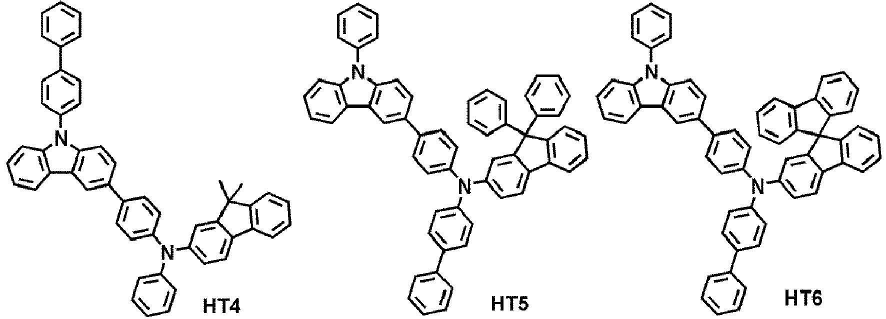

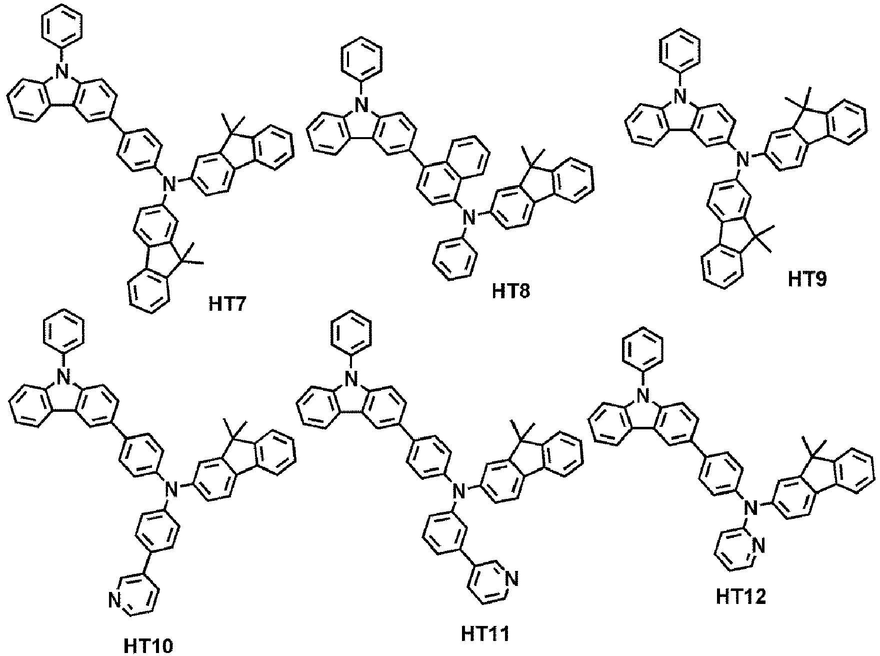

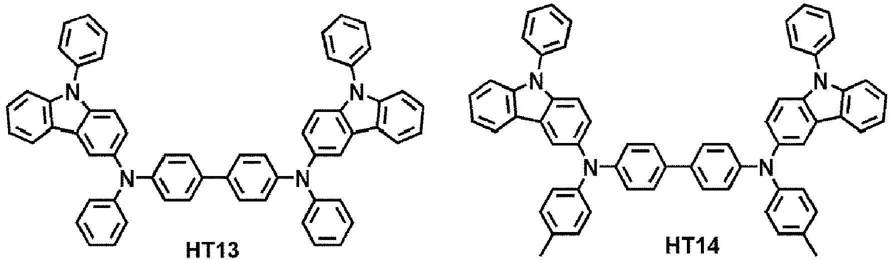

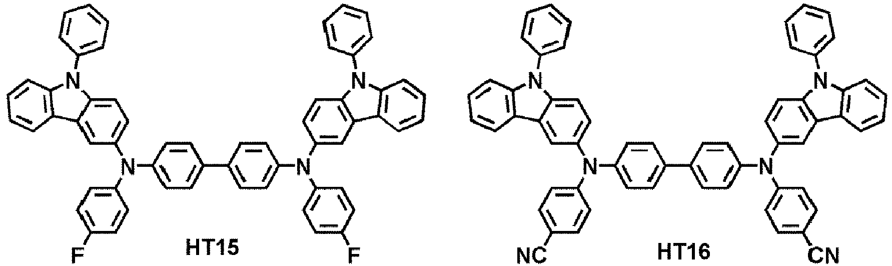

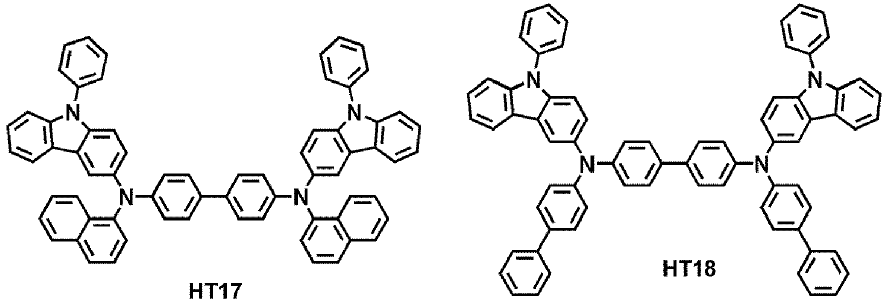

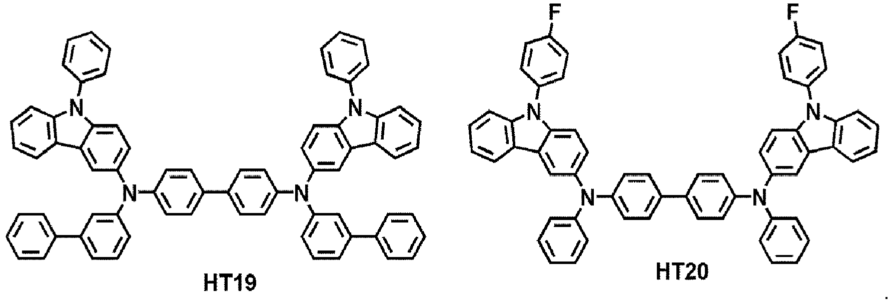

A thickness of the hole transport region may be about 100 Å to about 10,000 Å, for example, about 100 Å to about 1,000 Å. When the hole transport region includes a hole injection layer, a hole transport layer, an electron blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. Without wishing to be bound to theory, when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof, but embodiments are not limited thereto. For example, the p-dopant may be a quinone derivative such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide, such as a tungsten oxide, a molybdenum oxide, or the like; a cyano group-containing compound, such as Compound HT-D1 or the like; or a combination thereof, but embodiments are not limited thereto.

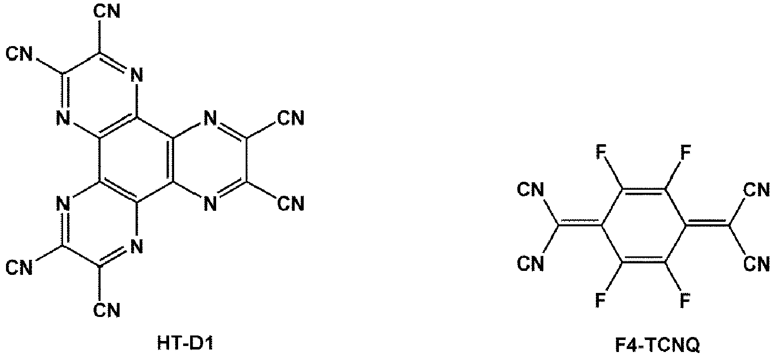

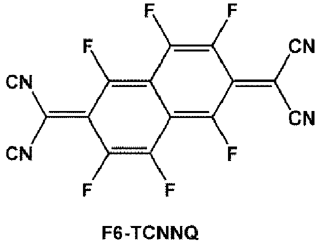

The hole transport region may further include a buffer layer.

The buffer layer may compensate for an optical resonance distance according to a wavelength of light emitted from the emission layer, and thus, efficiency of a formed organic light-emitting device may be increased.

Meanwhile, when the hole transport region includes an electron blocking layer, a material for forming the electron blocking layer may include a material that may be used in the hole transport region as described above, a host material described below, or a combination thereof. For example, when the hole transport region includes an electron blocking layer, a material for forming the electron blocking layer may include mCP.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

The emission layer may include a host and a dopant, and the dopant may include at least one of the organometallic compounds represented by Formula 1-1 or 1-2 as described herein.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalen-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TtCP), 1,3-bis(N-carbazolyl)benzene (mCP), Compound H50, Compound H51, Compound H52, or a combination thereof, but embodiments are not limited thereto:

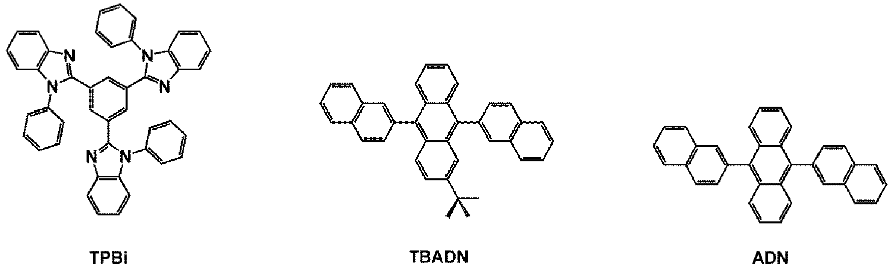

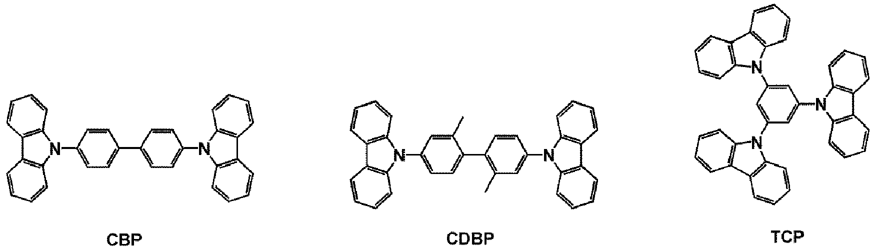

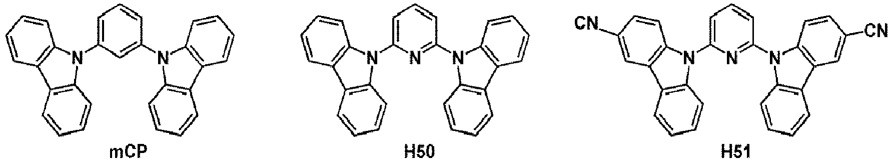

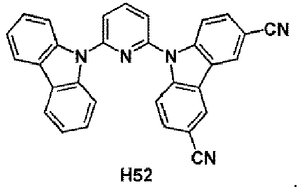

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light.

When the emission layer includes a host and a dopant, an amount of the dopant may be about 0.01 parts by weight to about 15 parts by weight, based on 100 parts by weight of the host, but embodiments are not limited thereto.

A thickness of the emission layer may be about 100 Å to about 1,000 Å, for example, about 200 Å to about 600 Å. Without wishing to be bound to theory, when the thickness of the emission layer is within the range, excellent light-emission characteristics may be obtained without a substantial increase in driving voltage.

Then, an electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure, or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), bis(2-methyl-8-quinolinolato-N1,08)-(1,1'-biphenyl-4-olato)aluminum (BAlq), or a combination thereof, but embodiments are not limited thereto:

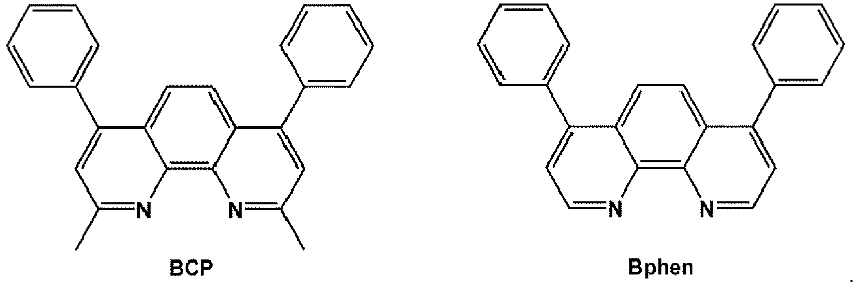

In one or more embodiments, the hole blocking layer may include the host, a material for forming an electron transport layer, a material for forming an electron injection layer, which will be described herein, or a combination thereof.

A thickness of the hole blocking layer may be about 20 Å to about 1,000 Å, for example, about 30 Å to about 600 Å. When the thickness of the hole blocking layer is within these ranges, the hole blocking layer may have excellent hole blocking characteristics without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), 1,3,5-tri(1-phenyl-1H-benzo[d]imidazol-2-yl)benzene (TPBi), tris(8-hydroxy-quinolinato)aluminum (Alq₃), bis(2-methyl-8-quinolinolato-N1,08)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto:

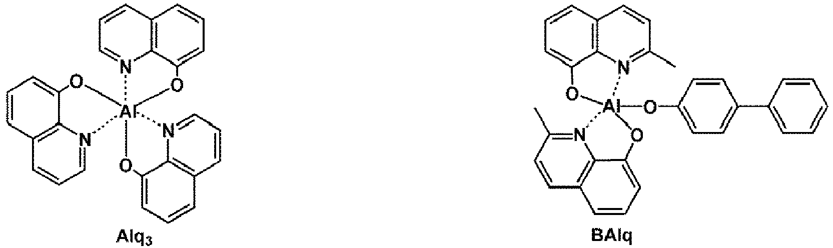

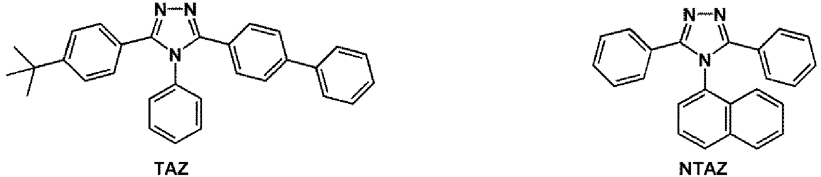

In one or more embodiments, the electron transport layer may include at least one of Compounds ET1 to ET25, or a combination thereof, but embodiments are not limited thereto:

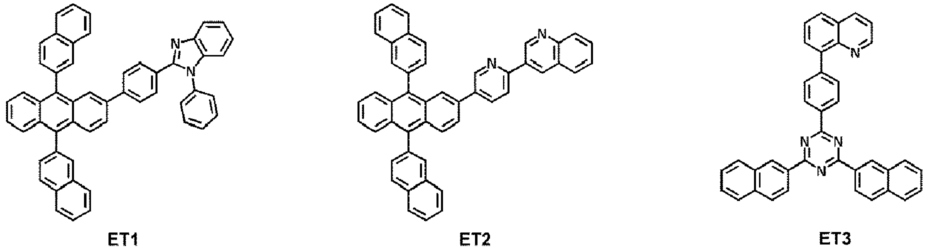

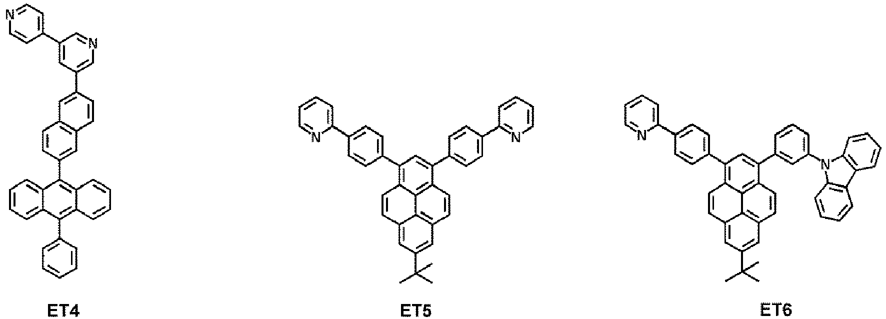

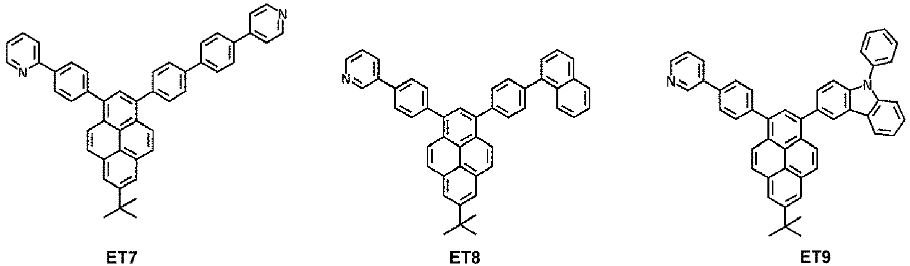

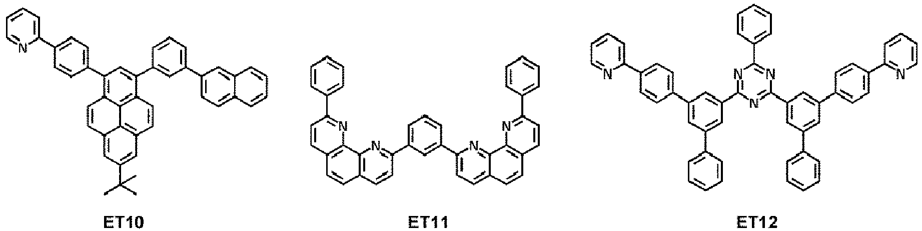

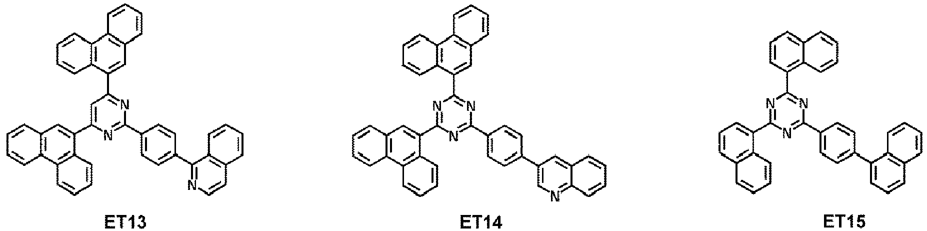

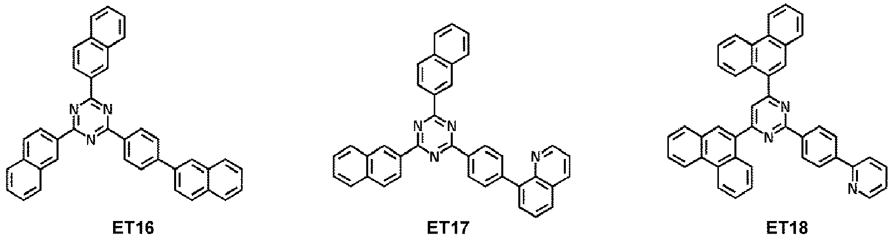

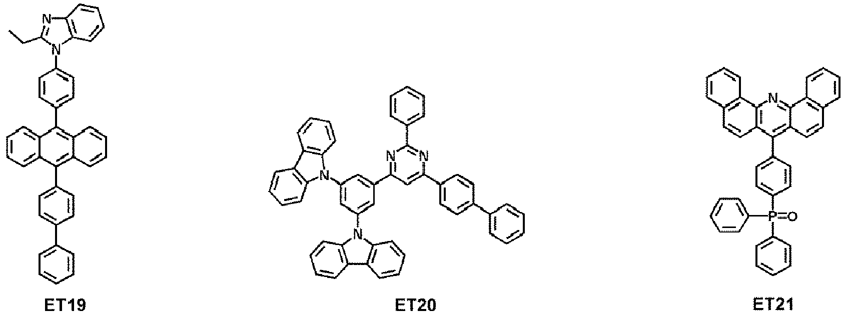

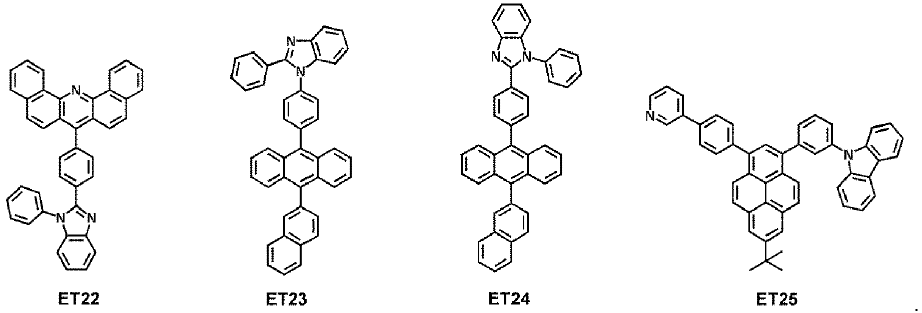

A thickness of the electron transport layer may be about 100 Å to about 1,000 Å, for example, about 150 Å to about 500 Å. Without wishing to be bound to theory, when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, at least one of Compound ET-D1 or ET-D2, but embodiments are not limited thereto.

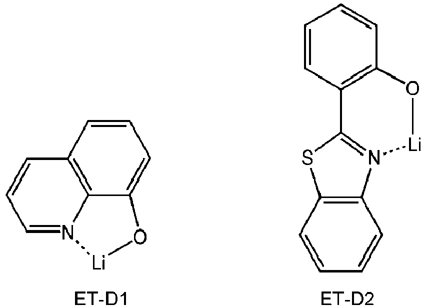

Also, the electron transport region may include an electron injection layer (EIL) that promotes flow of electrons from the second electrode 19 thereinto.

The electron injection layer may include at least one of LiF, NaCl, CsF, Li₂O, BaO, or a combination thereof.

A thickness of the electron injection layer may be about 1 Å to about 100 Å, and, for example, about 3 Å to about 90 Å. Without wishing to be bound to theory, when the thickness of the electron injection layer is within the range described above, satisfactory electron injection characteristics may be obtained without a substantial increase in driving voltage.

The second electrode 19 may be located above the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be formed as the material for forming the second electrode 19. In one or more embodiments, to manufacture a top-emission type light-emitting device, a transmissive electrode formed using ITO or IZO may be used as the second electrode 19, and various modifications may be made.

Hereinbefore, the organic light-emitting device has been described with reference to the FIGURE, but embodiments are not limited thereto.

According to one or more embodiments, the organic light-emitting device may be included in an electronic apparatus. Thus, there is provided an electronic apparatus including the organic light-emitting device. The electronic apparatus may include, for example, a display, an illumination, a sensor, or the like, but embodiments are not limited thereto.

According to one or more embodiments, also provided is a diagnostic composition including at least one organometallic compound represented by Formula 1-1 or 1-2.

Since the organometallic compound represented by Formula 1-1 or 1-2 provides a high emission efficiency, the diagnostic composition including at least one of the organometallic compounds represented by Formula 1-1 or 1-2 may have a high diagnostic efficiency.

The diagnostic composition may be used in various applications, including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used here refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

The term "C₁-C₆₀ alkoxy group" as used herein refers to a monovalent group having the formula of -OA₁₀₁ (where A₁₀₁ is the C₁-C₆₀ alkyl group), and the term "C₁-C₆₀ alkylthio group" as used herein indicates -SA₁₀₂ (wherein A₁₀₂ indicates the C₁-C₆₀ alkyl group).

Non-limiting examples of the C₁-C₆₀ alkoxy group, the C₁-C₂₀ alkoxy group, or the C₁-C₁₀ alkoxy group may include a methoxy group, an ethoxy group, a propoxy group, a butoxy group, a pentoxy group, or the like.

The term "C₂-C₆₀ alkenyl group" as used herein has a structure including at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as that of the C₃-C₁₀ cycloalkyl group.

Non-limiting examples of C₃-C₁₀ cycloalkyl group include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl group (a norbornanyl group), a bicyclo[2.2.2]octyl group, or the like.

The term "C₁-C₁₀ heterocycloalkyl group" as used herein refers to a monovalent monocyclic group that includes at least one heteroatom selected from N, O, P, Si, S, Se, Ge, and B as a ring-forming atom, and 1 to 10 carbon atoms as ring-forming atom(s), and the term "the C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group include a silolanyl group, a silinanyl group, a tetrahydrofuranyl group, a tetrahydro-2H-pyranyl group, a tetrahydrothiophenyl group, or the like.

The term "C₃-C₁₀ cycloalkenyl group" as used herein refers to a monovalent monocyclic group that has 3 to 10 carbon atoms, at least one carbon-carbon double bond in the ring thereof, and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms as ring-forming atom(s), and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms, and the term "C₆-C₆₀ arylene group" as used herein refers to a divalent group having a carbocyclic aromatic ring system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The "C₇-C₆₀ alkyl aryl group" as used herein refers to a C₆-C₆₀ aryl group that is substituted with at least one C₁-C₆₀ alkyl group. The "C₇₋C₆₀ aryl alkyl group" as used herein refers to a C₁-C₆₀ alkyl group that is substituted with at least one C₆-C₆₀ aryl group.

The term "C₁-C₆₀ heteroaryl group" as used herein refers to a monovalent group having at least one heteroatom selected from N, O, P, Si, S, Se, Ge, and B as a ring-forming atom and an aromatic ring system having 1 to 60 carbon atoms as ring-forming atom(s), and the term "C₁-C₆₀ heteroarylene group" as used herein refers to a divalent group having at least one heteroatom selected from N, O, P, Si, S, Se, Ge, and B as a ring-forming atom and an aromatic ring system having 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The "C₂-C₆₀ alkyl heteroaryl group" as used herein refers to a C₁-C₆₀ heteroaryl group that is substituted with at least one C₁-C₆₀ alkyl group. The "C₂-C₆₀ heteroaryl alkyl group" as used herein refers to a C₁-C₆₀ alkyl group that is substituted with at least one C₁-C₆₀ heteroaryl group.

The term "C₆-C₆₀ aryloxy group" as used herein indicates -OA₁₀₃ (wherein A₁₀₃ indicates the C₆-C₆₀ aryl group), and the term "C₆-C₆₀ arylthio group" as used herein indicates -SA₁₀₄ (wherein A₁₀₄ indicates the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its molecular structure when considered as a whole. Non-limiting examples of the monovalent non-aromatic condensed polycyclic group include a fluorenyl group or the like. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, a heteroatom selected from N, O, P, Si, S, Se, Ge, and B, other than carbon atoms, as a ring-forming atom, and no aromaticity in its molecular structure when considered as a whole. Non-limiting examples of the monovalent non-aromatic condensed heteropolycyclic group includes a carbazolyl group or the like. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" include an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group, or the like (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B, other than 1 to 30 carbon atoms as ring-forming atom(s). The C₁-C₃₀ heterocyclic group may be a monocyclic group or a polycyclic group. Non-limiting examples of the "C₁-C₃₀ heterocyclic group (unsubstituted or substituted with at least one R₁₀ₐ)" include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, or -CFH₂. The "fluorinated C₁-C₆₀ alkyl group (or a fluorinated C₁-C₂₀ alkyl group or the like)," "the fluorinated C₃-C₁₀ cycloalkyl group," "the fluorinated C₁-C₁₀ heterocycloalkyl group," or "the fluorinated phenyl group" may be i) a fully fluorinated C₁-C₆₀ alkyl group (or a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein are substituted with a fluoro group, or ii) a partially fluorinated C₁-C₆₀ alkyl group (or a partially fluorinated C₁-C₂₀ alkyl group or the like), a partially fluorinated C₃-C₁₀ cycloalkyl group, a partially fluorinated C₁-C₁₀ heterocycloalkyl group, or a partially fluorinated phenyl group, wherein, in each group, all hydrogen included therein are not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium atom. For example, the "deuterated C₁ alkyl group (that is, the deuterated methyl group)" may include -CD₃, -CD₂H, or -CDH₂. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl)'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group that is substituted with at least one C₁-C₂₀ alkyl group, and the term "(C₁-C₂₀ alkyl)phenyl group" as used herein refers to a phenyl group that is substituted with at least one C₁-C₂₀ alkyl group. Non-limiting examples of a (C₁ alkyl)phenyl group include a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" as used herein respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom selected from ring-forming carbon atoms is substituted with nitrogen.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SFs, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or - P(Q₃₃)(Q₃₉); or
a combination thereof.

Q₁ to Q₉, Q₁₁ to Q₁₉, Q₂₁ to Q₂₉, and Q₃₁ to Q₃₉ as used herein may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

Hereinafter, a compound and an organic light-emitting device according to exemplary embodiments are described in further detail with reference to Synthesis Examples and Examples. However, embodiments are not limited thereto. The wording "B was used instead of A" in describing Synthesis Examples means that an amount of A that was used was identical to an amount of B that was used, in terms of a molar equivalent.

### EXAMPLES

### Synthesis Example 1 (Compound 19)

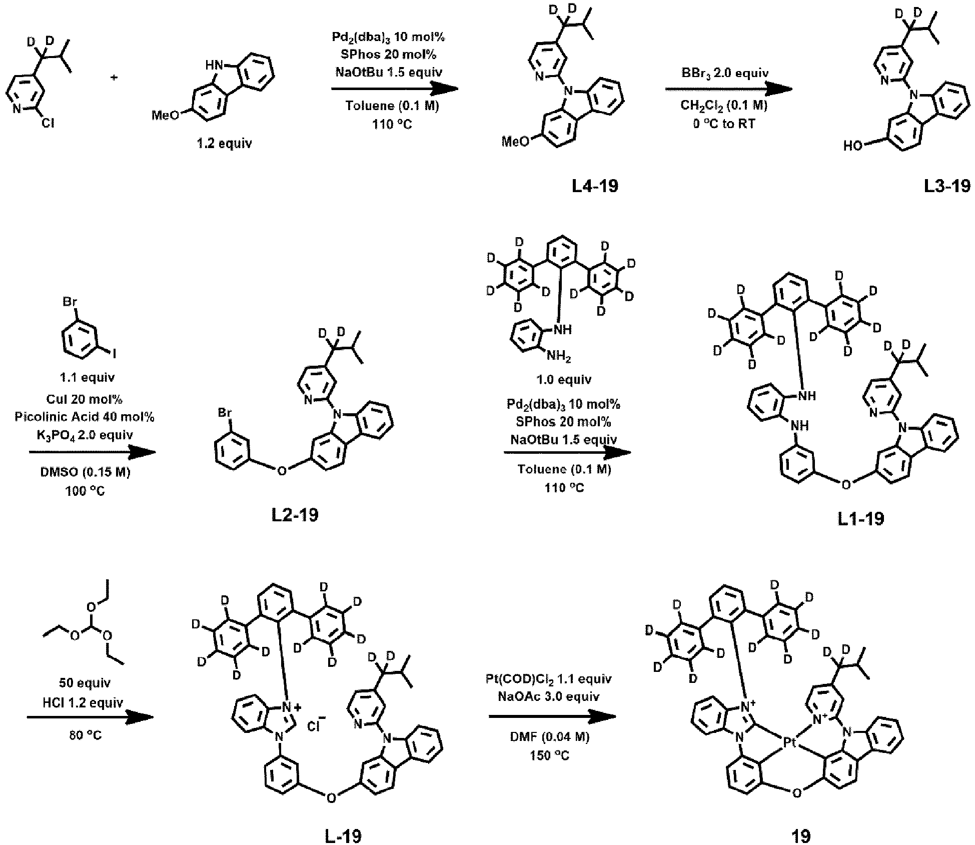

### Synthesis of Intermediate L4-19

2-chloro-4-(2-methylpropyl-1,1-d₂)pyridine (3.43 grams (g), 20 millimoles (mmol)), 2-methoxy-9H-carbazole (4.73 g, 24 mmol), tris(dibenzylideneacetone)dipalladium(0) (Pd₂(dba)₃) (1.83 g, 2 mmol), 2-dicyclohexylphosphino-2',6'-dimethoxybiphenyl (SPhos) (1.64 g, 4 mmol), and sodium tert-butoxide (NaO^{t}Bu) (2.88 g, 30 mmol) were mixed with 200 milliliters (mL) of toluene and then stirred at 110°C for 12 hours. Once the reaction was completed, the mixture was allowed to cool to room temperature, and then, an organic layer was extracted using saturated ammonium chloride (NH₄Cl) and methylene chloride (MC). The organic layer was dried with anhydrous magnesium sulfate (MgSO₄) aqueous solution and subjected to filtration, followed by removing the solvent under a reduced pressure. The resulting product was purified by silica gel column chromatography to thereby obtain Intermediate L4-19 (4.99 g, 15 mmol, yield = 75%).

Liquid chromatography-mass spectrometry (LC-MS) (calculated: 332.19 g/mol, found M+1 = 333 g/mol).

### Synthesis of Intermediate L3-19

Intermediate L4-19 (4.99 g, 15 mmol) was dissolved in 150 mL of MC and was then cooled to 0°C. Then, 1.0 molar (M) BBr₃ (30 mL, 30 mmol) was slowly added dropwise thereto. Afterwards, stirring was performed at room temperature for 2 hours. Once the reaction was completed, the mixture was cooled to 0°C, and water was slowly added dropwise thereto to quench the residual BBr₃. After the solution was neutralized using saturated sodium bicarbonate (NaHCOs), an organic layer was extracted using MC. The organic layer was dried with anhydrous magnesium sulfate (MgSO₄) aqueous solution and subjected to filtration, followed by removing the solvent under a reduced pressure. The resulting product was purified by silica gel column chromatography to thereby obtain Intermediate L3-19 (3.87 g, 12.15 mmol, yield = 81%).

LC-MS (calculated: 318.17 g/mol, found M+1 = 319 g/mol).

### Synthesis of Intermediate L2-19

Intermediate L3-19 (3.87 g, 12.15 mmol), 1-bromo-3-iodobenzene (3.78 g, 13.37 mmol), Cul (0.46 g, 2.43 mmol), picolinic acid (0.60 g, 4.86 mmol), and K₃PO₄ (5.16 g, 24.3 mmol) were mixed with 81 mL of dimethylsulfoxide (DMSO), and then stirred at 100°C for 12 hours. Once the reaction was completed, the mixture was allowed to cool to room temperature. Then, an organic layer was extracted using saturated ammonium chloride (NH₄Cl) aqueous solution and ethyl acetate (EA). The organic layer was dried with anhydrous magnesium sulfate (MgSO₄) and subjected to filtration, followed by removing the solvent under a reduced pressure. The resulting product was purified by silica gel column chromatography to thereby obtain Intermediate L2-19 (3.45 g, 7.29 mmol, yield = 60%).

### Synthesis of Intermediate L1-19

Intermediate L2-19 (3.45 g, 7.29 mmol), N1-([1,1':3',1"-terphenyl]-2'-yl-2,2",3,3",4,4",5,5",6,6"-d10)benzene-1,2-diamine (2.53 g, 7.29 mmol), Pd₂(dba)₃ (0.67 g, 0.73 mmol), SPhos (0.60 g, 1.46 mmol), and NaO^{t}Bu (1.05 g, 10.93 mmol) were mixed with 73 mL of toluene and then stirred at 110°C for 2 hours. Once the reaction was completed, the mixture was allowed to cool to room temperature. Then, an organic layer was extracted using saturated NH₄Cl aqueous solution and MC. The organic layer was dried with anhydrous magnesium sulfate (MgSO₄) and subjected to filtration, followed by removing the solvent under a reduced pressure. The resulting product was purified by silica gel column chromatography to thereby obtain Intermediate L1-19 (4.14 g, 5.61 mmol, yield = 77%).

LC-MS (calculated : 738.41 g/mol, found M+1 = 739 g/mol).

### Synthesis of Intermediate L-19

Intermediate L1-19 (4.14 g, 5.61 mmol) and 36 % HCl aqueous solution (0.58 ml, 6.73 mmol) were mixed with triethyl orthoformate (46.7 ml, 280.5 mmol) and then stirred at 80°C for 3 hours. Once the reaction was completed, the mixture was allowed to cool to room temperature. Then, the solvent was removed under a reduced pressure. The resulting product was purified by silica gel column chromatography to thereby obtain Intermediate L-19 (4.10 g, 5.22 mmol, yield = 93%).

LC-MS (calculated: 785.46 g/mol, found M+1 = 786 g/mol).

### Synthesis of Compound 19

Intermediate L-19 (4.10 g, 5.22 mmol), (1,5-cyclooctadiene)platinum(II) dichloride (Pt(COD)Cl₂) (1.99 g, 5.74 mmol), and sodium acetate (1.28 g, 15.66 mmol) were mixed with 130 mL of dimethylformamide (DMF), and then the reaction mixture was stirred and heated at 150°C for 12 hours. Once the reaction was completed, the mixture was allowed cooled to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 19 (2.21 g, 2.35 mmol, yield = 45%).

LC-MS (calculated: 941.34 g/mol, found M+1 = 942 g/mol).

### Synthesis Example 2 (Compound 20)

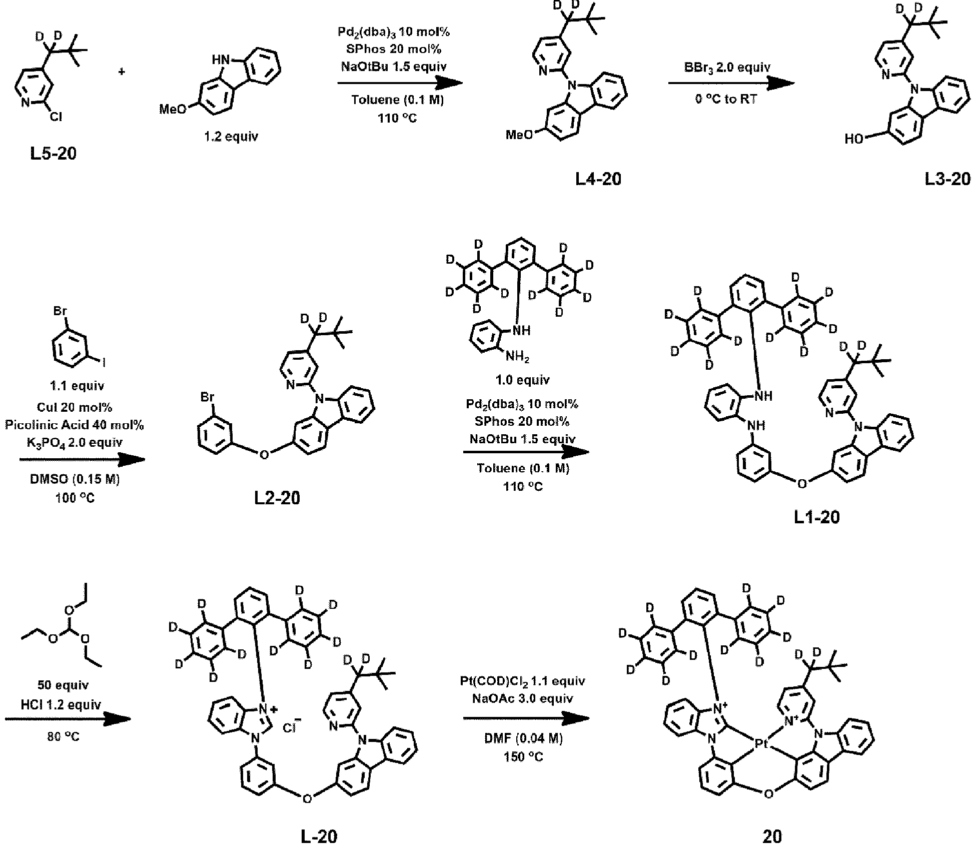

### Synthesis of Intermediate L4-20

Intermediate L4-20 was synthesized in a similar manner as used to synthesize Intermediate L4-19 of Synthesis Example 1, except that Compound L5-20 was used instead of 2-chloro-4-(2-methylpropyl-1,1-d2)pyridine.

### Synthesis of Intermediate L3-20

Intermediate L3-20 was synthesized in a similar manner as used to synthesize Intermediate L3-19 of Synthesis Example 1, except that Intermediate L4-20 was used instead of Intermediate L4-19.

### Synthesis of Intermediate L2-20

Intermediate L2-20 was synthesized in a similar manner as used to synthesize Intermediate L2-19 of Synthesis Example 1, except that Intermediate L3-20 was used instead of Intermediate L3-19.

### Synthesis of Intermediate L1-20

Intermediate L1-20 was synthesized in a similar manner as used to synthesize Intermediate L1-19 of Synthesis Example 1, except that Intermediate L2-20 was used instead of Intermediate L2-19.

### Synthesis of Intermediate L-20

Intermediate L-20 was synthesized in a similar manner as used to synthesize Intermediate L-19 of Synthesis Example 1, except that Intermediate L1-20 was used instead of Intermediate L1-19.

### Synthesis of Compound 20

Intermediate L-20 (5.0 g, 6.25 mmol), Pt(COD)Cl₂ (2.57 g, 6.88 mmol), and sodium acetate (1.54 g, 18.75 mmol) were mixed with 155 mL of DMF, and then the reaction mixture was stirred and heated at 150°C for 12 hours. Once the reaction was completed, the mixture was allowed to cool to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 20 (2.45 g, 2.56 mmol, yield = 41%).

LC-MS (calculated: 955.36 g/mol, found M+1 = 956 g/mol).

### Synthesis Example 3 (Compound 21)

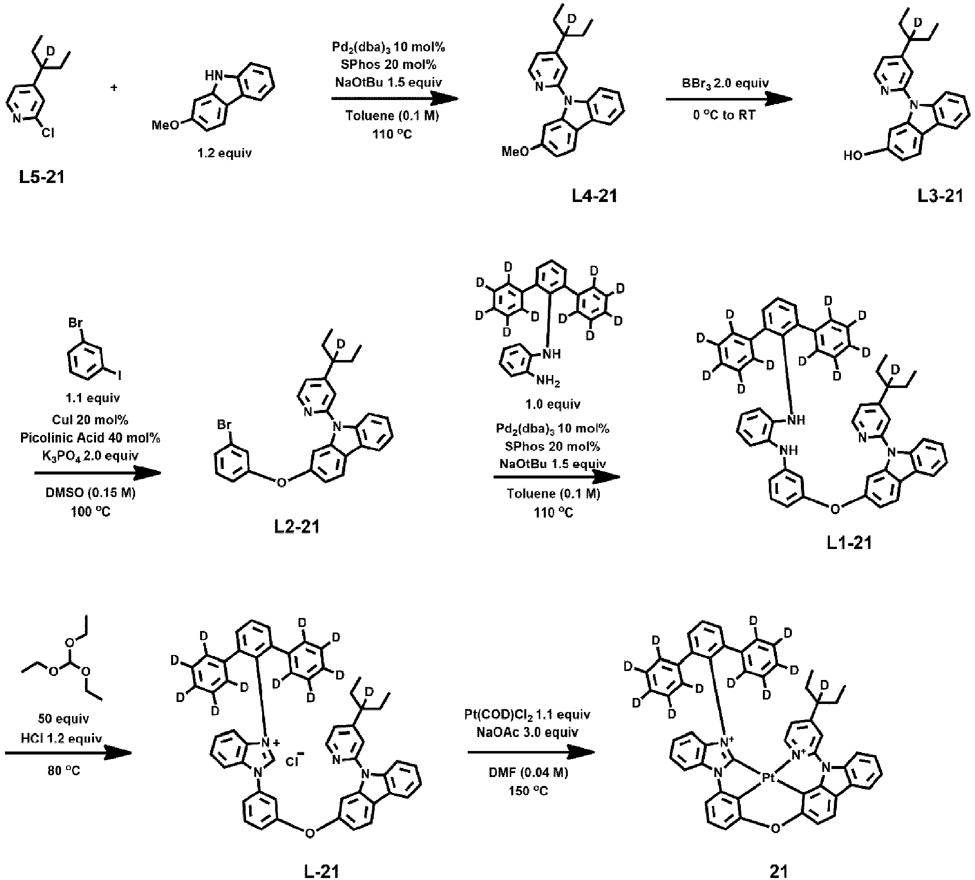

### Synthesis of Intermediate L4-21

Intermediate L4-21 was synthesized in a similar manner as used to synthesize Intermediate L4-19 of Synthesis Example 1, except that Compound L5-21 was used instead of 2-chloro-4-(2-methylpropyl-1,1-d2)pyridine.

### Synthesis of Intermediate L3-21

Intermediate L3-21 was synthesized in a similar manner as used to synthesize Intermediate L3-19 of Synthesis Example 1, except that Intermediate L4-21 was used instead of Intermediate L4-19.

### Synthesis of Intermediate L2-21

Intermediate L2-21 was synthesized in a similar manner as used to synthesize Intermediate L2-19 of Synthesis Example 1, except that Intermediate L3-21 was used instead of Intermediate L3-19.

### Synthesis of Intermediate L1-21

Intermediate L1-21 was synthesized in a similar manner as used to synthesize Intermediate L1-19 of Synthesis Example 1, except that Intermediate L2-21 was used instead of Intermediate L2-19.

### Synthesis of Intermediate L-21

Intermediate L-21 was synthesized in a similar manner as used to synthesize Intermediate L-19 of Synthesis Example 1, except that Intermediate L1-21 was used instead of Intermediate L1-19.

### Synthesis of Compound 21

Intermediate L-21 (5.0 g, 6.25 mmol), Pt(COD)Cl₂ (2.57 g, 6.88 mmol), and sodium acetate (1.54 g, 18.75 mmol) were mixed with 155 mL of DMF, and then the reaction mixture was stirred at 150°C for 12 hours. Once the reaction was completed, the mixture was allowed to cool to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 21 (2.39 g, 2.50 mmol, yield = 40%).

LC-MS (calculated: 954.35 g/mol, found M+1 = 955 g/mol).

### Synthesis Example 4 (Compound 92)

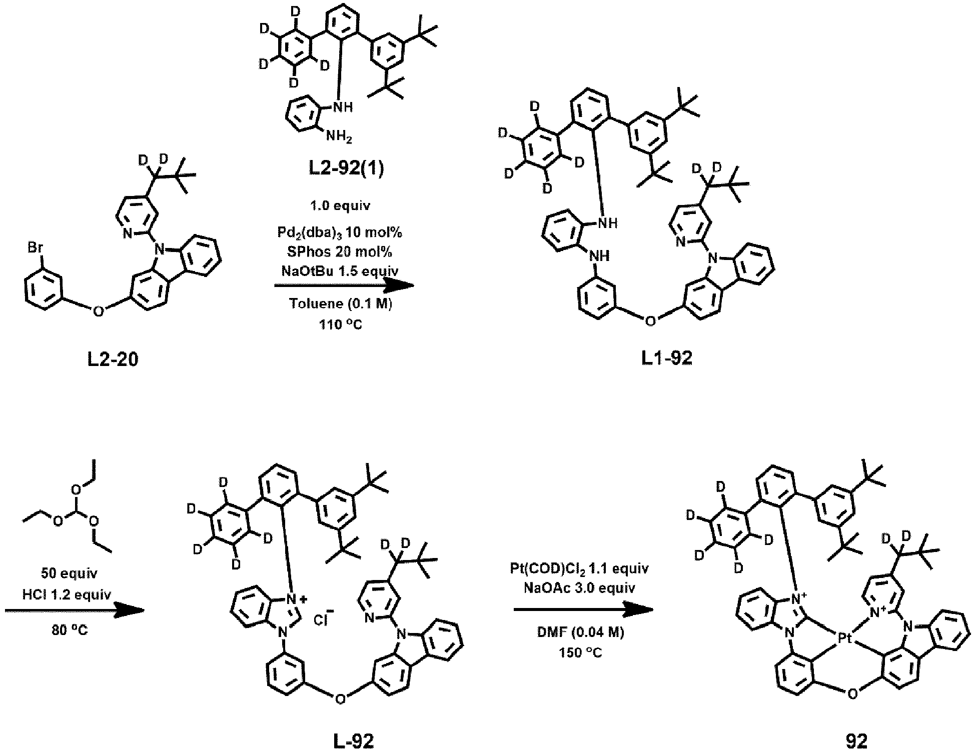

### Synthesis of Intermediate L1-92

Intermediate L1-92 was synthesized in a similar manner as used to synthesize Intermediate L1-20 of Synthesis Example 2, except that Compound L2-92(1) was used instead of N1-([1,1':3',1"-terphenyl]-2'-yl-2,2",3,3",4,4",5,5",6,6"-d10)benzene-1,2-diamine.

### Synthesis of Intermediate L-92

Intermediate L-92 was synthesized in a similar manner as used to synthesize Intermediate L-20 of Synthesis Example 2, except that Intermediate L1-92 was used instead of Intermediate L1-20.

### Synthesis of Compound 92

Intermediate L-92 (5.0 g, 5.51 mmol), Pt(COD)Cl₂ (2.27 g, 6.06 mmol), and sodium acetate (1.36 g, 16.53 mmol) were mixed with 138 mL of DMF, and then the reaction mixture was stirred and heated at 150°C for 12 hours. Once the reaction was completed, the mixture was allowed to cool to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 92 (2.45 g, 2.31 mmol, yield = 42%).

LC-MS (calculated: 1062.45 g/mol, found M+1 = 1063 g/mol).

### Synthesis Example 5 (Compound 250)

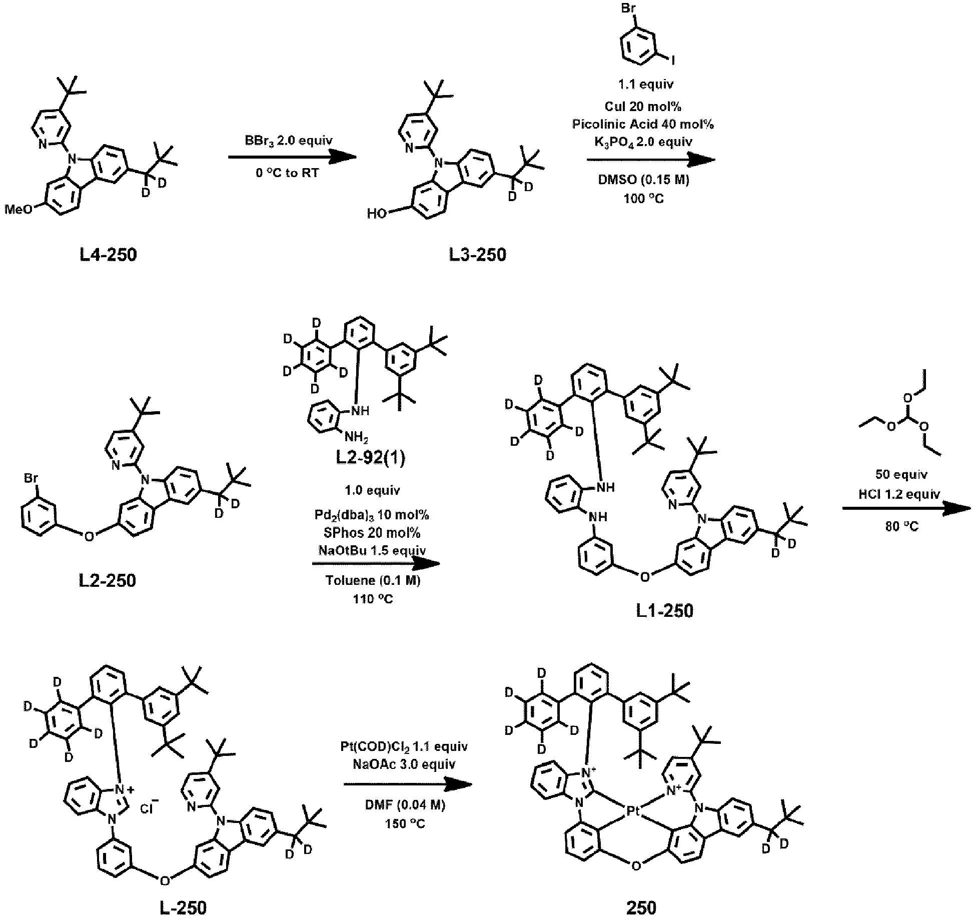

### Synthesis of Intermediate L3-250

Intermediate L3-250 was synthesized in a similar manner as used to synthesize Intermediate L3-19 of Synthesis Example 1, except that Intermediate L4-250 was used instead of Intermediate L4-19.

### Synthesis of Intermediate L2-250

Intermediate L2-250 was synthesized in a similar manner as used to synthesize Intermediate L2-19 of Synthesis Example 1, except that Intermediate L3-250 was used instead of Intermediate L3-19.

### Synthesis of Intermediate L1-250

Intermediate L1-250 was synthesized in a similar manner as used to synthesize Intermediate L1-19 of Synthesis Example 1, except that Intermediate L2-250 and Compound L2-92(1) were used instead of Intermediate L2-19 and N1-([1,1':3',1"-terphenyl]-2'-yl-2,2",3,3",4,4",5,5",6,6"-d₁₀)benzene-1,2-diamine, respectively.

### Synthesis of Intermediate L-250

Intermediate L-250 was synthesized in a similar manner as used to synthesize Intermediate L-19 of Synthesis Example 1, except that Intermediate L1-250 was used instead of Intermediate L1-19.

### Synthesis of Compound 250

Intermediate L-250 (5.0 g, 5.19 mmol), Pt(COD)Cl₂ (2.14 g, 5.71 mmol), and sodium acetate (1.28 g, 15.58 mmol) were mixed with 130 mL of DMF, and then the reaction mixture was stirred at 150°C for 12 hours. Once the reaction was completed, the mixture was allowed to cool to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 250 (2.44 g, 2.18 mmol, yield = 42%).

LC-MS (calculated: 1118.52 g/mol, found M+1 = 1119 g/mol).

### Synthesis Example 6 (Compound 272)

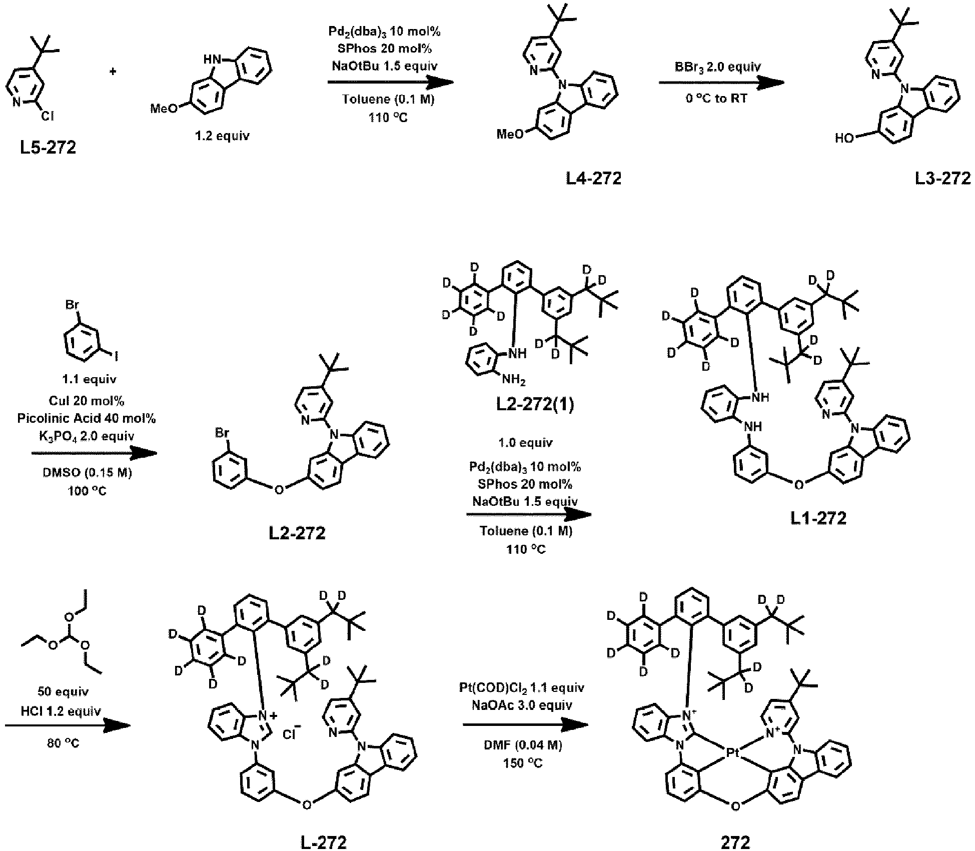

### Synthesis of Intermediate L4-272

Intermediate L4-272 was synthesized in a similar manner as used to synthesize Intermediate L4-19 of Synthesis Example 1, except that Compound L5-272 was used instead of 2-chloro-4-(2-methylpropyl-1,1-d2)pyridine.

### Synthesis of Intermediate L3-272

Intermediate L3-272 was synthesized in a similar manner as used to synthesize Intermediate L3-19 of Synthesis Example 1, except that Intermediate L4-272 was used instead of Intermediate L4-19.

### Synthesis of Intermediate L2-272

Intermediate L2-272 was synthesized in a similar manner as used to synthesize Intermediate L2-19 of Synthesis Example 1, except that Intermediate L3-272 was used instead of Intermediate L3-19.

### Synthesis of Intermediate L1-272

Intermediate L1-272 was synthesized in a similar manner as used to synthesize Intermediate L1-19 of Synthesis Example 1, except that Intermediate L2-272 and Compound L2-272(1) were used instead of Intermediate L2-19 and N1-([1,1':3',1"-terphenyl]-2'-yl-2,2",3,3",4,4",5,5",6,6"-d₁₀)benzene-1,2-diamine, respectively.

### Synthesis of Intermediate L-272

Intermediate L-272 was synthesized in a similar manner as used to synthesize Intermediate L-19 of Synthesis Example 1, except that Intermediate L1-272 was used instead of Intermediate L1-19.

### Synthesis of Compound 272

Intermediate L-272 (5.0 g, 5.42 mmol), Pt(COD)Cl₂ (2.23 g, 5.96 mmol), and sodium acetate (1.33 g, 16.26 mmol) were mixed with 136 mL of DMF, and then the reaction mixture was stirred and heated at 150°C for 12 hours. Once the reaction was completed, the mixture was allowed to cool to room temperature. Then, an organic layer was extracted using saturated NH₄Cl aqueous solution and EA. The organic layer was dried with anhydrous MgSO₄ and subjected to filtration, followed by removing the solvent under a reduced pressure. The resulting product was purified by silica gel column chromatography to thereby obtain Compound 272 (2.46 g, 2.28 mmol, yield = 42%).

LC-MS (calculated: 1078.48 g/mol, found M+1 = 1079 g/mol).

### Evaluation Example 1

After an emission spectrum of each of compounds in Table 3 was measured according to a method described in Table 2, a peak wavelength (PLₘₐₓ, nm) of a peak having a maximum emission intensity of the emission spectrum of each compound, a FWHM of the peak having a maximum emission intensity of the emission spectrum (nm), and triplet (T₁, eV) energy were evaluated, and the results thereof are shown in Table 3.

**Table 2**

| | |
|---|---|
| Emission spectrum evaluation method | After each compound was diluted in toluene to a concentration of 1x10⁻⁴ M, an ISC PC1 spectrofluorometer equipped with a xenon lamp was used to measure a photoluminescence (PL) spectrum for the compound at room temperature. |
| T₁ energy level evaluation method | A PLₘₐₓ value evaluated from the emission spectrum and the following equation were used for evaluation. T₁ (eV) = 1240 / PLₘₐₓ |

**Table 3**

| Compound No. | PLₘₐₓ (nm) | FWHM (nm) | T₁ (eV) |
|---|---|---|---|
| 19 | 461 | 18 | 2.69 |
| 20 | 461 | 17 | 2.69 |
| 21 | 461 | 18 | 2.69 |
| 92 | 461 | 17 | 2.69 |
| 250 | 461 | 17 | 2.69 |
| 272 | 461 | 17 | 2.69 |
| A | 461 | 18 | 2.69 |
| B | 463 | 19 | 2.68 |
| C | 462 | 17 | 2.68 |

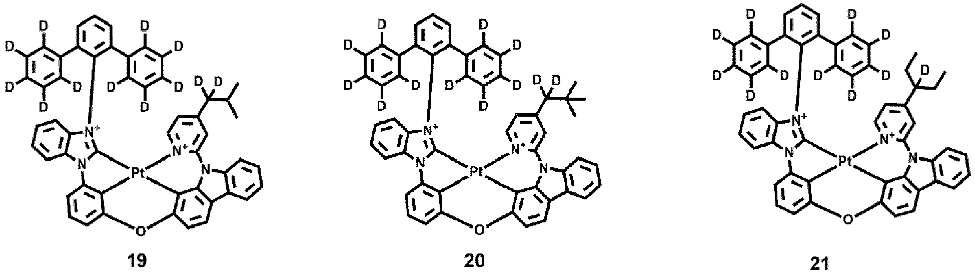

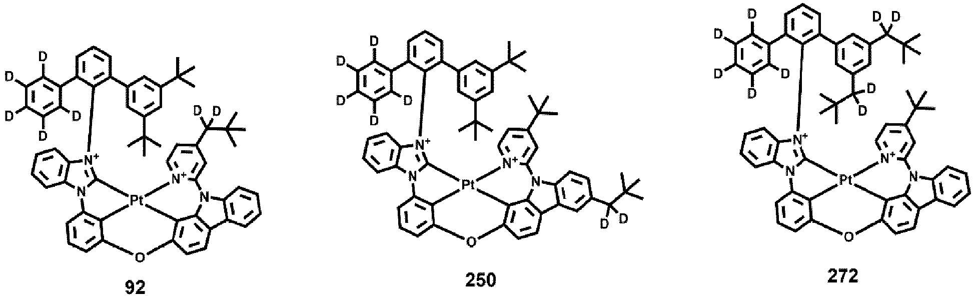

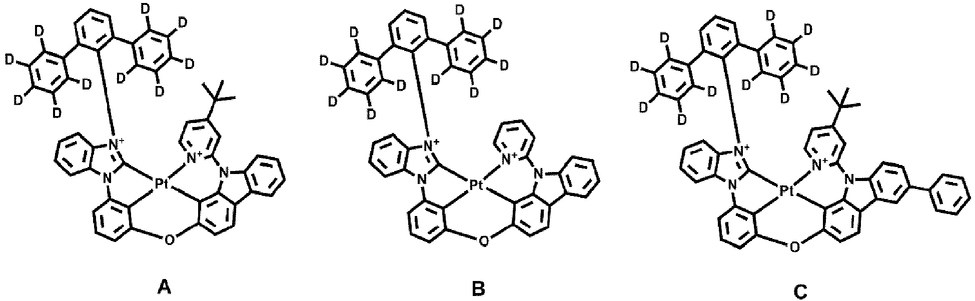

### Example 1

A glass substrate having formed thereon an ITO electrode having a thickness of 1,500 Å was cut to a size of 50 millimeters (mm) × 50 mm × 0.5 mm and then, sonicated in acetone isopropyl alcohol and deionized (DI) water, each for 15 minutes, and then, washed by exposure to UV ozone for 30 minutes.

Next, m-MTDATA was deposited on the ITO electrode (anode) on the glass substrate to form a hole injection layer having a thickness of 600 Å, and α-NPD was deposited on the hole injection layer to form a hole transport layer having a thickness of 250 Å.

Compound 19 (emitter) and CBP (host) were co-deposited on the hole transport layer at a weight ratio of 10:90 to form an emission layer having a thickness of 400 Å.

BAlq was deposited on the emission layer to form a hole blocking layer having a thickness of 50 Å, Alq₃ was deposited on the hole blocking layer to form an electron transport layer having a thickness of 300 Å, LiF was deposited on the electron transport layer to form an electron injection layer having a thickness of 10 Å, and then, Al was vacuum deposited on the electron injection layer to form a second electrode (cathode) having a thickness of 1,200 Å, thereby completing the manufacture of an organic light-emitting device having a structure of ITO / m-MTDATA (600 Å) / α-NPD (250 Å) / CBP + Compound 19 (10 wt%) (400 Å) / BAlq (50 Å) / Alq₃ (300 Å) / LiF (10 Å) / Al (1,200 Å).

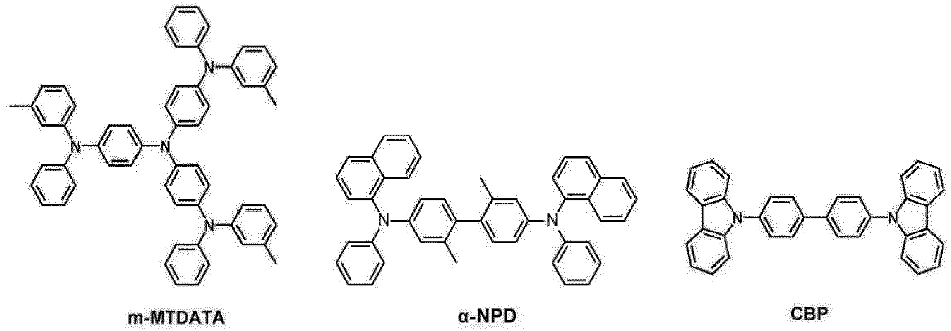

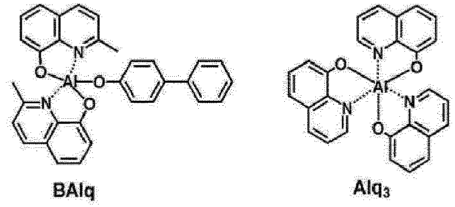

### Examples 1 to 6 and Comparative Examples A and B

Organic light-emitting devices were manufactured in a similar manner as in Example 1, except that the compounds shown in Table 4 were used instead of Compound 19 as an emitter in formation of the emission layer.

### Evaluation Example 2

For each of the organic light-emitting devices manufactured in Examples 1 to 6 and Comparative Examples A and B, an emission peak wavelength (maximum emission peak wavelength, nm) of an EL spectrum, a y coordinate (CIEy) of a color coordinate, a driving voltage (Volts, V), and an external quantum efficiency (EQE, %) were evaluated, and results thereof are shown in Table 4. For each organic light-emitting device, the emission peak wavelength of the EL spectrum and the y coordinate of the color coordinate was evaluated from the EL spectrum (at 1,000 cd/m²) by using a luminance meter (Minolta Cs-1000A). The driving voltage and external quantum efficiency were evaluated by using a current voltmeter (Keithley 2400) and a luminance meter (Minolta Cs-1000A). In Table 4, the external quantum efficiencies of the organic light-emitting devices of Examples 1 to 3 and Comparative Examples A and B measured at 1,000 cd/m² and are expressed as relative values (%).

**Table 4**

| | Emitter compound No. | Emission peak wavelength (nm) | ClEy | Driving voltage (V) | External quantum efficiency (EQE) (at 1,000 cd/m²) (relative value, %) |
|---|---|---|---|---|---|
| Example 1 | 19 | 463 | 0.160 | 4.22 | 109 |
| Example 2 | 20 | 463 | 0.161 | 4.19 | 110 |
| Example 3 | 21 | 463 | 0.160 | 4.23 | 108 |
| Example 4 | 92 | 462 | 0.158 | 4.24 | 115 |
| Example 5 | 250 | 462 | 0.159 | 4.28 | 113 |
| Example 6 | 272 | 461 | 0.149 | 4.33 | 112 |
| Comparative Example A | A | 462 | 0.152 | 4.32 | 100 |
| Comparative Example B | B | 464 | 0.172 | 4.53 | 101 |

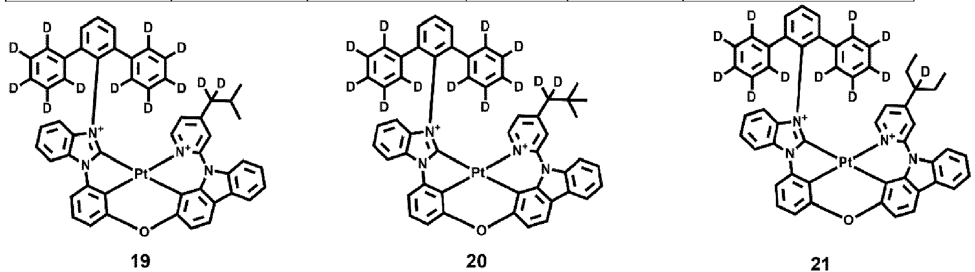

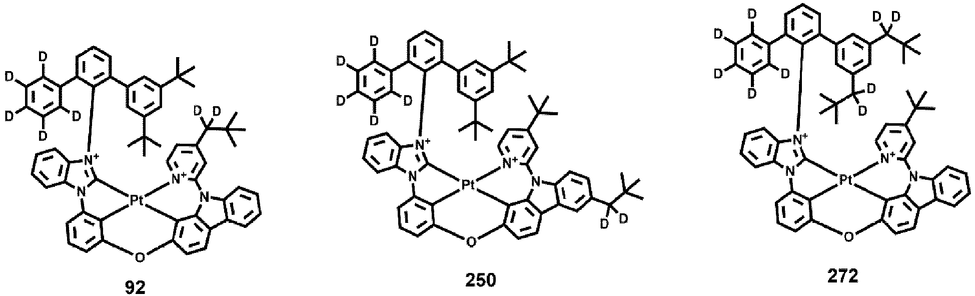

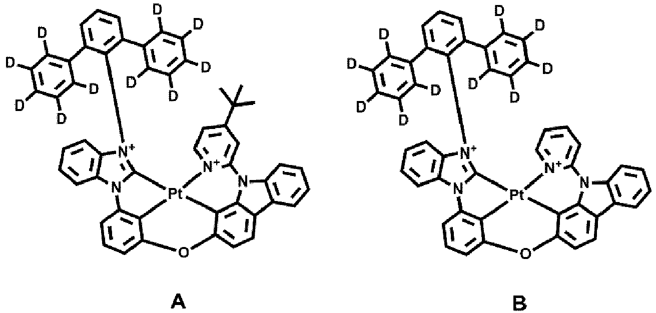

From Table 4, it was found that the organic light-emitting devices of Examples 1 to 6 had driving voltages and external quantum efficiencies, equal to or greater than those of the organic light-emitting devices of Comparative Examples A and B, and could emit a blue light of excellent color purity.

### Example 11

An organic light-emitting device was manufactured in a similar manner as in Example 1, except that, in forming the emission layer, Compound 92 (sensitizer), Compound FD14 (emitter), and CBP (host) were co-deposited at a weight ratio of 10:1.5:88.5 to form an emission layer having a thickness of 400 Å.

### Comparative Example X

An organic light-emitting device was manufactured in a similar manner as in Example 1, except that, in forming the emission layer, Compound FD14 (emitter) and CBP (host) were co-deposited at a weight ratio of 10:90 to form an emission layer having a thickness of 400 Å.

### Evaluation Example 3

For each of the organic light-emitting devices manufactured in Example 11 and Comparative Example X, an emission peak wavelength of an EL spectrum (nm), a y coordinate (CIEy) of a color coordinate, an external quantum efficiency (EQE), and lifespan (T₉₅, %) were evaluated by using a similar method as the method described in Evaluation Example 2, and results thereof are shown in Table 5. The lifespan (T₉₅) indicated a time taken for the luminance to reach 95% of its initial luminance of 100%. In Table 5, both the external quantum efficiencies and lifespans of the organic light-emitting devices of Example 11 and Comparative Example X measured at 1,000 cd/m² and are expressed as relative values (%).

**Table 5**

| | Sensitizer compound No. | Emitter Compound No. | Emission peak wavelength (nm) | ClEy | External quantum efficiency (EQE) (at 1,000 cd/m²) (relative value, %) | Lifespan (T₉₅) (at 1,000 cd/m²) (relative value, %) |
|---|---|---|---|---|---|---|
| Example 11 | 92 | FD14 | 462 | 0.111 | 248 | 2,130 |
| Comparative Example X | - | FD14 | 461 | 0.086 | 100 | 100 |

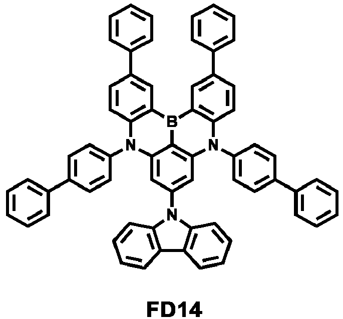

From Table 5, it was found that the organic light-emitting device of Example 11 including Compound 92 as a sensitizer had better external quantum efficiency and better lifespan characteristics than those of the organic light-emitting device of Comparative Example X, and could emit a blue light of excellent color purity.

Since the organometallic compound has excellent thermal stability and excellent electrical characteristics, and may emit a blue light of high color purity having a good ClEy coordinate, an electronic device, for example, an organic light-emitting device, including at least one of the organometallic compounds represented by Formula 1-1 or 1-2 may have, for example, an increased driving voltage, an increased external quantum efficiency, an increased emission efficiency, and/or an improved lifespan characteristic.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figure, it will be understood by those of ordinary skill in the art that various changes in form and details may be made therein without departing from the scope as defined by the following claims.

## Claims

1. An organometallic compound represented by Formula 1-1 or 1-2: 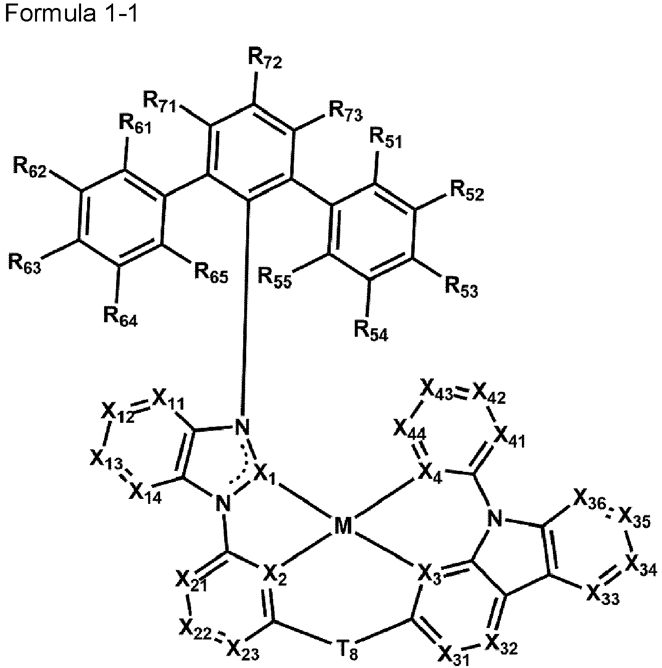 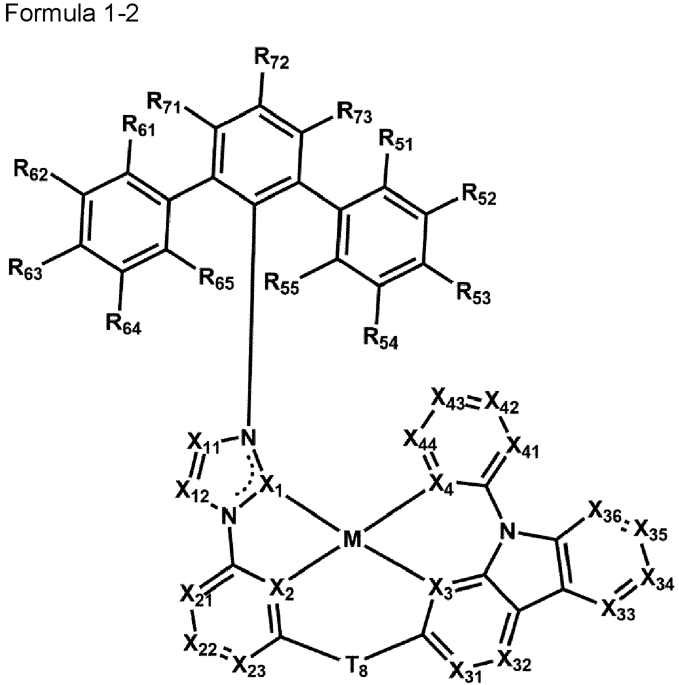 wherein, in Formulae 1-1 and 1-2,
M is Pt or Pd,
each of X₁, X₂, and X₃ is carbon,
X4 is nitrogen,
X₁₁ is N, C(R₁₁), or C(R₀); X₁₂ is N, C(R₁₂), or C(R₀); X₁₃ is N, C(R₁₃), or C(R₀); and X₁₄ is N, C(R₁₄), or C(R₀),
X₂₁ is N, C(R₂₁), or C(R₀); X₂₂ is N, C(R₂₂), or C(R₀); and X₂₃ is N, C(R₂₃), or C(R₀),
X₃₁ is N, C(R₃₁), or C(R₀); X₃₂ is N, C(R₃₂), or C(R₀); X₃₃ is N, C(R₃₃), or C(R₀); X₃₄ is N, C(R₃₄), or C(R₀); X₃₅ is N, C(R₃₅), or C(R₀); and X₃₆ is N, C(R₃₆), or C(R₀),
X₄₁ is N, C(R₄₁), or C(R₀); X₄₂ is N, C(R₄₂), or C(R₀); X₄₃ is N, C(R₄₃), or C(R₀); and X₄₄ is N, C(R₄₄), or C(R₀),
T₈ is O, S, N(R₈₁), C(R₃₁)(R₃₂), or Si(R₈₁)(R₈₂),
each R₀ is independently a group represented by Formula 2,
R₁₁ to R₁₄, R₂₁ to R₂₃, R₃₁ to R₃₆, R₄₁ to R₄₄, R₅₁ to R₅₅, R₆₁ to R₆₅, R₇₁ to R₇₃, R₈₁, and R₈₂ are each independently:
a group represented by Formula 2;
hydrogen or deuterium; or
a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
wherein Condition A or Condition B is satisfied:
Condition A
each of X₂₁ to X₂₃ in Formulae 1-1 and 1-2 is not N, and A-i), A-ii) or A-iii) is true:
A-i) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀),
A-ii) at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
A-iii) at least one of X₁₁ to X₁₄ in Formula 1-1 or at least one of X₁₁ and X₁₂ in Formula 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2,
Condition B
at least one of X₂₁ to X₂₃ in Formulae 1-1 and 1-2 is N, and B-i), B-ii) or B-iii) is true:
B-i) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀),
B-ii) at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, or
B-iii) at least one of X₁₁ to X₁₄ in Formula 1-1 or at least one of X₁₁ and X₁₂ in Formula 1-2, at least one of X₂₁ to X₂₃ in Formulae 1-1 and 1-2, at least one of X₃₁ to X₃₆ in Formulae 1-1 and 1-2, at least one of X₄₁ to X₄₄ in Formulae 1-1 and 1-2, or a combination thereof, is C(R₀), and at least one of R₅₁ to R₅₅ in Formulae 1-1 and 1-2, at least one of R₆₁ to R₆₅ in Formulae 1-1 and 1-2, at least one of R₇₁ to R₇₃ in Formulae 1-1 and 1-2, at least one of R₈₁ and R₈₂ in Formulae 1-1 and 1-2, or a combination thereof, is a group represented by Formula 2, and
when the organometallic compound represented by Formulae 1-1 or 1-2 comprises at least two groups represented by Formula 2, the at least two groups represented by Formula 2 are identical to or different from each other, 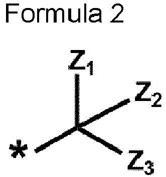 wherein, in Formula 2,
Z1 is:
hydrogen or deuterium; or
a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
Z₂ is hydrogen or deuterium,
Z₃ is a C₁-C₂₀ alkyl group, a phenyl group, or a carbazolyl group, each unsubstituted or substituted with at least one of deuterium, a C₁-C₂₀ alkyl group, a phenyl group, a carbazolyl group, or a combination thereof,
at least two of Z₁ to Z₃ are not linked to each other to form a ring, and
* indicates a binding site to a neighboring atom.

2. The organometallic compound of claim 1, wherein T₈ in Formulae 1-1 and 1-2 is O or S.

3. The organometallic compound of claims 1 or 2, wherein at least one of Conditions 1 to 8 is satisfied:
Condition 1
at least one of X₁₁ to X₁₄ in Formula 1-1 is C(R₀), or
at least one of X₁₁ and X₁₂ in Formula 1-2 is C(R₀),
Condition 2
at least one of X₃₁ and X₃₂ in Formulae 1-1 and 1-2 is C(R₀),
Condition 3
at least one of X₃₃ to X₃₆ in Formulae 1-1 and 1-2 is C(R₀),
Condition 4
at least one of X₄₁ to X₄₄ in Formulae 1-1 and 1-2 is C(R₀),
Condition 5
at least one of R₅₁ to R₅₅ in Formulae 1-1 and 1-2 is a group represented by Formula 2,
Condition 6
at least one of R₆₁ to R₆₅ in Formulae 1-1 and 1-2 is a group represented by Formula 2,
Condition 7
at least one of R₇₁ to R₇₃ in Formulae 1-1 and 1-2 is a group represented by Formula 2,
Condition 8
at least one of X₂₁ to X₂₃ in Formulae 1-1 and 1-2 is N, and
at least one among the others of X₂₁ to X₂₃ is C(R₀).

4. The organometallic compound of claim 3, wherein at least one of Conditions 1 to 4 is satisfied; and/or
wherein at least one of Conditions 5 to 7 is satisfied.

5. The organometallic compound of any of claims 1-4, wherein the group represented by Formula 2 is a group represented by Formula 2(1) or a group represented by Formula 2(2): 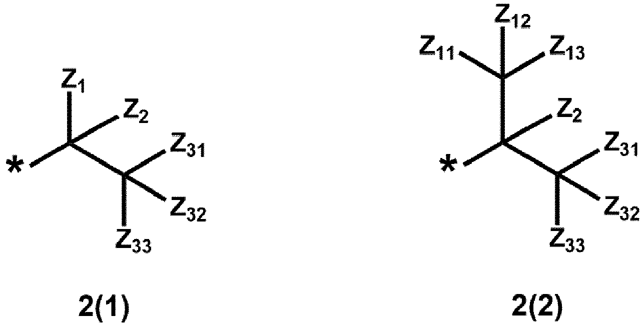 wherein, in Formulae 2(1) and 2(2),
Z₁ and Z₂ are as defined in claim 1,
Z₁₁ to Z₁₃ and Z₃₁ to Z₃₃ are each independently:
hydrogen or deuterium;
a C₁-C₁₅ alkyl group that is unsubstituted or substituted with at least one deuterium; or
a phenyl group that is unsubstituted or substituted with at least one of deuterium, a C₁-C₁₀ alkyl group, or a combination thereof, and
* indicates a binding site to a neighboring atom;
preferably wherein Z₁₁ to Z₁₃ and Z₃₁ to Z₃₃ in Formulae 2(1) and 2(2) are each independently:
hydrogen or deuterium;
a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, or a tert-decyl group, each unsubstituted or substituted with at least one deuterium atom; or
a phenyl group that is unsubstituted or substituted with at least one of deuterium, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof.

6. The organometallic compound of any of claims 1-5, wherein the group represented by Formula 2 is a group represented by one of Formulae 2-1 to 2-24: 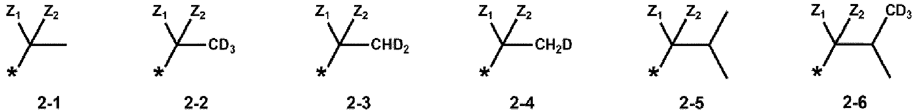 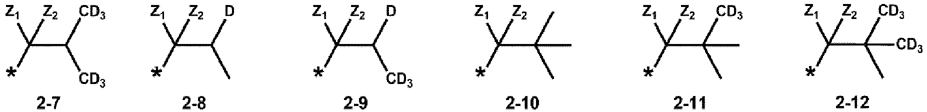 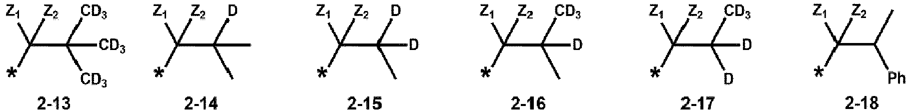 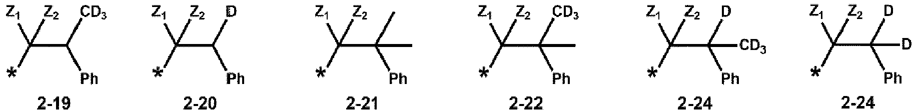 wherein, in Formulae 2-1 to 2-24,
Z₁ is hydrogen, deuterium, a methyl group, -CD₃, -CHD₂, or -CH₂D,
Z₂ is hydrogen or deuterium,
Ph is a phenyl group, and
* indicates a binding site to a neighboring atom.

7. The organometallic compound of any of claims 1-6, wherein the organometallic compound comprises at least one deuterium;
preferably wherein the group represented by Formula 2 comprises at least one deuterium.

8. The organometallic compound of any of claims 1-7, wherein at least one of R₅₁ to R₅₅, at least one of R₆₁ to R₆₅, or a combination thereof, comprises at least one deuterium.

9. An organic light-emitting device, comprising:
a first electrode;
a second electrode; and
an organic layer arranged between the first electrode and the second electrode,
wherein the organic layer comprises an emission layer, and
wherein the organic layer further comprises at least one of the organometallic compound of any of claims 1-8.

10. The organic light-emitting device of claim 9, wherein the emission layer comprises the at least one of the organometallic compound.

11. The organic light-emitting device of claim 10, wherein a CIEy coordinate of light emitted from the emission layer is 0.040 to 0.170; and/or
wherein a maximum emission peak wavelength of light emitted from the emission layer is 440 nanometers to 470 nanometers.

12. The organic light-emitting device of claims 10 or 11, wherein the at least one of the organometallic compound included in the emission layer is an emitter.

13. The organic light-emitting device of claims 10 or 11, wherein the at least one of the organometallic compound included in the emission layer is a sensitizer.

14. The organic light-emitting device of claim 13, wherein
the emission layer further comprises a fluorescent compound,
the fluorescent compound is different from the at least one of the organometallic compound, and
the fluorescent compound is an emitter;
preferably wherein the fluorescent compound comprises an amino group, or the fluorescent compound comprises a 6-membered ring comprising at least one nitrogen atom and at least one boron atom.

15. An electronic apparatus, comprising the organic light-emitting device of any of claims 9-14.
